# EUROPEAN PATENT APPLICATION

(11) **EP 4 151 700 A1**
(43) Date of publication of application: **22.03.2023**
(21) Application number: 22195847.3
(22) Date of filing: 15.09.2022
(51) Int. Cl.: C09K 11/06

(54) **COMPOSITION, LAYER INCLUDING THE COMPOSITION, LIGHT-EMITTING DEVICE INCLUDING THE COMPOSITION, AND ELECTRONIC APPARATUS INCLUDING THE LIGHT-EMITTING DEVICE**

(30) Priority: 17.09.2021 KR 20210125144
(71) Applicant: Samsung Electronics Co., Ltd., Gyeonggi-do, 16677 (KR)
(72) Inventor: KIM, Soyeon, 16678 Suwon-si (KR); SIM, Myungsun, 16678 Suwon-si (KR); CHO, Yongsuk, 16678 Suwon-si (KR); CHOI, Jongwon, 16678 Suwon-si (KR); KRAVCHUK, Dmitry, 16678 Suwon-si (KR); LEE, Sunghun, 16678 Suwon-si (KR); HONG, Sunghun, 16678 Suwon-si (KR)
(74) Representative: Elkington and Fife LLP

(57) **Abstract**

A composition, including a first compound represented by Formula 1, and a second compound represented by Formula 2, wherein the first compound and the second compound are different from each other:

Formula 1 Ir(L₁₁)ₙ₁₁(L₁₂)ₙ₁₂(L₁₃)ₙ₁₃

Formula 2 Ir(L₂₁)ₙ₂₁(L₂₂)ₙ₂₂(L₂₃)ₙ₂₃

wherein Formula 1 and Formula 2 are as defined in the specification.

## Description

### FIELD OF THE INVENTION

The present disclosure relates to compositions, layers including the compositions, light-emitting devices including the compositions, and electronic apparatuses including the light-emitting devices.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed, and produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

### SUMMARY OF THE INVENTION

Provided are compositions capable of providing excellent luminescence efficiency and lifespan, etc., layers including the compositions, light-emitting devices including the compositions, and electronic apparatuses including the light-emitting devices.

Additional aspects will be set forth in part in the description, which follows and, in part, will be apparent from the description, or may be learned by practice of the presented embodiments of the disclosure.

According to an aspect, a composition includes:
a first compound represented by Formula 1 and a second compound represented by Formula 2, wherein the first compound is different from the second compound:

   Formula 1 Ir(L₁₁)ₙ₁₁(L₁₂)ₙ₁₂(L₁₃)ₙ₁₃

   Formula 2 Ir(L₂₁)ₙ₂₁(L₂₂)ₙ₂₂(L₂₃)ₙ₂₃

   wherein, in Formulae 1 and Formula 2,
L₁₁ is a bidentate ligand, i) bonded to iridium (Ir) of Formula 1 via a nitrogen atom and a carbon atom and ii) including ring A₁ bonded to iridium of Formula 1 via the nitrogen atom,
ring A₁ is:
a C₃-C₆₀ polycyclic group including at least three cyclic groups that are condensed with each other, or
a C₃-C₆₀ polycyclic group including at least one cyclic group and at least one 5-membered ring that are condensed with each other,
L₁₃, L₂₁, and L₂₃ are each independently:
   a bidentate ligand bonded to iridium of Formula 1 or Formula 2 via two nitrogen atoms,
   a bidentate ligand bonded to iridium of Formula 1 or 2 via a nitrogen atom and a carbon atom, or
   a bidentate ligand bonded to iridium of Formula 1 or 2 via two carbon atoms,
   L₁₂ and L₂₂ are each independently a bidentate ligand bonded to iridium of Formula 1 or Formula 2 via two oxygen atoms,
   n11, n12, n21 and n22 are each independently 1 or 2,
   n13 and n23 are each independently 0 or 1,
   the sum of n11, n12, and n13 is 3, and
   the sum of n21, n22, and n23 is 3,
   with the proviso that the first compound is not:

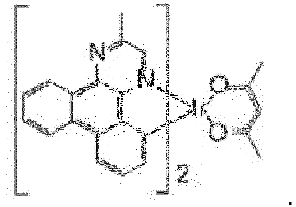

According to another aspect, a layer includes the composition.

According to still another aspect, an organic light-emitting device includes a first electrode, a second electrode, and an organic layer located between the first electrode and the second electrode, wherein the organic layer includes an emission layer, and wherein the organic layer includes the composition.

In one or more embodiments, the composition may be included in the emission layer in the organic layers of the light-emitting device.

Another aspect of the present disclosure provides an electronic apparatus including the light-emitting device.

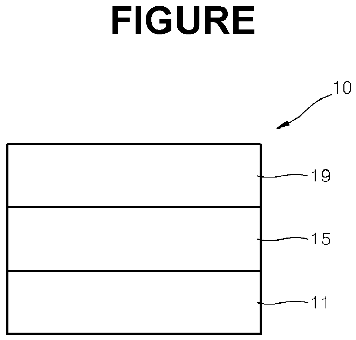

### BRIEF DESCRIPTION OF THE DRAWING

The above and other aspects, features, and advantages of certain embodiments of the disclosure will be more apparent from the following description taken in conjunction with FIGURE, which shows a schematic cross-sectional view of a light-emitting device according to one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (*i.e.,* the limitations of the measurement system). For example, "about" can mean within one or more standard deviations, or within ± 30%, 20%, 10%, 5% of the stated value.

A composition of the present disclosure includes a first compound represented by Formula 1 and a second compound represented by Formula 2. Formulae 1 and 2 will now be described in further detail.

Formula 1 Ir(L₁₁)ₙ₁₁(L₁₂)ₙ₁₂(L₁₃)ₙ₁₃

Formula 2 Ir(L₂₁)ₙ₂₁(L₂₂)ₙ₂₂(L₂₃)ₙ₂₃

The first compound and the second compound are different from each other.

Each of Formulae 1 and 2 includes one iridium (Ir).

Each of the first compound and the second compound may be electrically neutral.

Each of the first compound and the second compound may be a heteroleptic complex.

L₁₁ is a bidentate ligand, i) bonded to iridium of Formula 1 via a nitrogen atom and a carbon atom and ii) including ring A₁ bonded to iridium of Formula 1 via the nitrogen atom.

Ring A₁ may be:
a) a C₃-C₆₀ polycyclic group including at least three cyclic groups that are condensed with each other, or
b) a C₃-C₆₀ polycyclic group including at least one cyclic group and at least one 5-membered ring are condensed with each other.

L₁₃, L₂₁, and L₂₃ in Formula 1 and 2 are each independently:
i) a bidentate ligand bonded to iridium (Ir) of Formula 1 or Formula 2 via two nitrogen atoms,
ii) a bidentate ligand bonded to iridium of Formula 1 or 2 via a nitrogen atom and a carbon atom, or
iii) a bidentate ligand bonded to iridium of Formula 1 or 2 via two carbon atoms.

Each of L₁₂ and L₂₂ in Formulae 1 and 2 is independently a bidentate ligand bonded to iridium of Formula 1 or Formula 2 via two oxygen atoms.

n11, n12, n21, and n22 in Formulae 1 and 2 are each independently 1 or 2. In one or more embodiments, each of n12 and n22 may be 1. In one or more embodiments, each of n11 and n21 may be 2, and each of n12 and n22 may be 1.

n13 and n23 in Formula 1 and 2 are each independently 0 or 1.

In Formulae 1 and 2, the sum of n11, n12, and n13 is 3, and the sum of n21, n22, and n23 is 3.

The first compound is not of the formula:

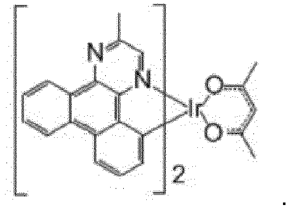

In one or more embodiments, in Formulae 1 and 2, each of L₁₃, L₂₁ and L₂₃ may be a bidentate ligand bonded to iridium in Formula 1 or Formula 2 via a nitrogen atom and a carbon atom, and n12 and n22 may each be 1.

In one or more embodiments, L₁₁ of Formula 1 and L₂₁ of Formula 2 may be different from each other.

In one or more embodiments, L₁₂ of Formula 1 and L₂₂ of Formula 2 may be different from each other.

In one or more embodiments, each of n13 and n23 in Formulae 1 and 2 may be 0.

In one or more embodiments,
L₁₁ may be a ligand represented by Formula 1-1,
L₁₂ may be a ligand represented by Formula 1-3,
L₁₃ may be a ligand represented by Formula 1-1 or 1-2,
L₂₁ may be a ligand represented by Formula 2-1,
L₂₂ may be a ligand represented by Formula 2-3, and
L₂₃ may be a ligand represented by Formula 2-1 or 2-2: 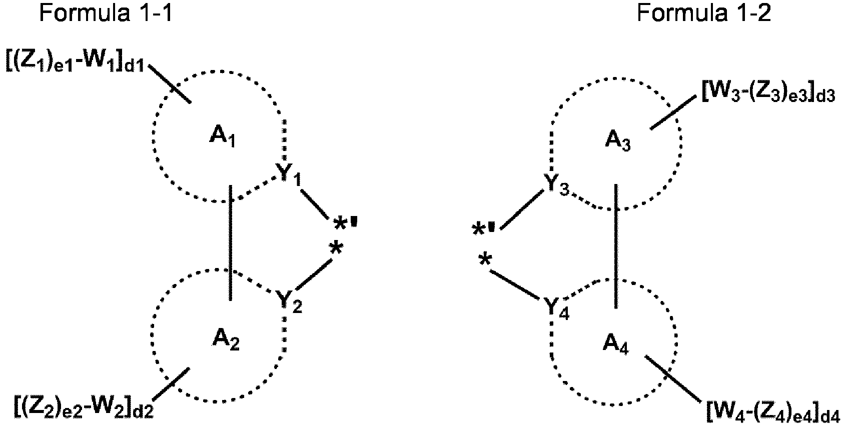 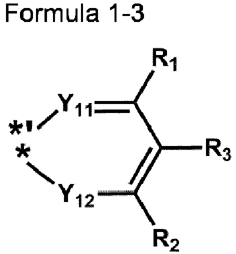 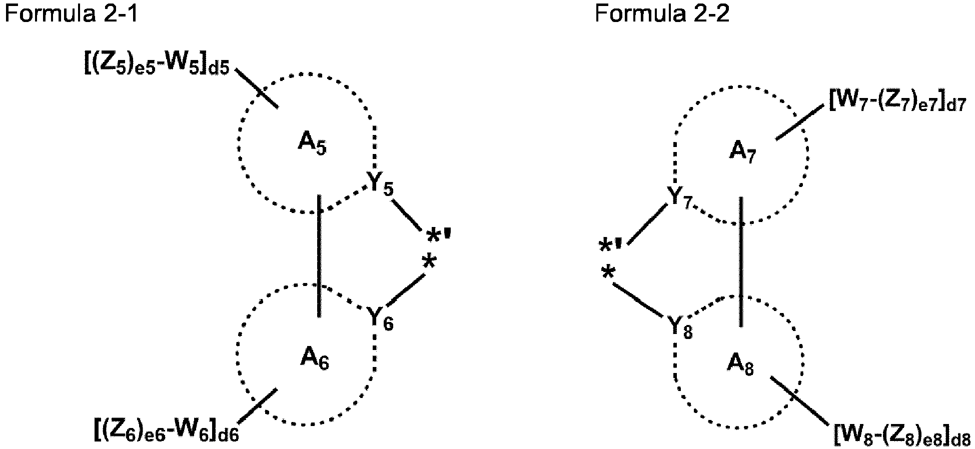 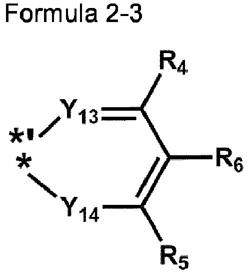
Y₁ in Formula 1-1 may be N.
Y₂ to Y₈ in Formulae 1-1, 1-2, 2-1, and 2-2 may each independently be N or C.

In one or more embodiments, Y₃, Y₅, and Y₇ may each be N, and Y₂, Y₄, Y₆, and Y₈ may each be C.

In one or more embodiments, i) Y₂ may be C, ii) Y₃ and Y₄ may each be C, iii) Y₅ and Y₆ may each be C, or iv) Y₇ and Y₈ may each be C.

In Formulae 1-1, 1-2, 2-1, and 2-2, i) a bond between Y₁ and iridium, a bond between Y₃ and iridium, a bond between Y₅ and iridium, and a bond between Y₇ and iridium may each be a coordinate bond, ii) a bond between Y₂ and iridium, a bond between Y₄ and iridium, a bond between Y₆ and iridium, and a bond between Y₈ and iridium may each be a covalent bond. Thus, each of the first compound and the second compound may be electrically neutral.

Y₁₁ to Y₁₄ in Formulae 1-3 and 2-3 may each be O.

Ring A₁ in Formula 1-1 is:
a) a C₃-C₆₀ polycyclic group including at least three cyclic groups that are condensed with each other, or
b) a C₃-C₆₀ polycyclic group including at least one cyclic group and at least one 5-membered ring that are condensed with each other.

Ring A₂ to ring A₈ in Formulae 1-1, 1-2, 2-1, and 2-2 may each independently be a C₅-C₃₀ carbocyclic group or a C₁-C₃₀ heterocyclic group.

In one or more embodiments, i) ring A₃, ring A₅, and ring A₇ may each be a C₁-C₃₀ heterocyclic group, and ii) ring A₂, ring A₄, ring A₆, and ring A₈ may each independently be a C₅-C₃₀ carbocyclic group or a C₁-C₃₀ heterocyclic group.

In one or more embodiments, i) ring A₃, ring A₅, and ring A₇ may each be a C₁-C₃₀ heterocyclic group, ii) ring A₂, ring A₄, ring A₆, and ring A₈ may each independently be a C₅-C₃₀ carbocyclic group or a C₁-C₃₀ heterocyclic group, iii) Y₃, Y₅, and Y₇ may each be N, and iv) Y₂, Y₄, Y₆, and Y₈ may each be C.

For example, in relation to Formula 1-1, ring A₁ may be i) a C₃-C₆₀ polycyclic group in which at least three cyclic groups are condensed with each other, wherein each of the at least three cyclic groups may each be ring T1, ring T2, ring T3, or ring T4, or ii) a C₃-C₆₀ polycyclic group in which at least one cyclic group and at least one 5-membered ring may be condensed with each other, wherein each of the at least one cyclic group may each be ring T1, ring T2, ring T3 or ring T4, and each of the at least one 5-membered ring may each be ring T2 or ring T3,
ring T1 may be a pyridine group, a pyrimidine group, a pyrazine group, a pyridazine group, or a triazine group,
ring T2 may be an oxazole group, an oxadiazole group, an oxatriazole group, a thiazole group, a thiadiazole group, a thiatriazole group, a pyrazole group, an imidazole group, a triazole group, a tetrazole group, or an azasilole group,
ring T3 may be a cyclopentane group, a cyclopentene group, a furan group, a thiophene group, a pyrrole group, a silole group, a borole group, a phosphole group, a germole group, or a selenophene group,
ring T4 may be an adamantane group, a norbornane group, a norbornene group, a cyclohexane group, a cyclohexene group, or a benzene group.

In one or more embodiments, ring A₃, ring A₅, and ring A₇ in Formulae 1-2, 2-1 and 2-2 may each independently be i) a ring T5, ii) a condensed ring in which two or more ring T5 are condensed with each other, or iii) a condensed ring in which at least one ring T5 and at least one ring T6 are condensed with each other,
ring T5 may be a pyridine group, a pyrimidine group, a pyrazine group, a pyridazine group, a triazine group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
ring T6 may be a cyclopentane group, a cyclopentene group, a furan group, a thiophene group, a pyrrole group, a silole group, a borole group, a phosphole group, a germole group, a selenophene group, an adamantane group, a norbornane group, a norbornene group, a cyclohexane group, a cyclohexene group, or a benzene group.

In one or more embodiments, in Formulae 1-1, 1-2, 2-1, and 2-2, ring A₂, ring A₄, ring A₆, and ring A₈ may each be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring A₁ in Formula 1-1 may be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a benzoquinoline group, a benzoisoquinoline group, a benzoquinoxaline group, a benzoquinazoline group, a naphthoquinoline group, a naphthoisoquinoline group, a phenanthroline group, a phenanthridine group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a furanopyridine group, a furanopyrimidine group, a thienopyridine group, or a thienopyrimidine group.

In one or more embodiments, ring A₃, ring A₅, and ring A₇ in Formulae 1-2,2-1, and 2-2 may each independently be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a naphthoquinoline group, a naphthoisoquinoline group, a phenanthroline group, a phenanthridine group, a pyrrole group, a pyrazole group, an imidazole group, a triazole group, an oxazole group, an iso-oxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, a pyridine group to which a cyclohexane group is condensed , a pyridine group to which a norbornane group is condensed, a furanopyridine group, a furanopyrimidine group, a thienopyridine group, or a thienopyrimidine group.

In one or more embodiments, ring A₂, ring A₄, ring A₆, and ring A₈ in Formulae 1-1, 1-2, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a naphthoquinoline group, a naphthoisoquinoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group to which a cyclohexane group is condensed, a benzene group to which a norbornane group is condensed, a pyridine group to which a cyclohexane group is condensed, a pyridine group to which a norbornane group is condensed, a furanopyridine group, a furanopyrimidine group, a thienopyridine group, or a thienopyrimidine group.

In one or more embodiments, in relation to Formulae 1-1, 1-2, 2-1, and 2-2, a Y₁-containing cyclic group (Y₁-containing monocyclic group) in ring A₁, a Y₃-containing cyclic group (Y₃₋containing monocyclic group) in ring A₃, a Y₅-containing cyclic group (Ys-containing monocyclic group) in ring A₅, and a Y₇-containing cyclic group (Y₇-containing monocyclic group) in ring A₇ may each be a 6-membered ring (for example, a pyridine group, a pyrimidine group, a pyrazine group, a pyridazine group, or the like).

In one or more embodiments, in relation to Formulae 1-1, 1-2, 2-1, and 2-2, a Y₂-containing cyclic group (Y₂-containing monocyclic group) in ring A₂, a Y₄-containing cyclic group (Y₄-containing monocyclic group) in ring A₄, a Y₆-containing cyclic group (Y6-containing monocyclic group) in ring A₆, and a Y₈-containing cyclic group (Y₈-containing monocyclic group) in ring A₈ may each be a 6-membered ring (for example, a benzene group).

In one or more embodiments, ring A₁ and ring A₅ may be different from each other.

In one or more embodiments, ring A₁ and ring A₅ may be identical to each other.

In one or more embodiments, ring A₁ may be a benzoquinoline group, a benzoisoquinoline group, a naphthoquinoline group, a naphthoisoquinoline group, a furanopyridine group, a furanopyrimidine group, a thienopyridine group, a thienopyrimidine group, an azadibenzofuran group, or an azadibenzothiophene group.

In one or more embodiments, ring A₃, ring A₅, and ring A₇ may each independently be a pyridine group, a pyrimidine group, a pyrazine group, a pyridazine group, a quinoline group, an isoquinoline group, a benzoquinoline group, a benzoisoquinoline group, a naphthoquinoline group, a naphthoisoquinoline group, a furanopyridine group, a furanopyrimidine group, a thienopyridine group, a thienopyrimidine group, an azadibenzofuran group, or an azadibenzothiophene group.

In one or more embodiments, ring A₂ and ring A₆ may be different from each other.

In one or more embodiments, ring A₂ and ring A₆ may be identical to each other.

In one or more embodiments, ring A₂, ring A₄, ring A₆, and ring A₈ may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

W₁ to W₈ in Formulae 1-1, 1-2, 2-1, and 2-2 may each independently be a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, W₁ to W₈ in Formulae 1-1, 1-2, 2-1, and 2-2 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each substituted or unsubstituted with at least one R₁₀ₐ.

In one or more embodiments, W₁ to W₈ in Formulae 1-1, 1-2, 2-1, and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, W₁ to W₈ in Formulae 1-1, 1-2, 2-1, and 2-2 may each independently be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

Z₁ to Z₈ and R₁ to R₆ in Formulae 1-1 to 1-3 and 2-1 to 2-3 may each independently be hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ may each be as described herein.

For example, Z₁ to Z₈ and R₁ to R₆ in Formulae 1-1 to 1-3 and 2-1 to 2-3 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, C₁-C₂₀ alkyl group, a C₁-C₂₀ alkenyl group, a C₁-C₂₀ alkoxy group, or a C₁-C₂₀ alkylthio group;
a C₁-C₂₀ alkyl group, a C₁-C₂₀ alkenyl group, a C₁-C₂₀ alkoxy group, or a C₁-C₂₀ alkylthio group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1,1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q3)(Q4)(Q5), -B(Q6)(Q7), -P(=O)(Q₈)(Q₉), or -P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, -CD₂CDH₂, -CF₃, -CF₂H, -CFH₂, -CH₂CF₃, -CH₂CF₂H, -CH₂CFH₂, -CHFCH₃,-CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, C₁-C₁₀ alkyl group, a phenyl group, or a combination thereof.

In one or more embodiments, Z₁ to Z₈ and R₁ to R₆ in Formulae 1-1 to 1-3 and 2-1 to 2-3 may each independently be:
hydrogen, deuterium, -F, or a cyano group;
a C₁-C₂₀ alkyl group unsubstituted or substituted with at least one of deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a C₁-C₂₀ alkyl group, a deuterated C₁-C₂₀ alkyl group, fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₃)(Q₄)(Q₅) or -Ge(Q₃)(Q₄)(Q₅).

In one embodiment, in Formula 1-1,
e1 and d1 may each not be 0, and
one or more Z₁(s) may each independently be:
   a C₁-C₂₀ alkyl group that is unsubstituted or substituted with at least one of deuterium, -F, a phenyl group, or a combination thereof;
   -Si(Q₃)(Q₄)(Q₅); or
   -Ge(Q₃)(Q₄)(Q₅).
   Q₃ to Q₅ are as described in the present specification.

In one or more embodiments, in relation to Formula 2-1,
e5 and d5 may each not be 0, and
one or more Z₅(s) may each independently be:
   a C₁-C₂₀ alkyl group that is unsubstituted or substituted with at least one of deuterium, -F, a phenyl group, or a combination thereof;
   -Si(Q₃)(Q₄)(Q₅); or
   -Ge(Q₃)(Q₄)(Q₅).

Q₃ to Q₅ are as described in the present specification.

For example, Q₃ to Q₅ may each independently be:
a C₁-C₆₀ alkyl group unsubstituted or substituted with at least one of deuterium, a C₁-C₆₀ alkyl group, a C₆-C₆₀ aryl group, or a combination thereof; or
a C₆-C₆₀ aryl group unsubstituted or substituted with at least one of deuterium, a C₁-C₆₀ alkyl group, a C₆-C₆₀ aryl group, or a combination thereof.

In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

In one or more embodiments, Q₃ to Q₅ may be identical to each other (i.e., Q₃ to Q₅ may be the same).

In one or more embodiments, two or more of Q₃ to Q₅ may be different from each other.

In one or more embodiments, Z₁ to Z₈ and R₁ to R₆ in Formulae 1-1 to 1-3 and 2-1 to 2-3 may each independently be hydrogen, deuterium, -F, -CH₃, -CD₃, -CD₂H, -CDH₂, -CF₃, -CF₂H, -CFH₂, a C₁-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (wherein Q₃ to Q₅ are respectively as those described in the present specification):

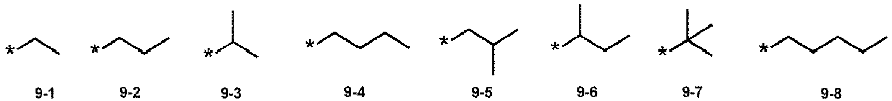

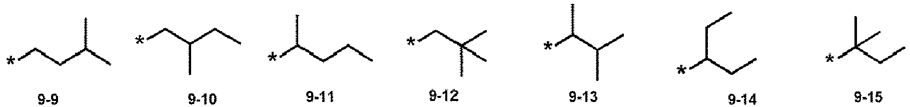

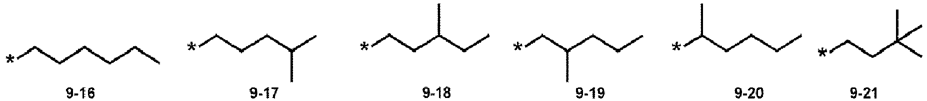

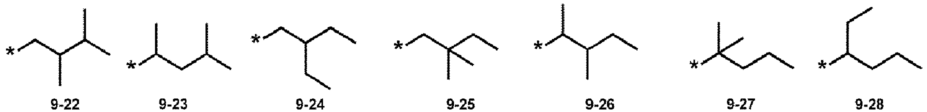

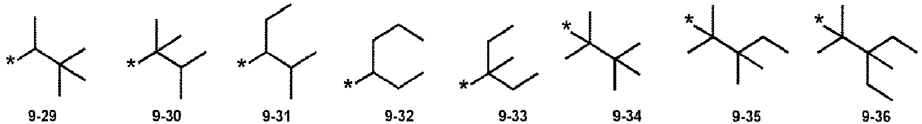

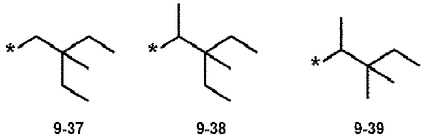

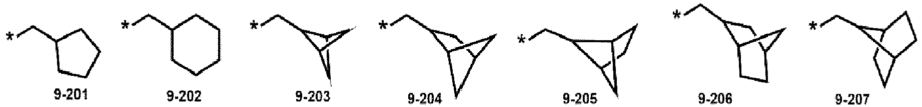

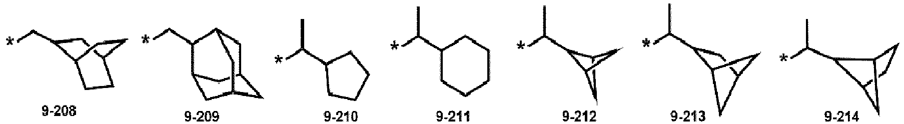

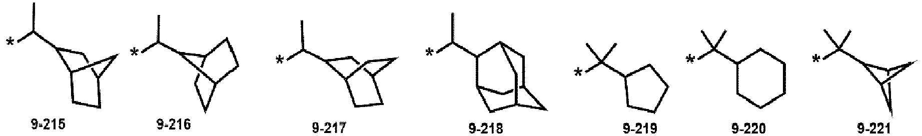

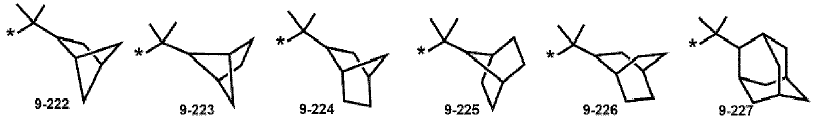

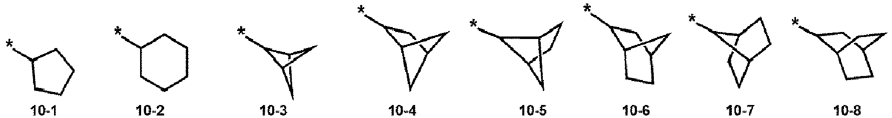

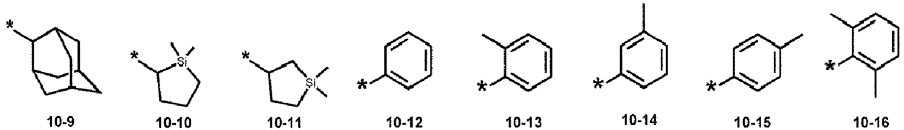

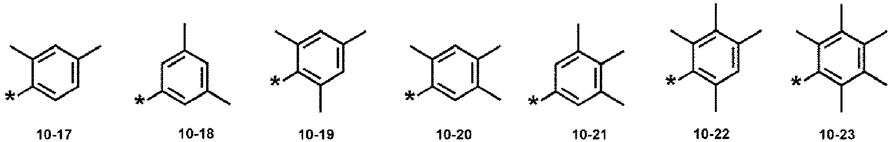

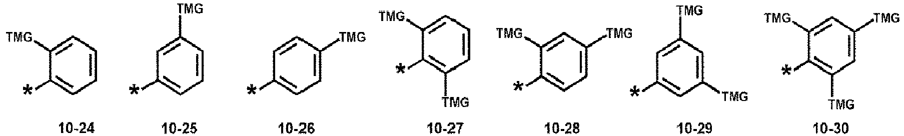

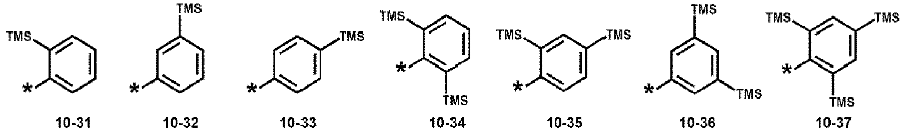

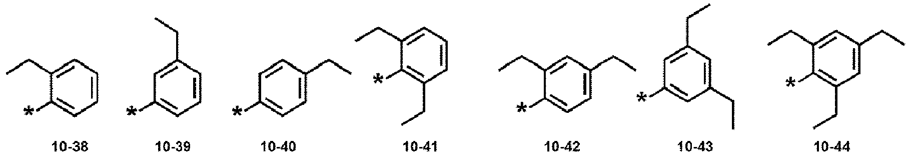

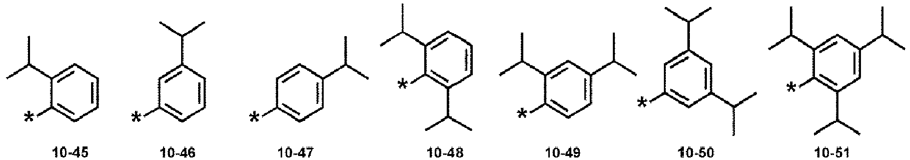

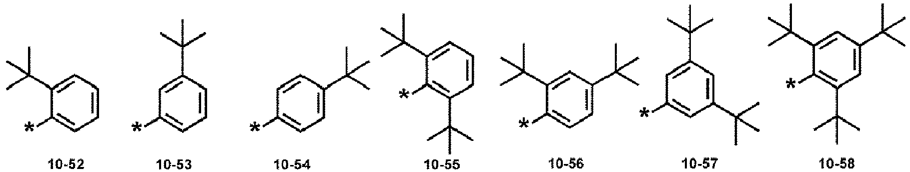

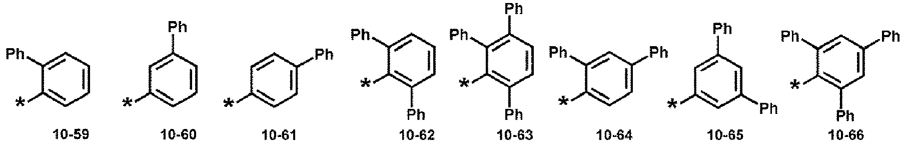

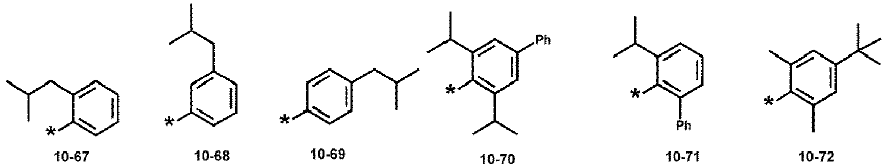

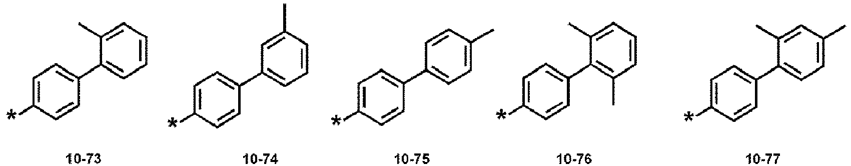

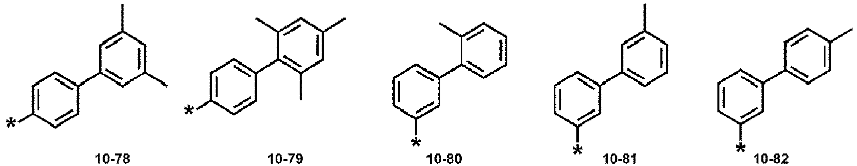

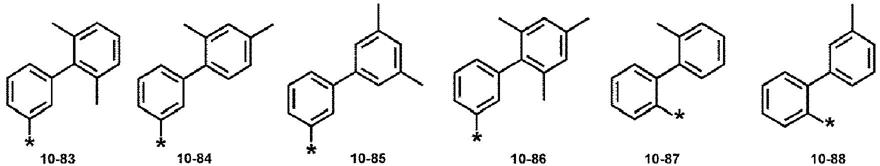

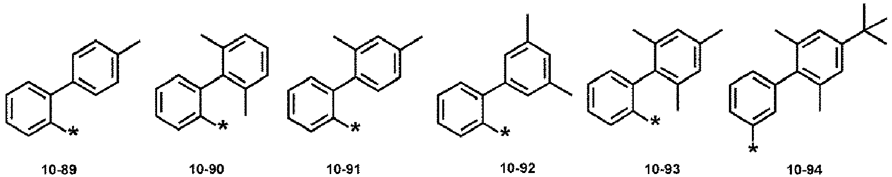

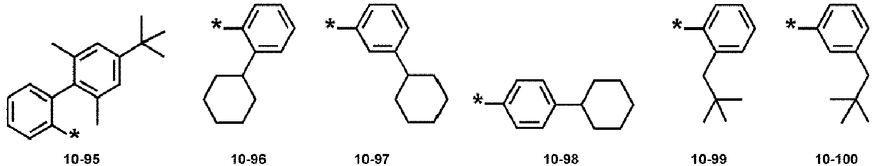

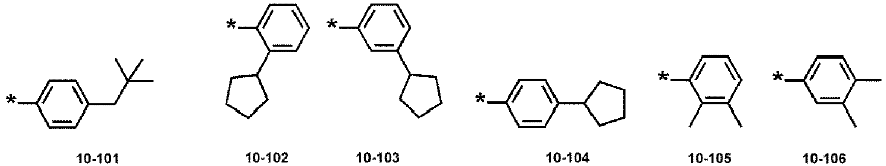

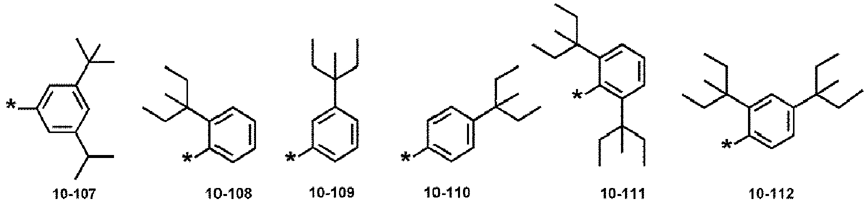

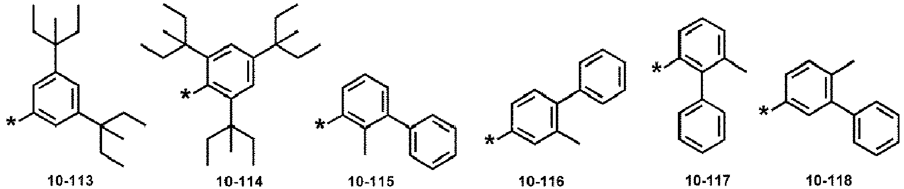

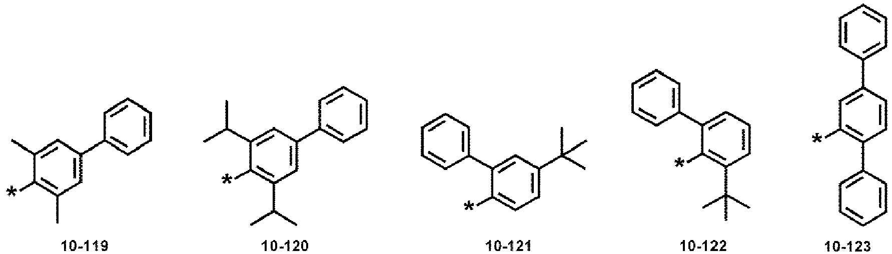

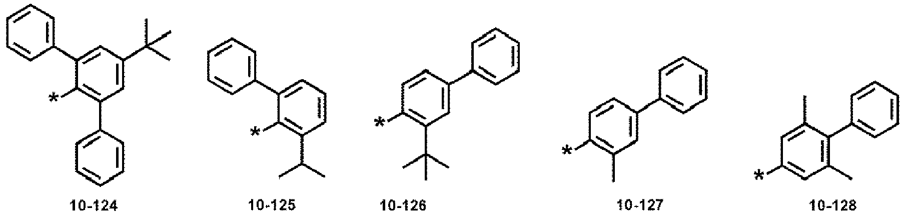

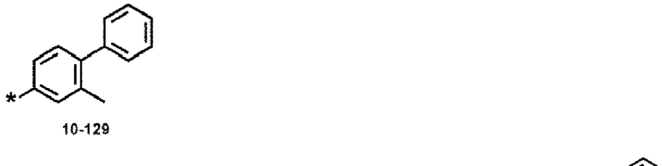

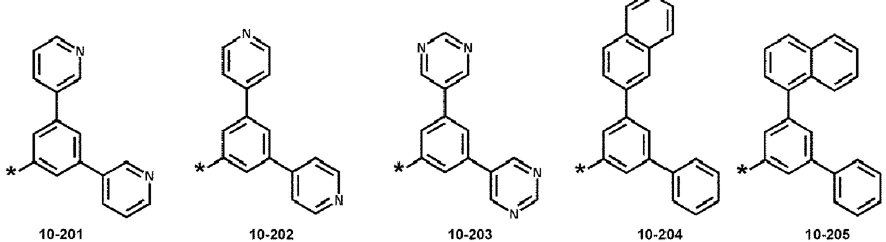

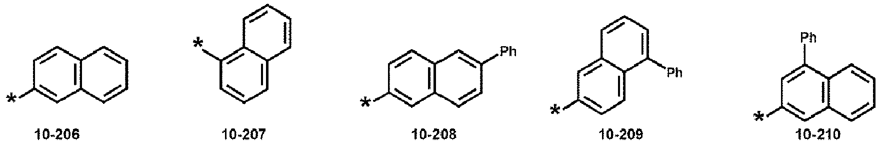

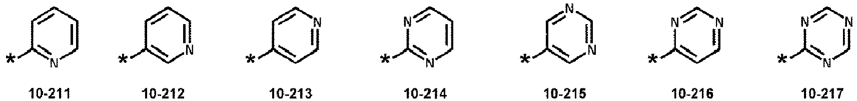

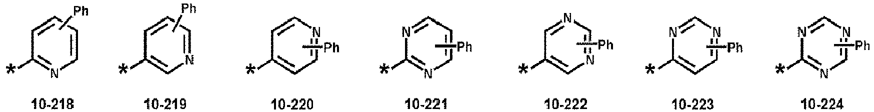

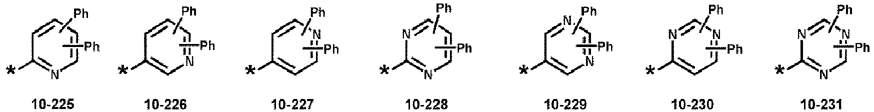

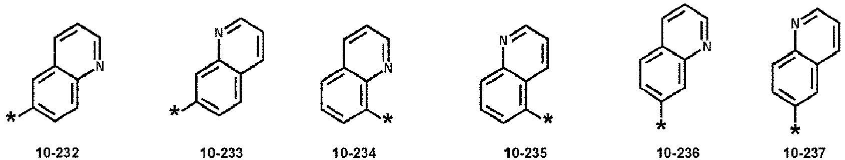

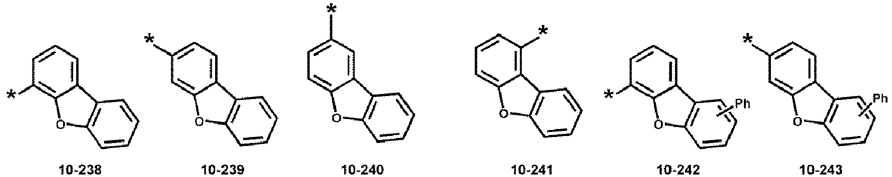

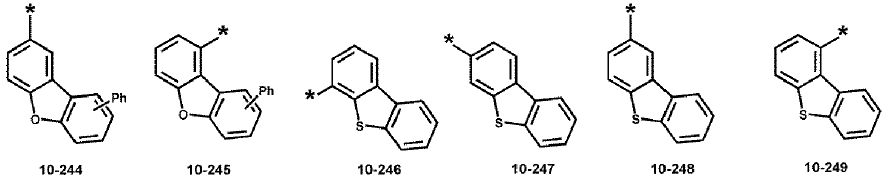

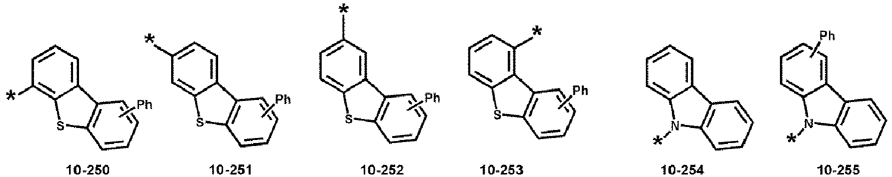

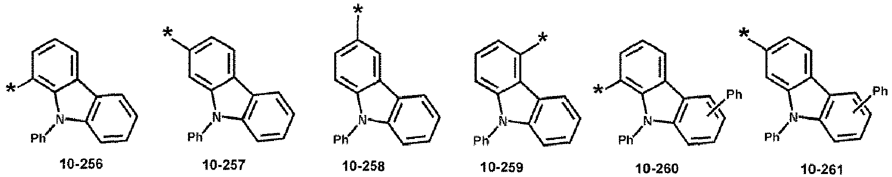

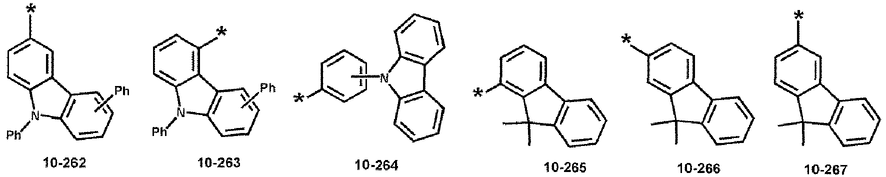

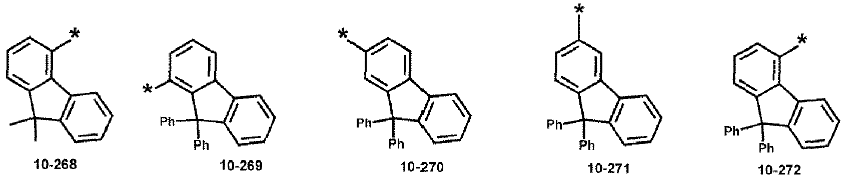

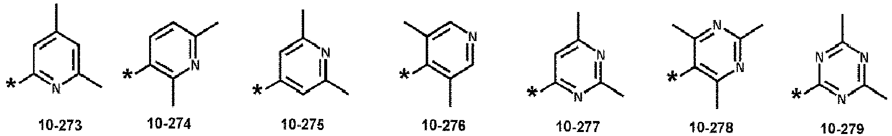

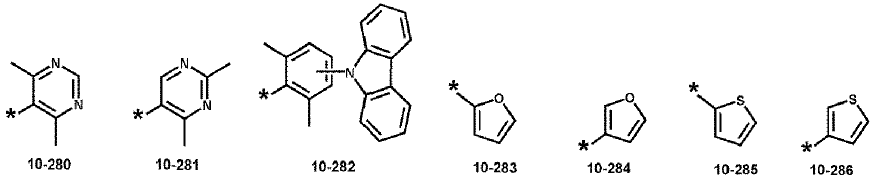

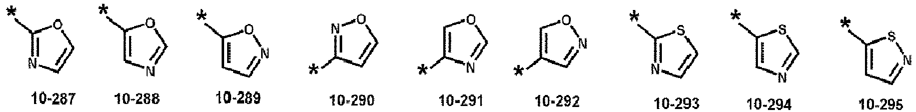

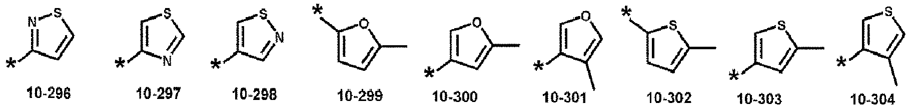

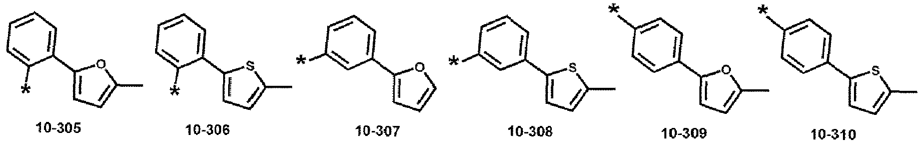

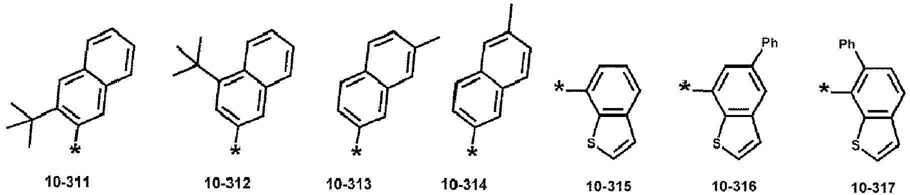

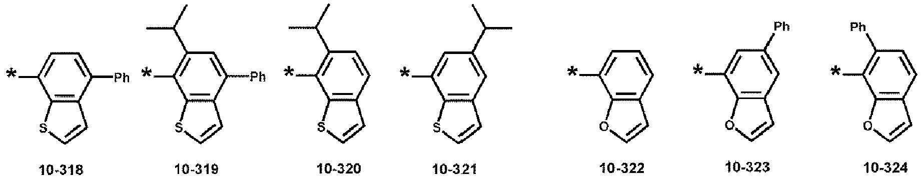

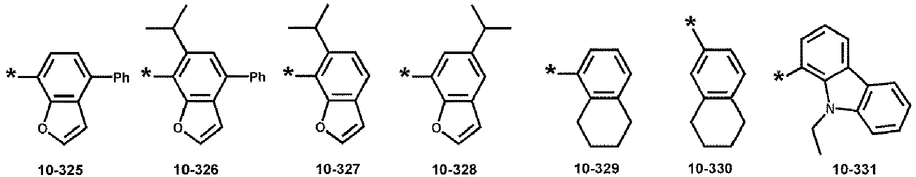

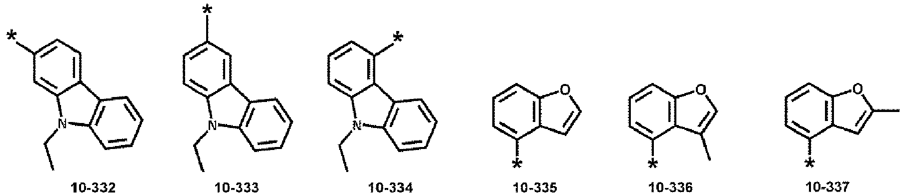

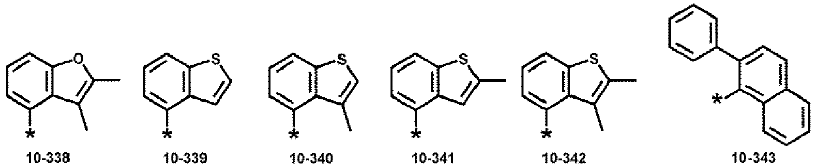

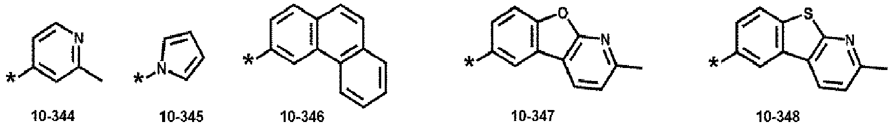

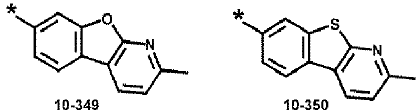

In Formulae 9-1 to 9-39, 9-201 to 9-237, 10-1 to 10-129, and 10-201 to 10-350, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 or 9-601 to 9-636:

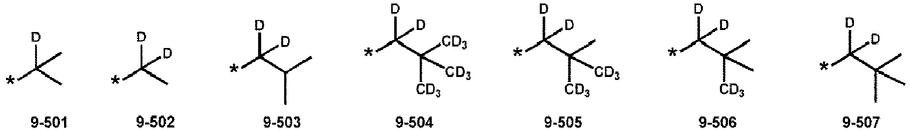

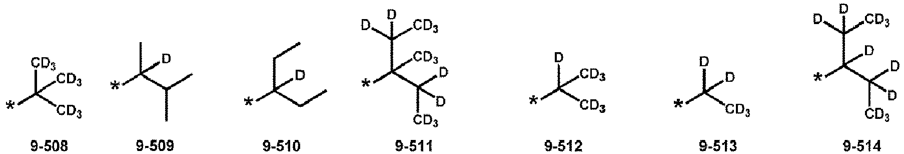

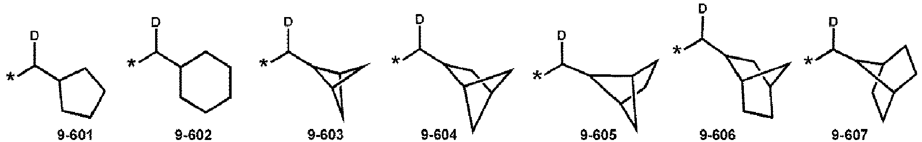

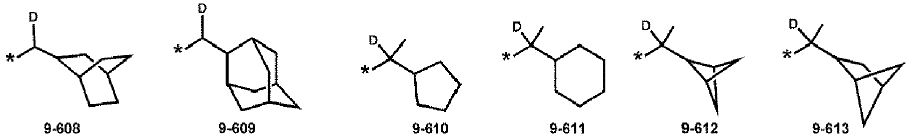

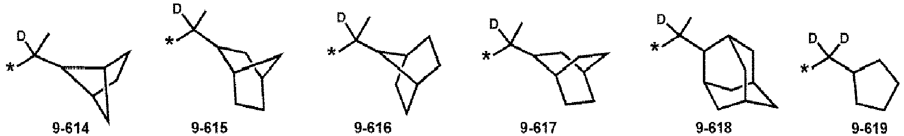

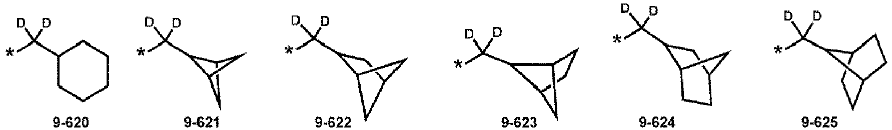

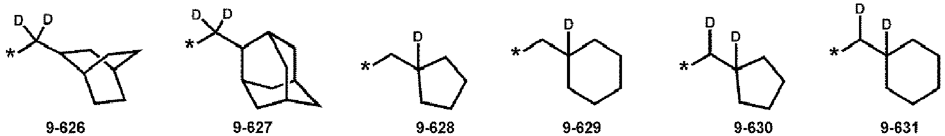

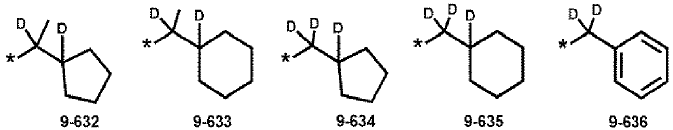

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

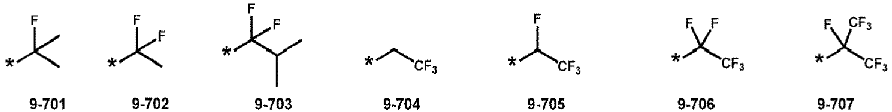

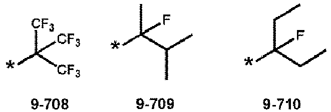

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

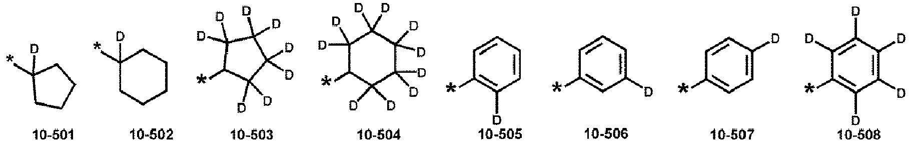

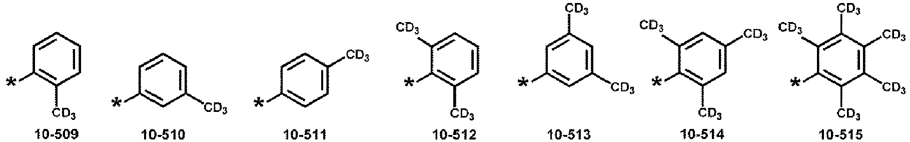

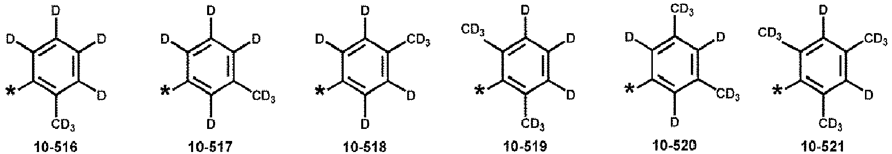

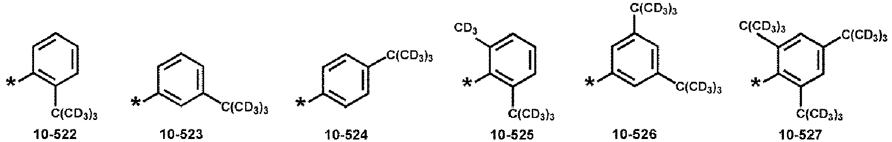

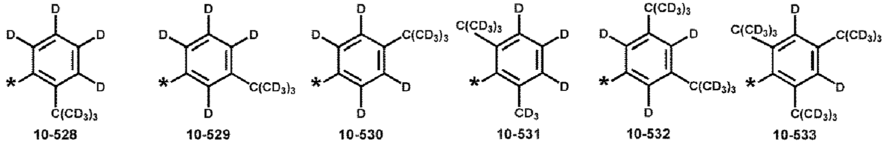

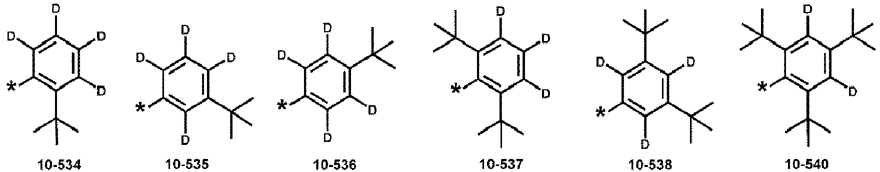

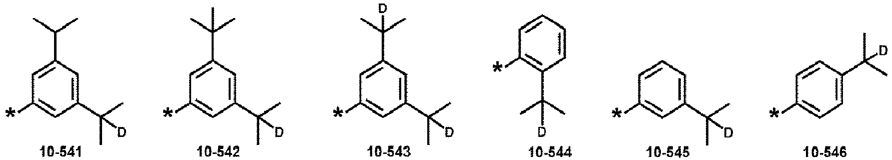

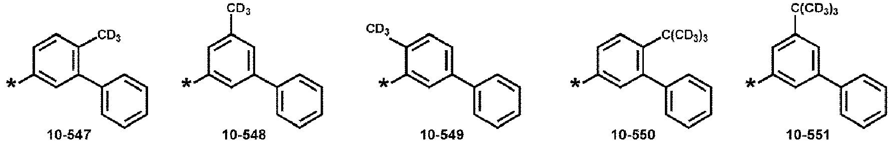

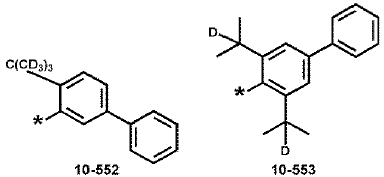

The " group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617:

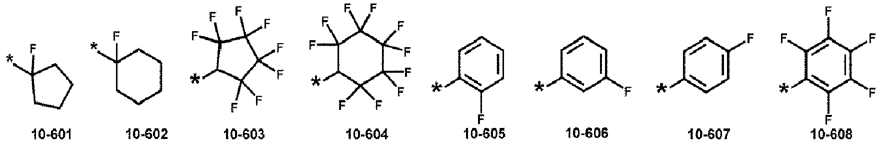

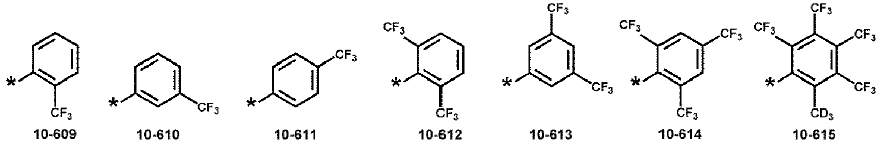

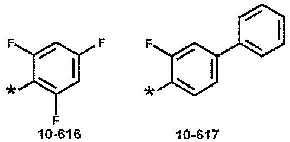

The number of carbon atoms included in at least one of R₁ and R₂ (for example, R₁ and R₂) in Formulae 1-3 may each independently be 4 or more, 5 or more, or 6 or more.

In one or more embodiments, R₁ in Formula 1-3 may not be a methyl group.

In one or more embodiments, R₁ and R₂ in Formula 1-3 may not be a methyl group.

In one or more embodiments, R₁ in Formula 1-3 may not be a tert-butyl group.

In one or more embodiments, each of R₁ and R₂ in Formula 1-3 may not be a tert-butyl group.

In one or more embodiments, Formulae 1-3 may satisfy at least one of Condition E1 to Condition E3, or may satisfy Condition E1 and Condition E2 at the same time:

### Condition E1

R₁ is a group represented by *-C(R₁₁)(R₁₂)(R₁₃), and
R₁₁ to R₁₃ are each independently a substituted or unsubstituted C₁-C₆₀ alkyl group, a substituted or unsubstituted C₃-C₁₀ cycloalkyl group, a substituted or unsubstituted C₂-C₁₀ heterocycloalkyl group, a substituted or unsubstituted C₆-C₆₀ aryl group, a substituted or unsubstituted C₂-C₆₀ heteroaryl group, a substituted or unsubstituted monovalent non-aromatic condensed polycyclic group, or a substituted or unsubstituted monovalent non-aromatic condensed heteropolycyclic group.

### Condition E2

R1 is a group represented by *-C(R₁₁)(R₁₂)(R₁₃), and
at least one of R₁₁ to R₁₃ are each independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition E3

R₁ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, Formulae 1-3 may satisfy at least one of Condition F1 to Condition F3, or may satisfy Condition F1 and Condition F2 at the same time:

### Condition F1

R2 is a group represented by *-C(R₂₁)(R₂₂)(R₂₃), and
R₂₁ to R₂₃ are each independently a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition F2

R2 is a group represented by *-C(R₂₁)(R₂₂)(R₂₃), and
one or more of R₂₁ to R₂₃ are each independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition F3

R₂ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, R₃ in Formula 1-3 may be hydrogen or deuterium.

In one or more embodiments, R₁ and R₂ in Formula 1-3 may be identical to each other.

In one or more embodiments, R₁ and R₂ in Formula 1-3 may be different from each other.

In one or more embodiments, at least one of R₄ and R₅ (e.g., both R₄ and R₅) in Formula 2-3 may be a methyl group.

In one or more embodiments, at least one of R₄ and R₅ in Formula 2-3 may be a tert-butyl group.

In one or more embodiments, Formulae 2-3 may satisfy at least one of Condition G1 to Condition G3, or may satisfy Condition G1 and Condition G2 at the same time:

### Condition G1

R4 is a group represented by *-C(R₄₁)(R₄₂)(R₄₃), and
R₄₁ to R₄₃ are each independently a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition G2

R4 is a group represented by *-C(R₄₁)(R₄₂)(R₄₃), and
one or more of R₄₁ to R₄₃ are each independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition G3

R₄ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, Formulae 2-3 may satisfy at least one of Condition H1 to Condition H3, or may satisfy Condition H1 and Condition H2 at the same time:

### Condition H1

R₅ is a group represented by *-C(R₅₁)(R₅₂)(R₅₃), and
R₅₁ to R₅₃ are each independently a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition H2

R₅ may be a group represented by *-C(R₅₁)(R₅₂)(R₅₃), and
one or more of R₅₁ to R₅₃ are each independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

### Condition H3

R₅ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, R₆ in Formula 2-3 may be hydrogen or deuterium.

In one or more embodiments, R₄ and R₅ in Formula 2-3 may be identical to each other.

In one or more embodiments, R₄ and R₅ in Formula 2-3 may be different from each other.

e1 to e8 and d1 to d8 in Formulae 1-1, 1-2, 2-1, and 2-2 indicates numbers of Z₁ to Z₈, a group represented by *-[W₁-(Z₁)ₑ₁], a group represented by *-[W₂-(Z₂)ₑ₂], a group represented by *-[W₃-(Z₃)ₑ₃], a group represented by *-[W₄-(Z₄)ₑ₄], a group represented by *-[W₅-(Z₅)ₑ₅], a group represented by *-[W₆-(Z₆)ₑ₆], a group represented by *-[W₇-(Z₇)ₑ₇], and a group represented by *-[W₈-(Z₈)ₑ₈], respectively, and may each independently be an integer from 0 to 20. When e1 is 2 or more, two or more of Z₁(s) may be identical to or different from each other, when e2 is 2 or more, two or more of Z₂(s) may be identical to or different from each other, when e3 is 2 or more, two or more of Z₃(S) may be identical to or different from each other, when e4 is 2 or more, two or more of Z₄(s) may be identical to or different from each other, when e5 is 2 or more, two or more of Z₅(s) may be identical to or different from each other, when e6 is 2 or more, two or more of Z₆(s) may be identical to or different from each other, when e7 is 2 or more, two or more of Z₇(s) may be identical to or different from each other, when e8 is 2 or more, two or more of Z₈(s) may be identical to or different from each other, when d1 is 2 or more, two or more of groups represented by *-[W₁-(Z₁)ₑ₁] may be identical to or different from each other, when d2 is 2 or more, two or more of groups represented by *-[W₂-(Z₂)ₑ₂] may be identical to or different from each other, when d3 is 2 or more, two or more of groups represented by *-[W₃-(Z₃)ₑ₃] may be identical to or different from each other, when d4 is 2 or more, two or more of groups represented by *-[W₄-(Z₄)ₑ₁] may be identical to or different from each other, when d5 is 2 or more, two or more of groups represented by *-[W₅-(Z₅)ₑ₅] may be identical to or different from each other, when d6 is 2 or more, two or more of groups represented by *-[W₆-(Z₆)ₑ₆] may be identical to or different from each other, when d7 is 2 or more, two or more of groups represented by *-[W₇-(Z₇)ₑ₇] may be identical to or different from each other, and when d8 is 2 or more, two or more of groups represented by *-[W₈-(Z₈)ₑ₈] may be identical to or different from each other. In one or more embodiments, e1 to e8 and d1 to d8 in Formulae 1-1, 1-2, 2-1, and 2-2 may each independently be 0, 1, 2, or 3.

For each of the cases of i) two or more of a plurality of Z₁(s), ii) two or more of a plurality of Z₂(s), iii) two or more of a plurality of Z₃(s), iv) two or more of a plurality of Z₄(s), v) two or more of a plurality of Z₅(s), vi) two or more of a plurality of Z₆(s), vii) two or more of a plurality of Z₇(s), viii) two or more of a plurality of Z₈(s), ix) two or more of R₁ to R₃, and x) at least two of R₄ to R₆, constituent elements may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ may be as described in connection with Z₁ in the present specification.

* and *' in Formula 1-1 to 1-3 and 2-1 to 2-3 each indicate a binding site to iridium in Formulae 1 and 2.

The symbols *, *' and *" as used herein each indicate a binding site to a neighboring atom, unless otherwise stated.

In one or more embodiments, a group represented by 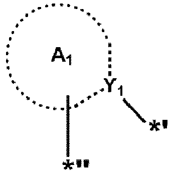 in Formula 1-1 may be a group represented by one of NR(4) to NR(28).

A group represented by 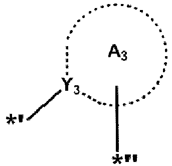 in Formula 1-2,
a group represented by 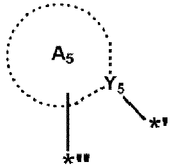 in Formula 2-1, and
a group represented by 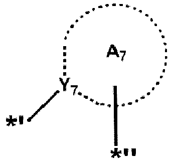 in Formula 2-2 may each independently be a group represented by one of Formulae NR(1) to NR(28): 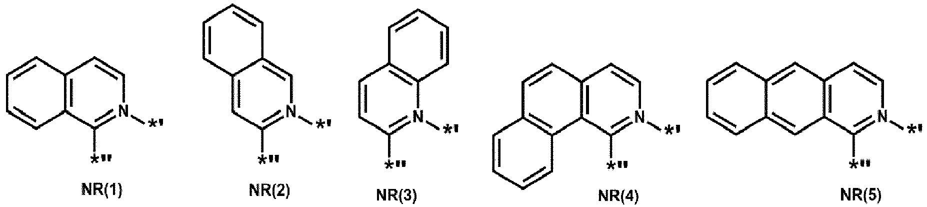 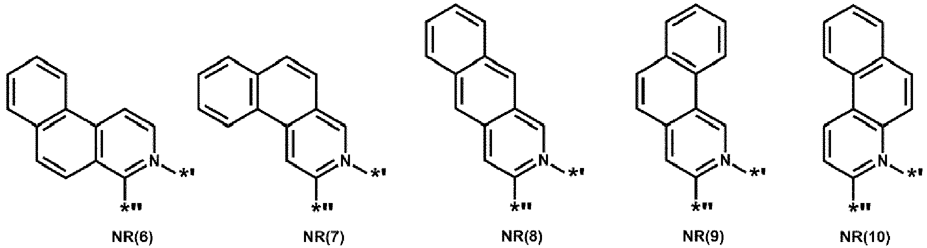 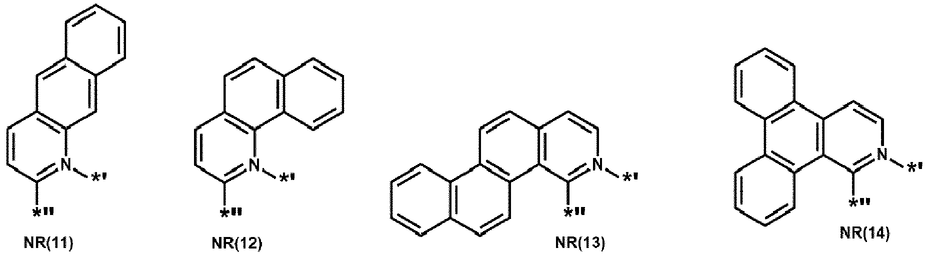 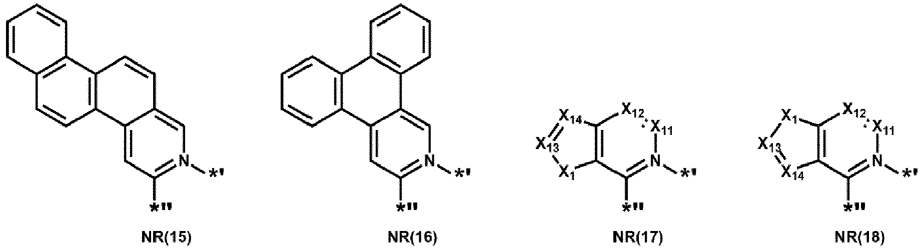 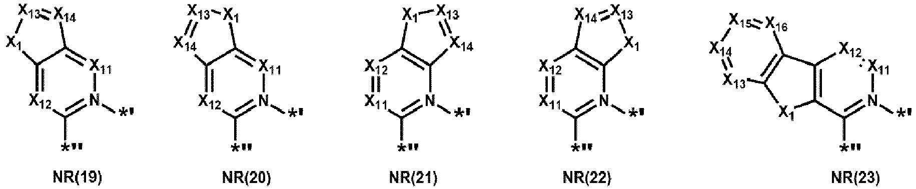 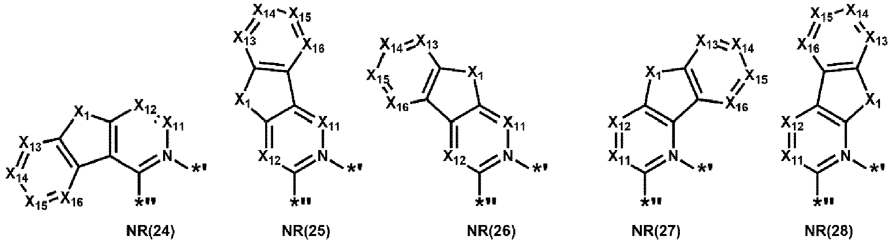 wherein, in Formulae NR(1) to NR(28),
X₁ may be O or S,
X11 to X16 may each independently be C or N,
* indicates a binding site to iridium in Formulae 1 and 2, and
*" indicates a binding site to ring A₂, ring A₄, ring A₆, or ring A₈.

In one or more embodiments,
Y₂ of Formula 1-1, Y₄ of Formula 1-2, Y₆ of Formula 2-1, and Y₈ of Formula 2-2 may each be C, and
a group represented by 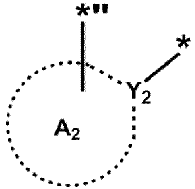 in Formula 1-1,
a group represented by 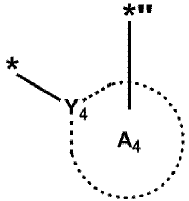 in Formula 1-2,
a group represented by 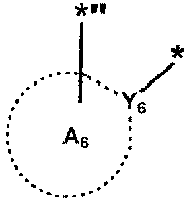 in Formula 2-1, and
a group represented by 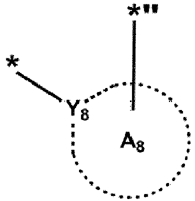 in Formula 2-2 may each independently be a group represented by one of Formulae CR1 to CR29: 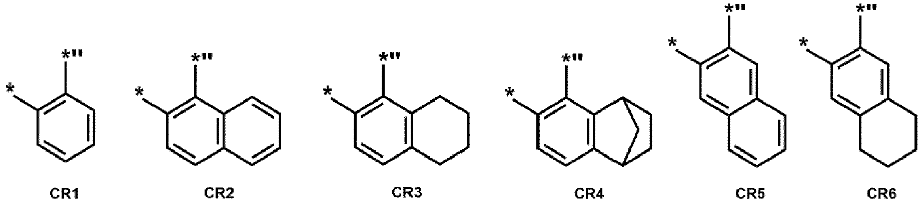 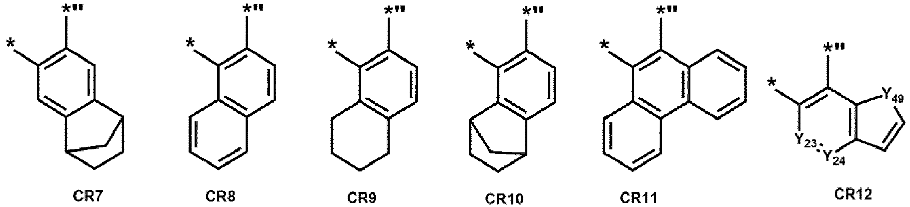 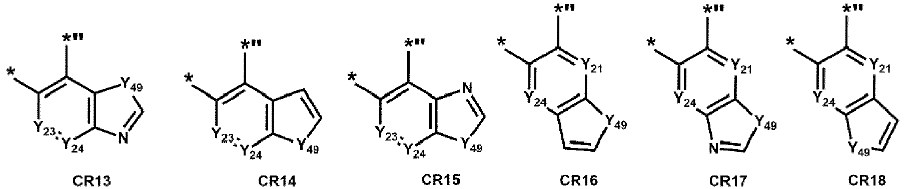 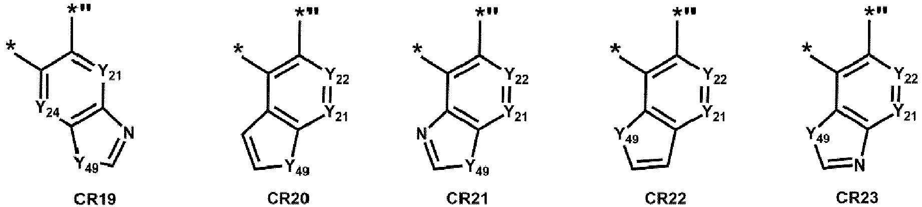 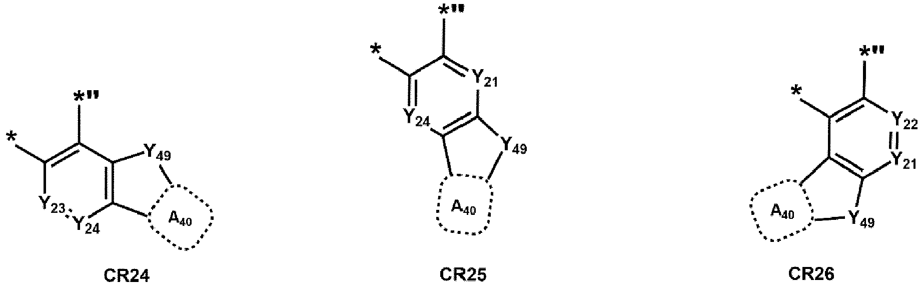 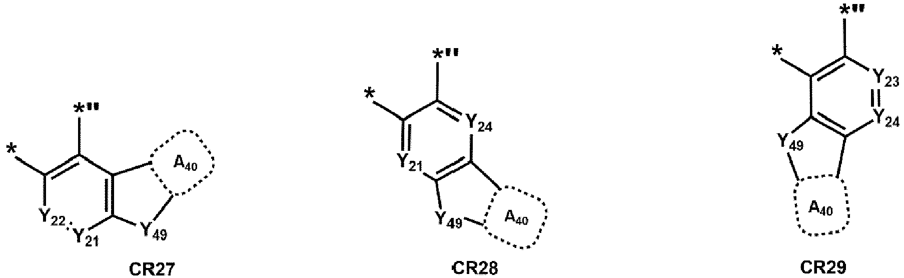
wherein, in Formulae CR1 to CR29,
Y49 may be O, S, Se, N-[W2-(Z2)e2], N-[W4-(Z4)e4], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}), or Si(Z₈₉ₐ)(Z_{89b}),
W₂, W₄, W₆, W₈, Z₂, Z₄, Z₆, Z₈, e2, e4, e6, and e8 are respectively as described in the present specification,
Z₂₉ₐ and Z_{29b} are respectively as described in connection with Z₂ in the present specification,
Z₄₉ₐ and Z_{49b} are respectively as described in connection with Z₄ in the present specification,
Z₆₉ₐ and Z_{69b} are respectively as described in connection with Z₆ in the present specification,
Z₈₉ₐ and Z_{89b} are respectively as described in connection with Z₈ in the present specification,
Y₂₁ to Y₂₄ may each independently be N or C,
ring A₄₀ may be a substituted or unsubstituted C₅-C₃₀ carbocyclic group or a substituted or unsubstituted C₁-C₃₀ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, a benzoquinazoline group, or the like),
* indicates a binding site to iridium in Formulae 1 and 2, and
*" indicates a binding site to ring A₁, ring A₃, ring A₅, and ring A₇.

In one or more embodiments,
a group represented by 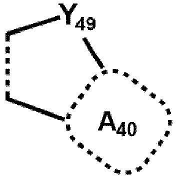 in Formulae CR24 to CR29 may be a group represented by one of Formulae CR(1) to CR(13): 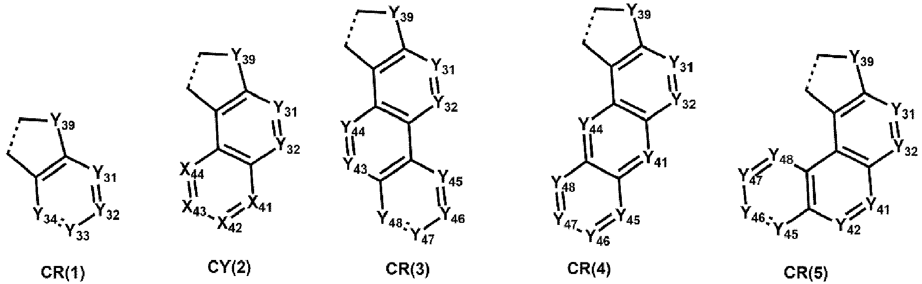 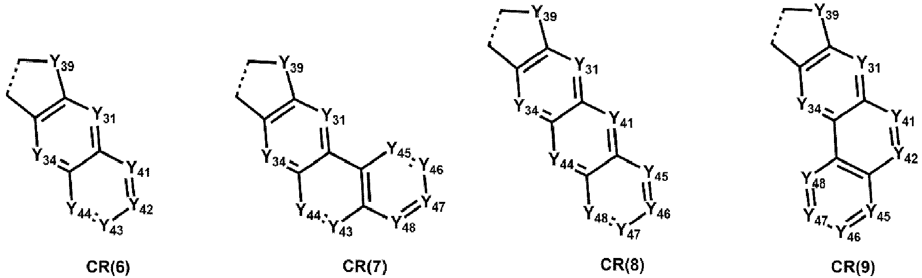 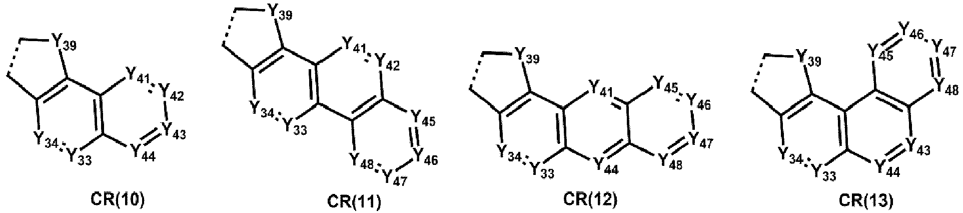 wherein, in Formulae CR(1) to CR(13),
Y₃₉ may be the same as described herein in connection with Y₄₉ as described herein, and
Y₃₁ to Y₃₄ and Y₄₁ to Y₄₈ may each independently be C or N.

In one or more embodiments, the first compound may include at least one deuterium.

In one or more embodiments, the second compound may include at least one deuterium.

In one or more embodiments, a weight ratio of the first compound to the second compound included in the composition may be about 90:10 to about 10:90, about 80:20 to about 20:80, about 70:30 to about 30:70, or about 60:40 to about 40:60.

The first compound may emit a first light having a first spectrum, wherein λP(1) may be an emission maximum (peak) wavelength (nanometers, nm) of the first spectrum.

The second compound may emit a second light having a second spectrum, wherein λP(2) may be an emission maximum (peak) wavelength (nm) of the second spectrum.

The λP(1) and the λP(2) may be evaluated from a photoluminescence (PL) spectrum measured for a first film and a second film, respectively.

The term "first film" as used herein refers to a film including the first compound, and the term "second film" as used herein refers to a film including the second compound. The first film and the second film may be manufactured using various methods, such as a vacuum deposition method, a coating method, and a heating method. The first film and the second film may further include a compound, for example, a host described herein, other than the first compound and the second compound.

In one or more embodiments, λP(1) and λP(2) may each be about 570 nm to about 650 nm, or about 600 nm to about 650 nm.

In one or more embodiments, an absolute value of a difference between the AP(1) and the λP(2) may be 0 nm to about 30 nm, 0 nm to about 20 nm, or 0 nm to about 10 nm.

In one or more embodiments, the first light and second light may each be red light (for example, light having an emission maximum (peak) wavelength in the range of about 570 nm to about 650 nm).

In one or more embodiments, the composition may not emit white light.

In one or more embodiments, the composition may emit red light (for example, light having an emission maximum (peak) wavelength in the range of about 570 nm to about 650 nm).

In one or more embodiments, the first compound may be one of the compounds of Group R1-6 to Group R1-11.

In one or more embodiments, the second compound may be one of the compounds of Group R1-1 to Group R1-11.

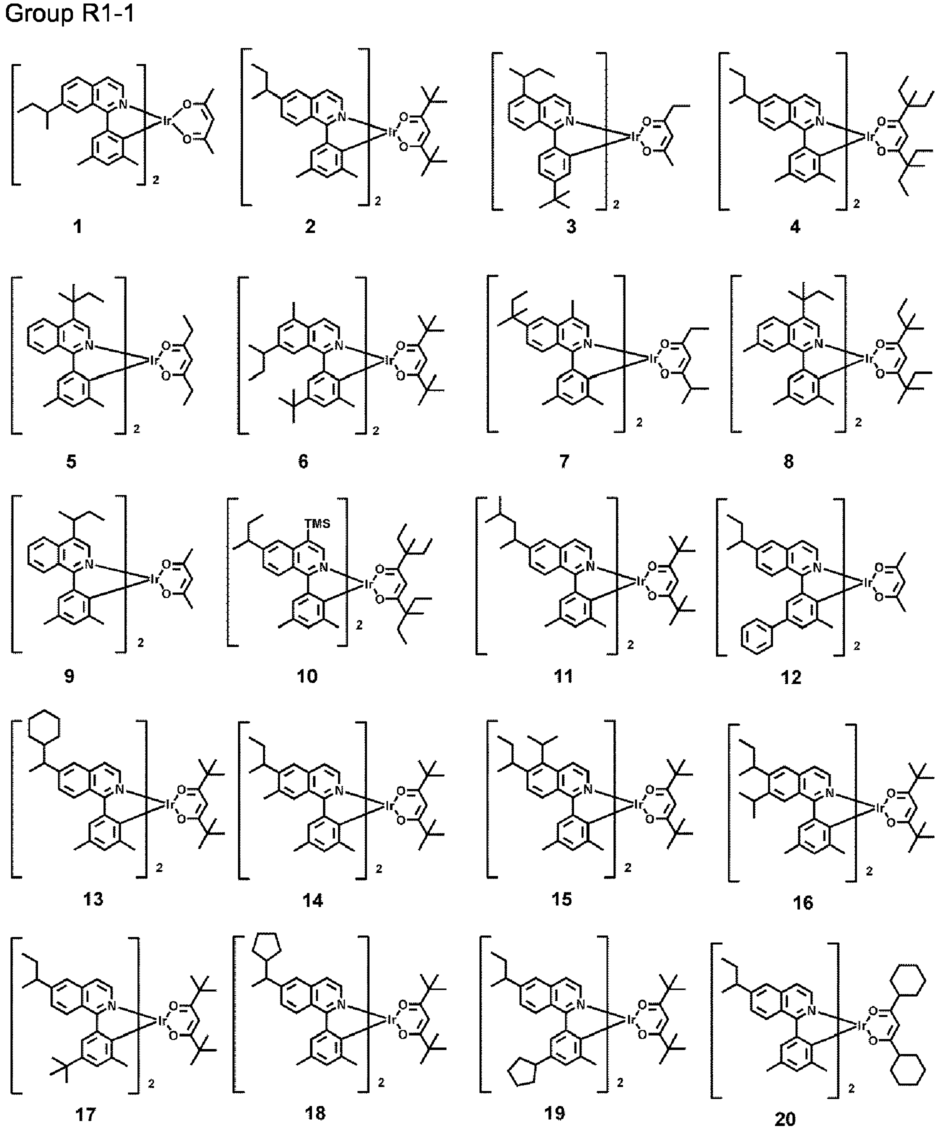

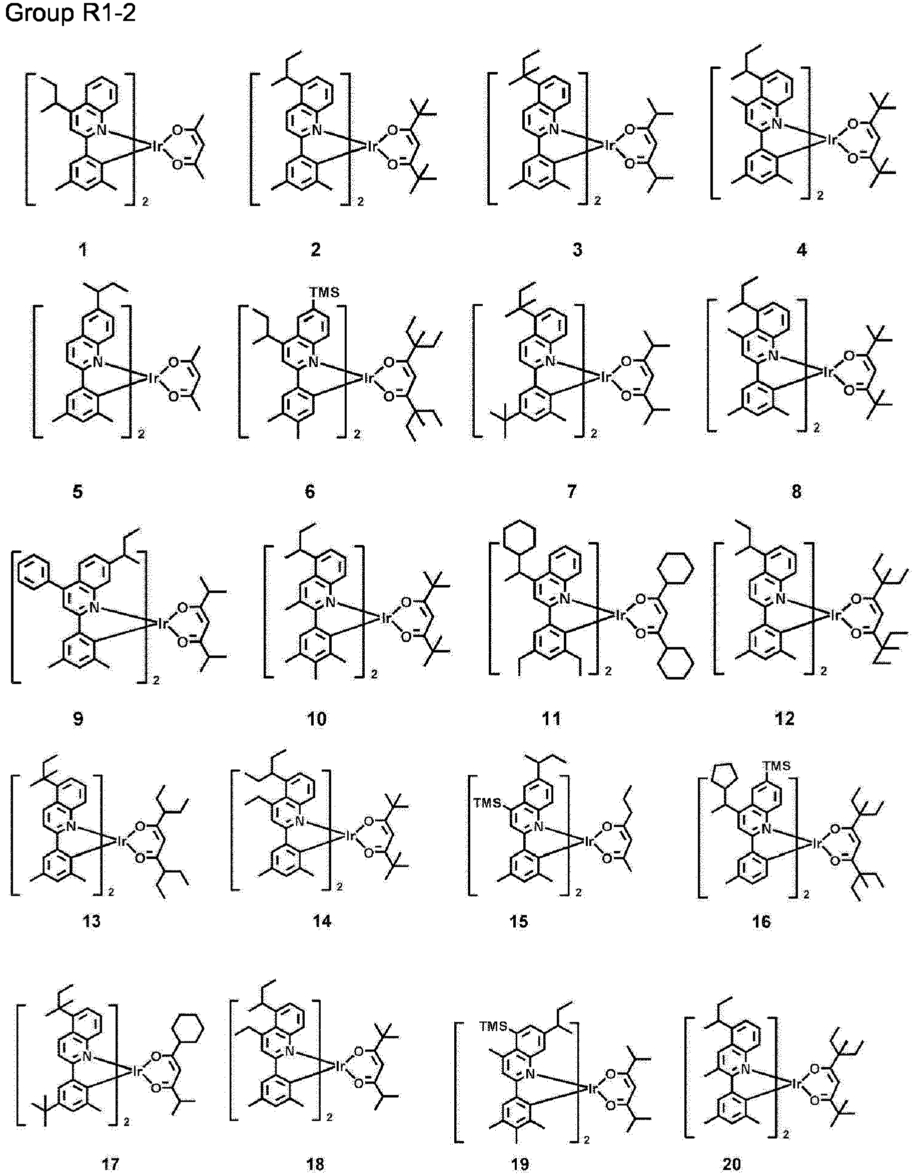

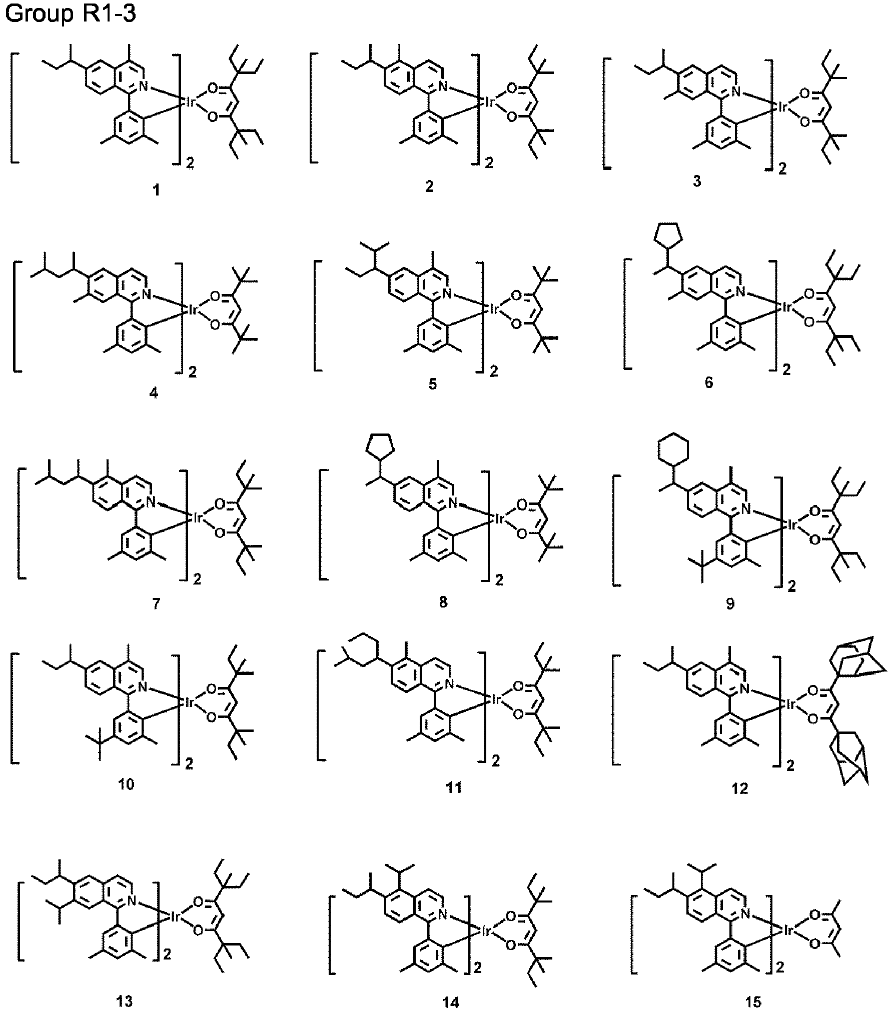

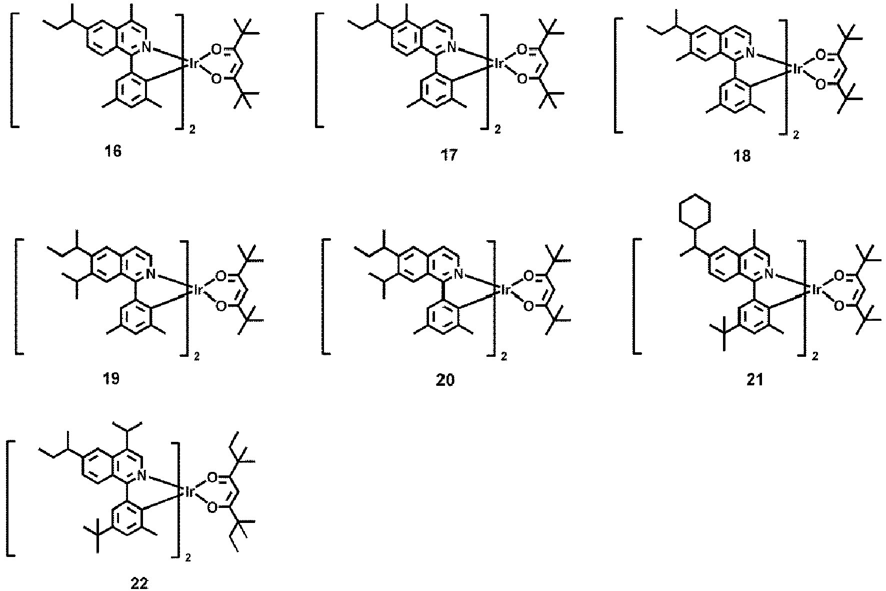

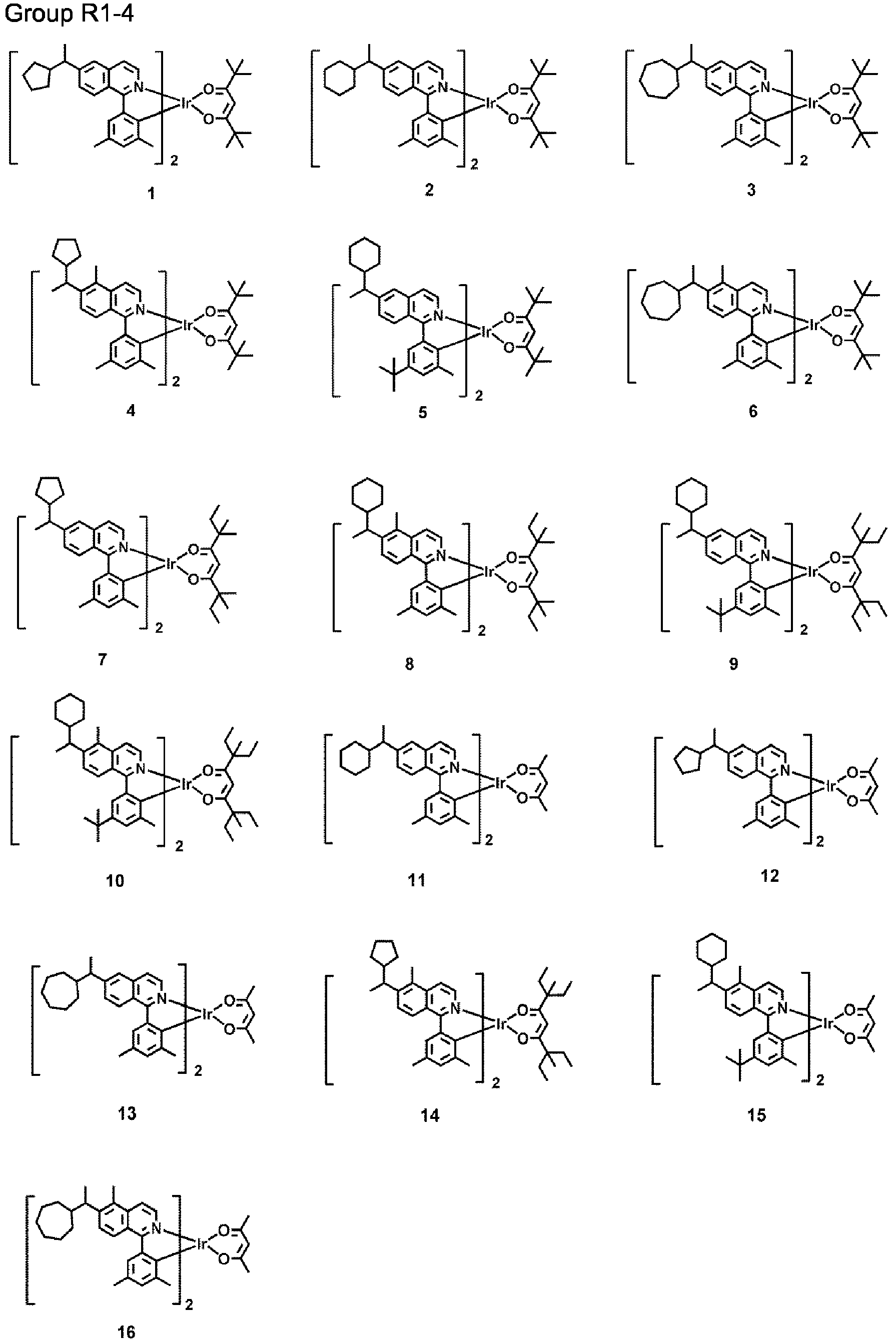

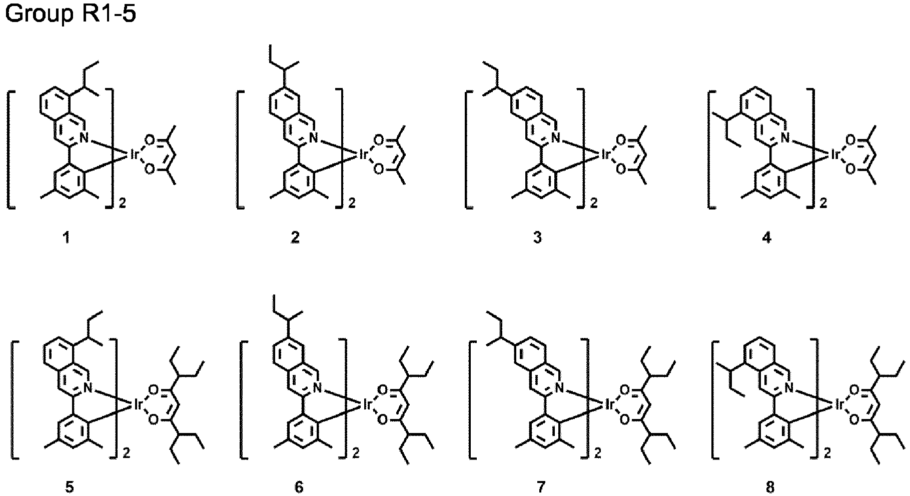

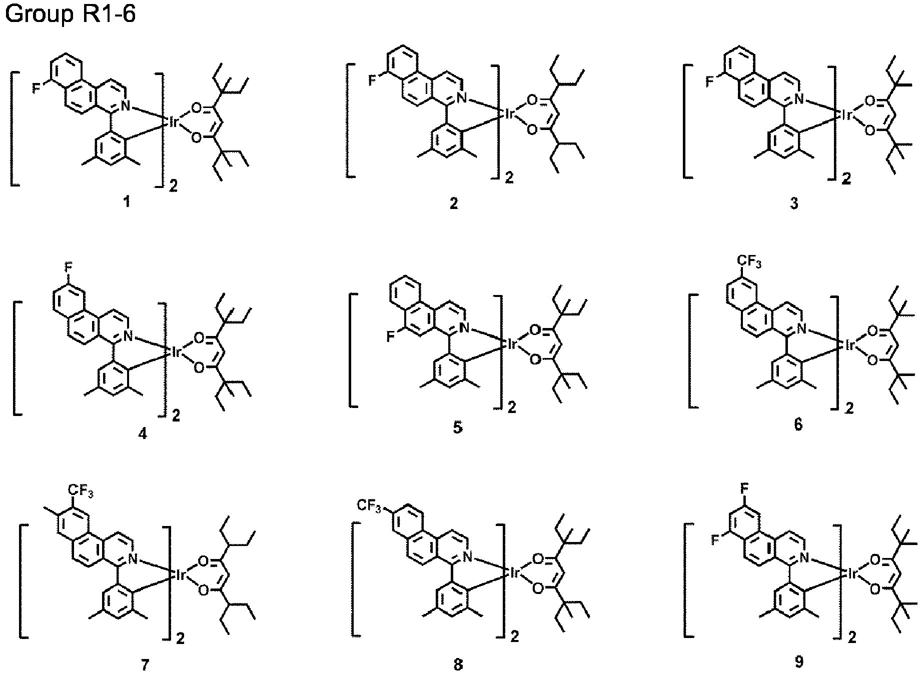

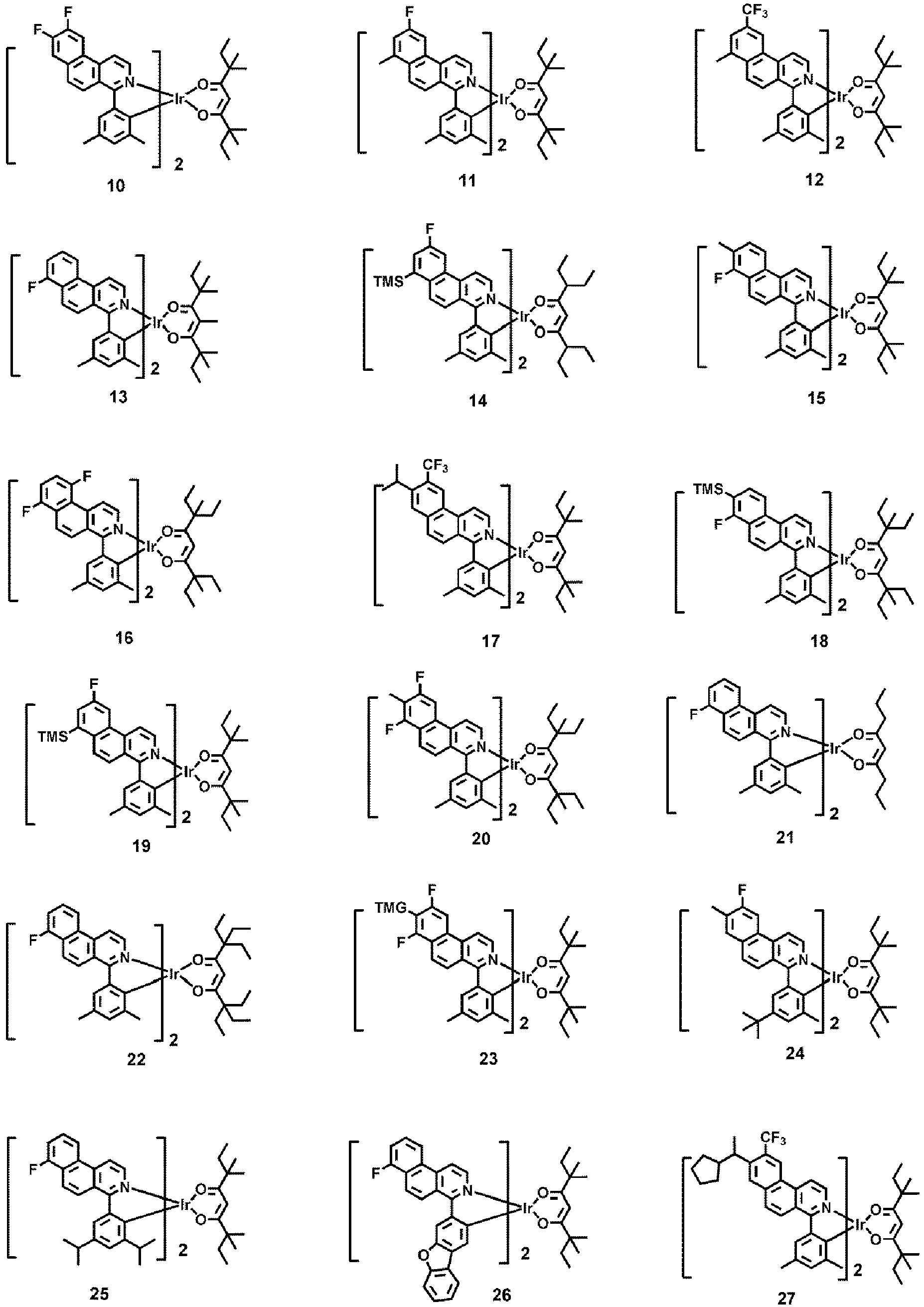

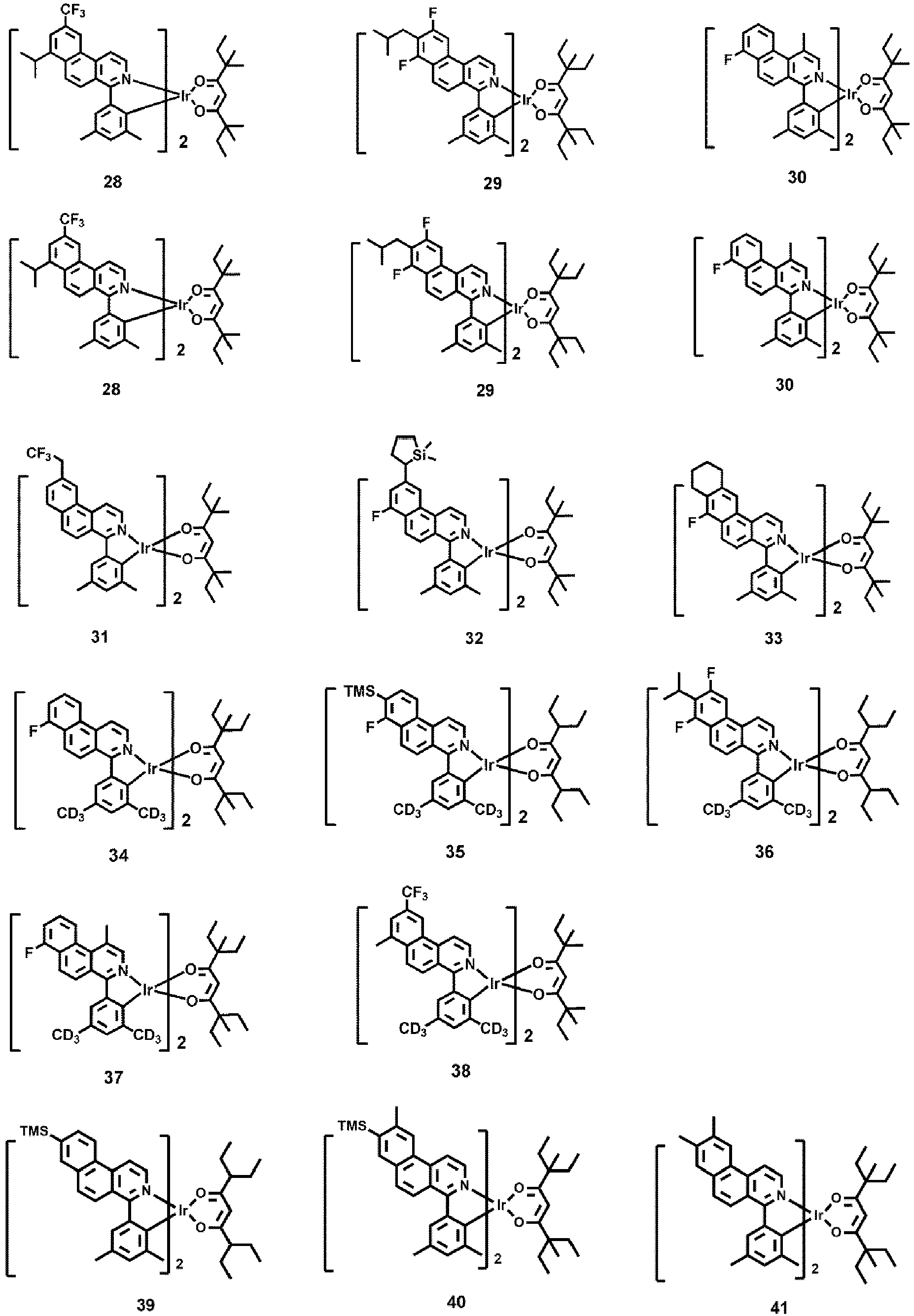

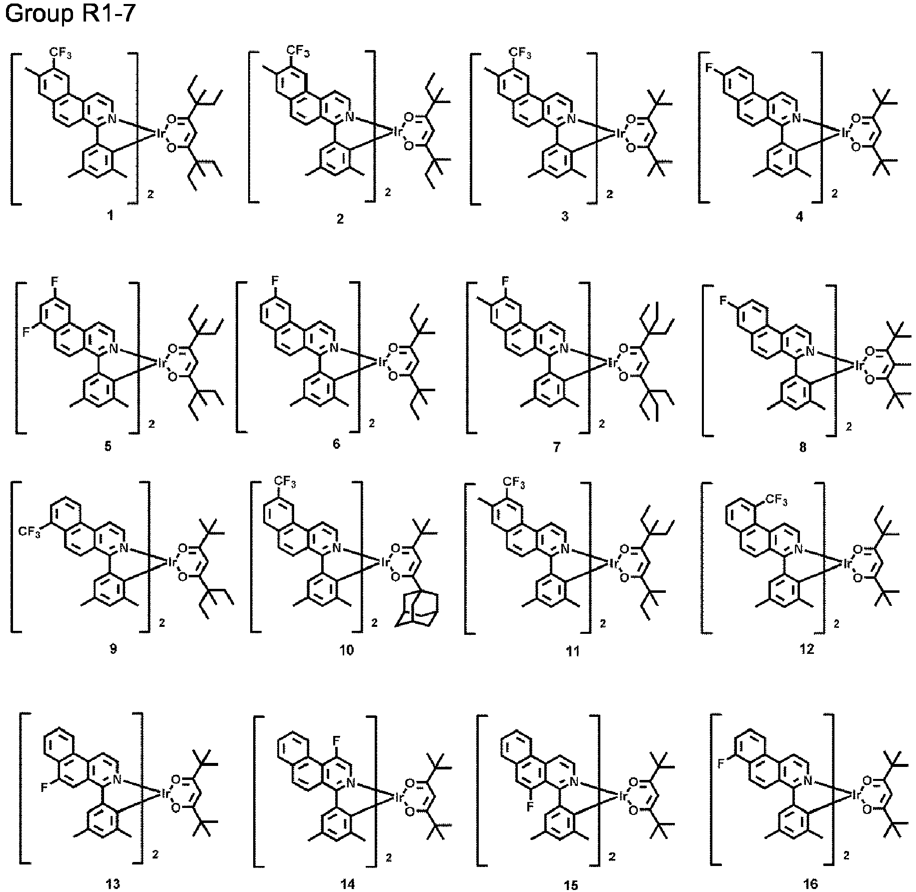

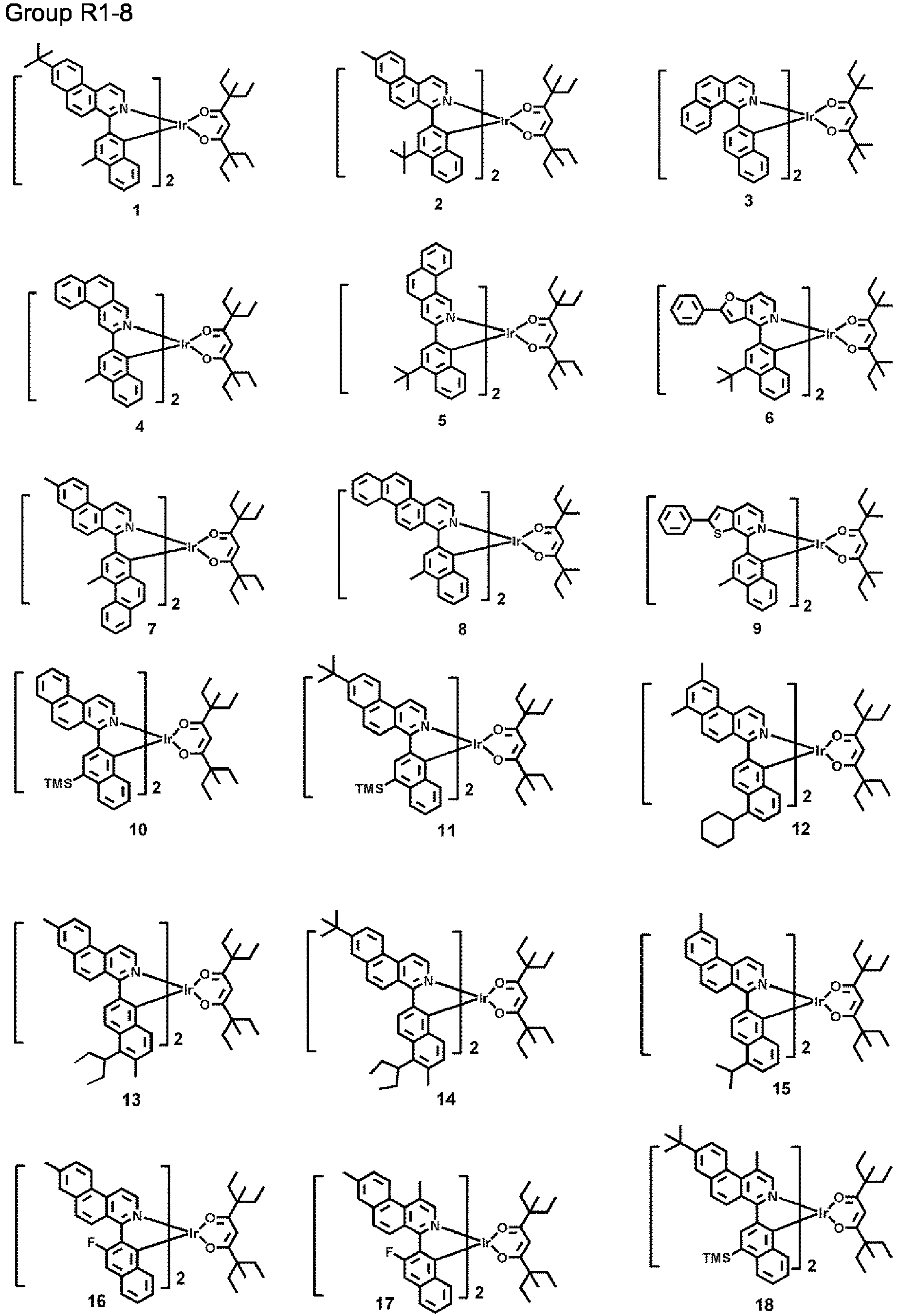

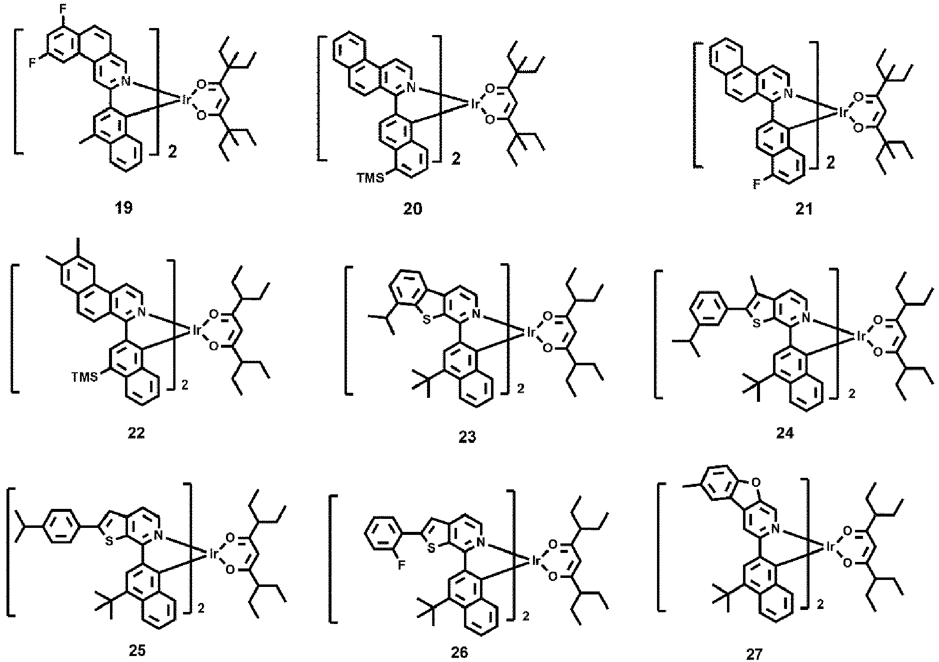

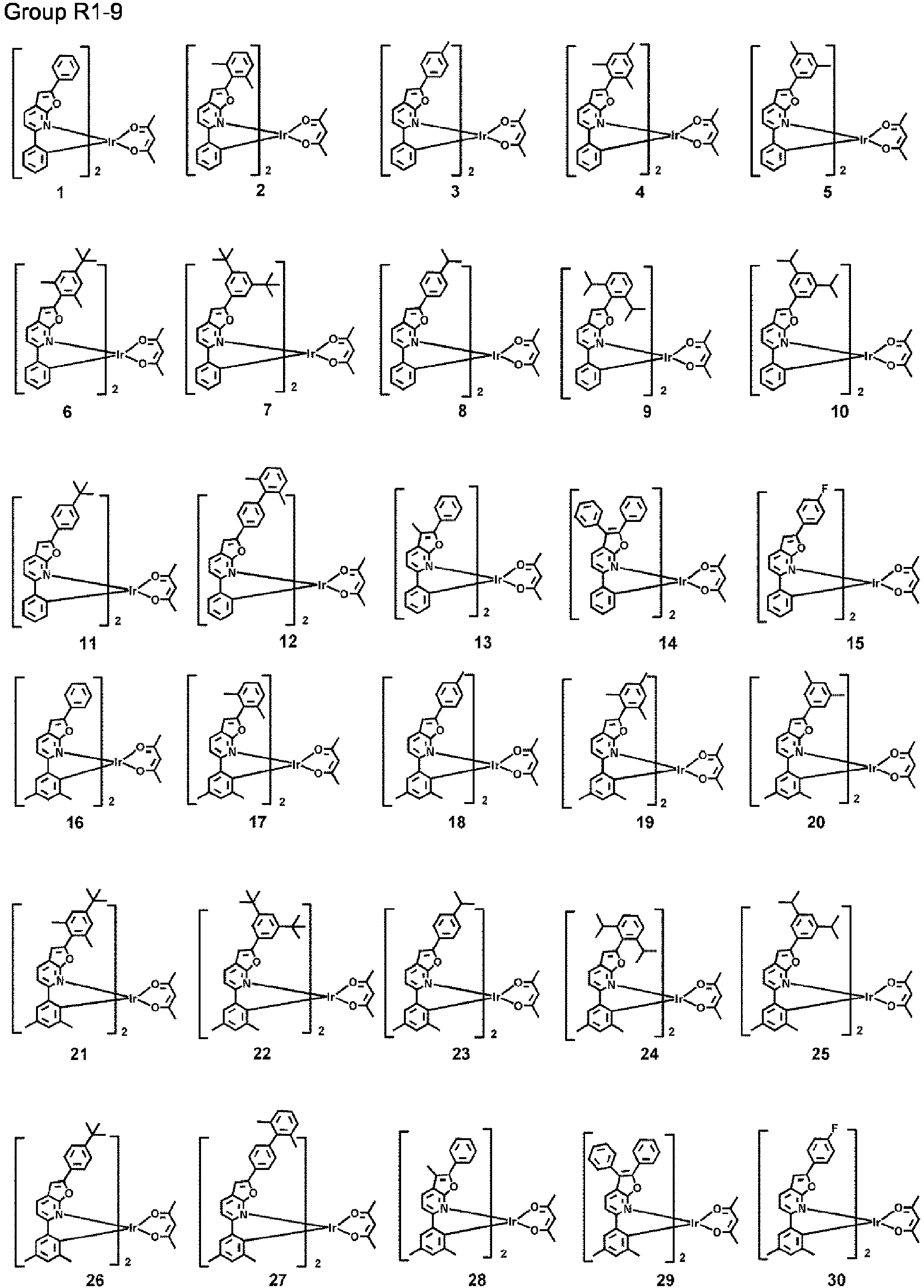

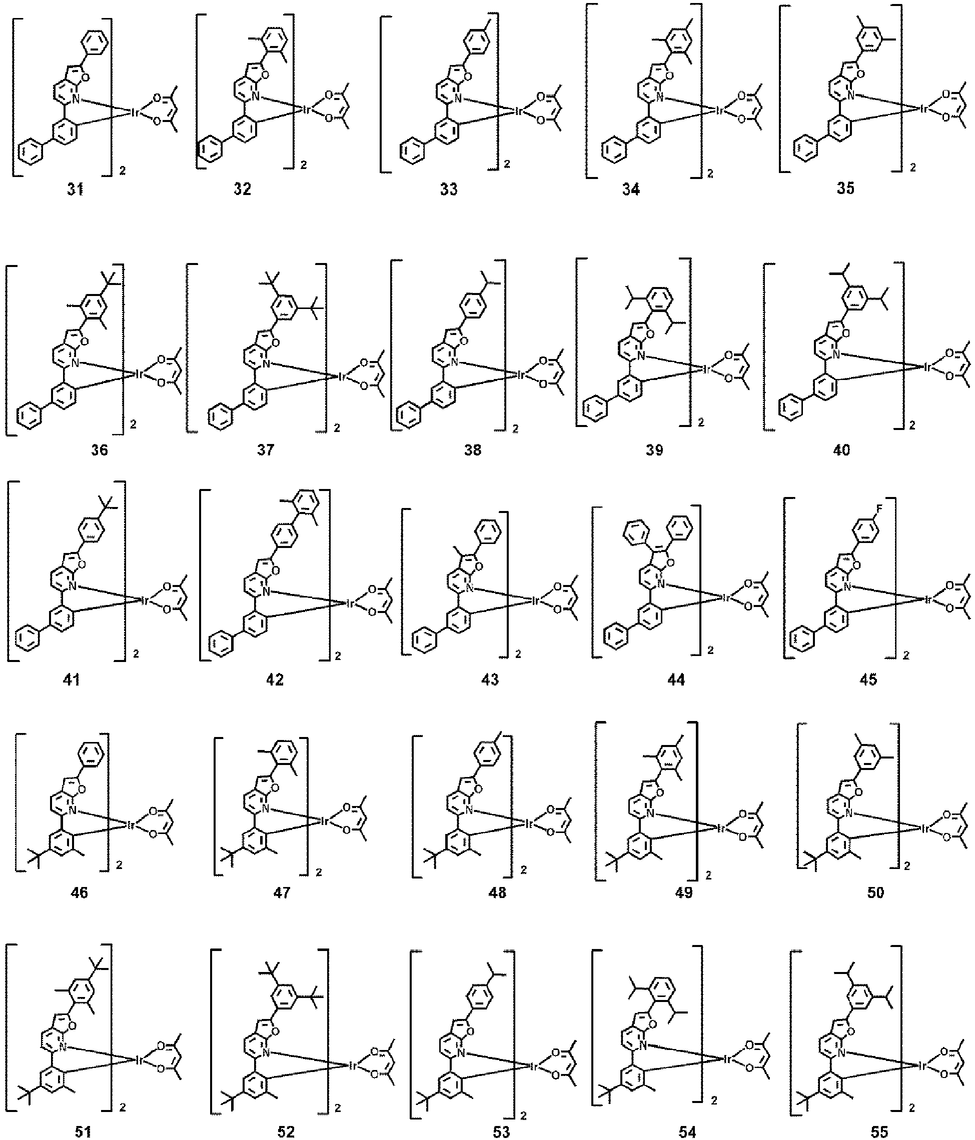

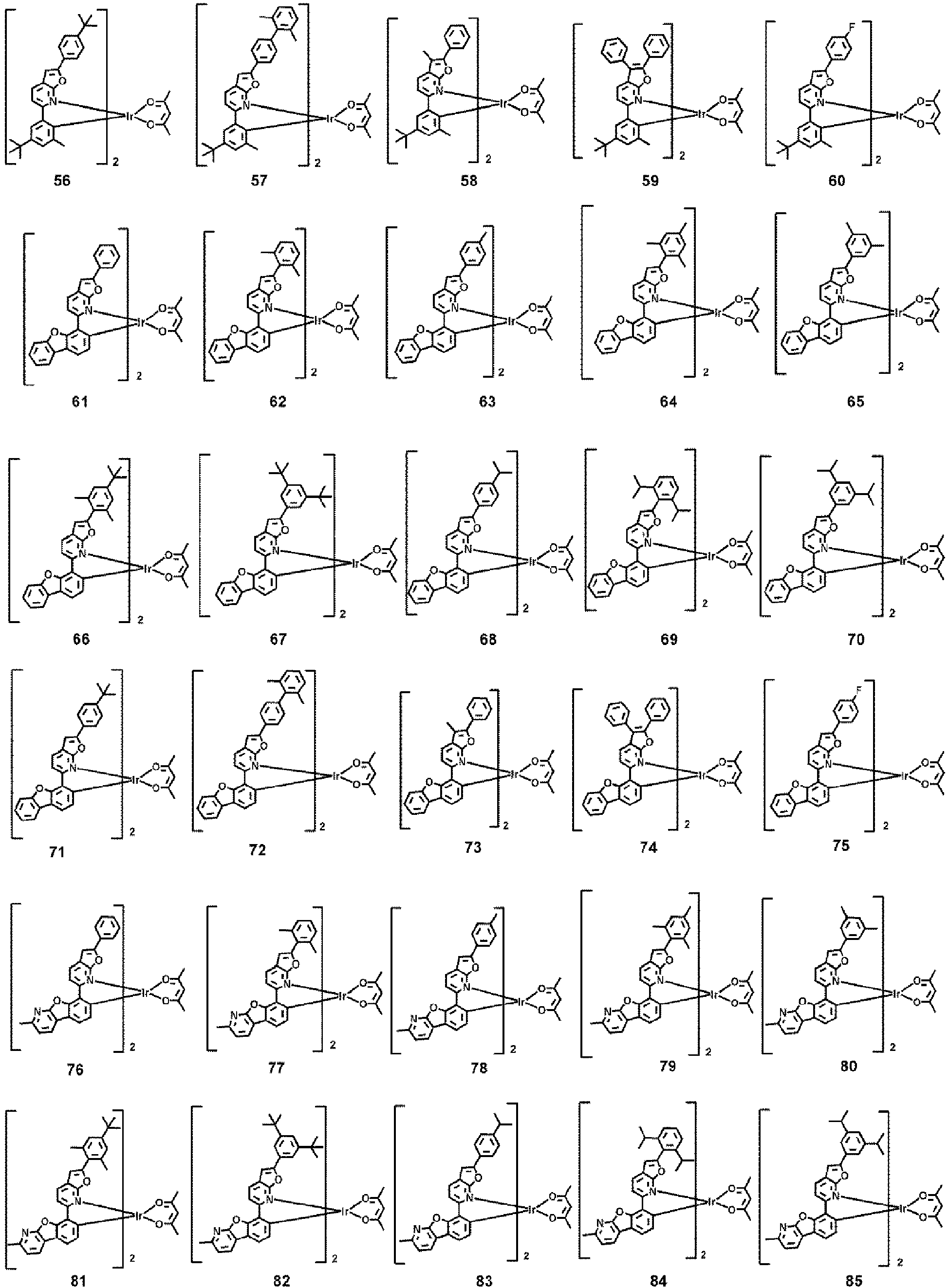

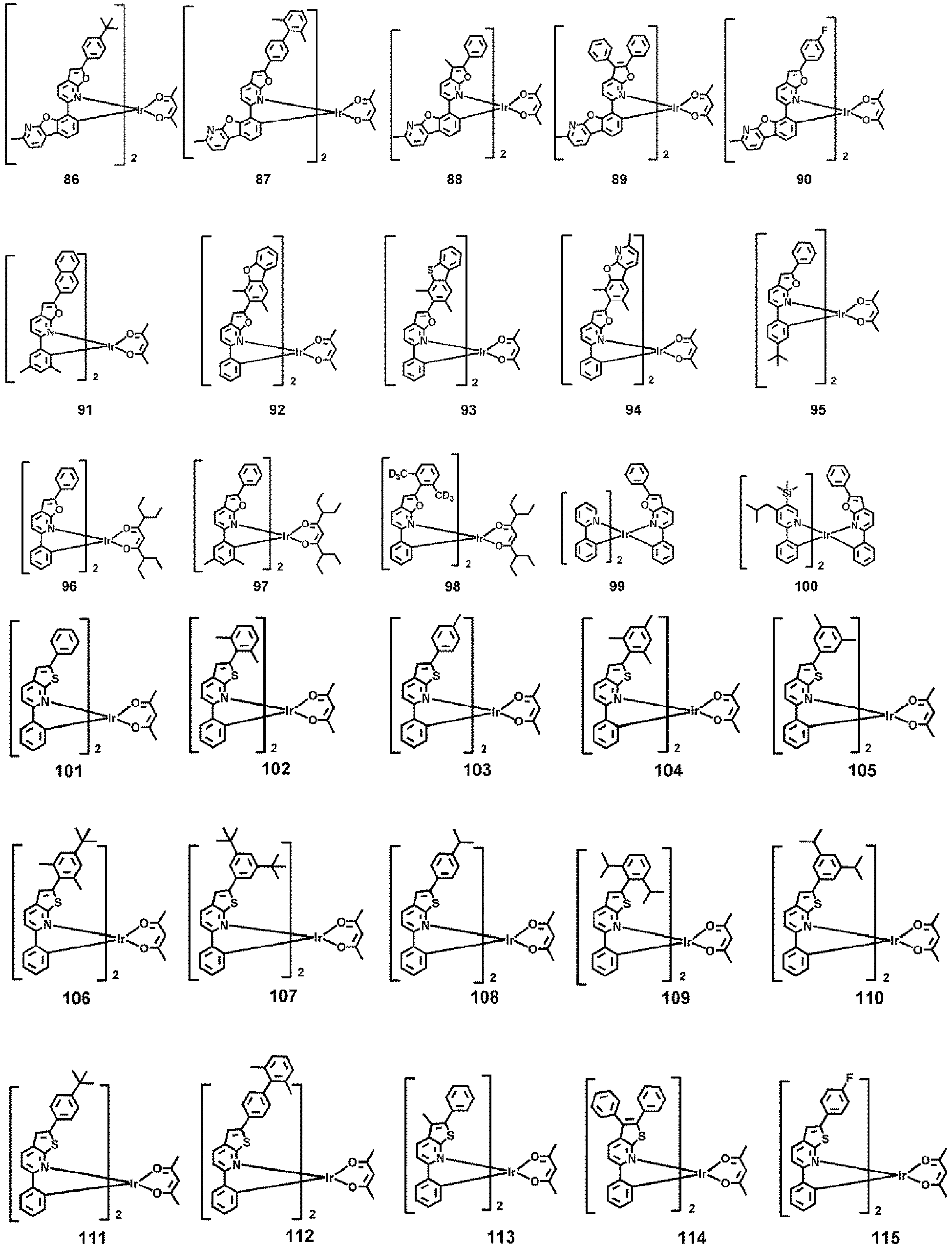

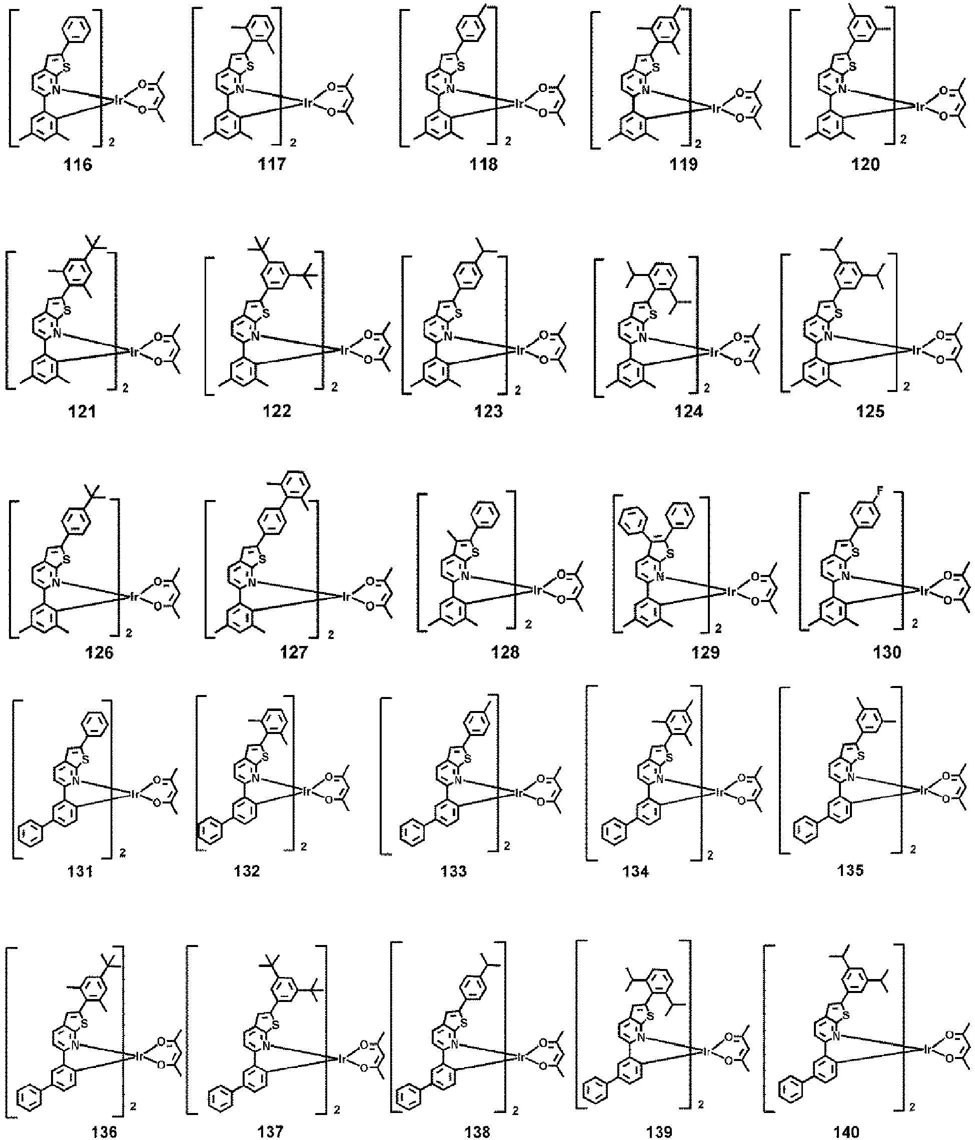

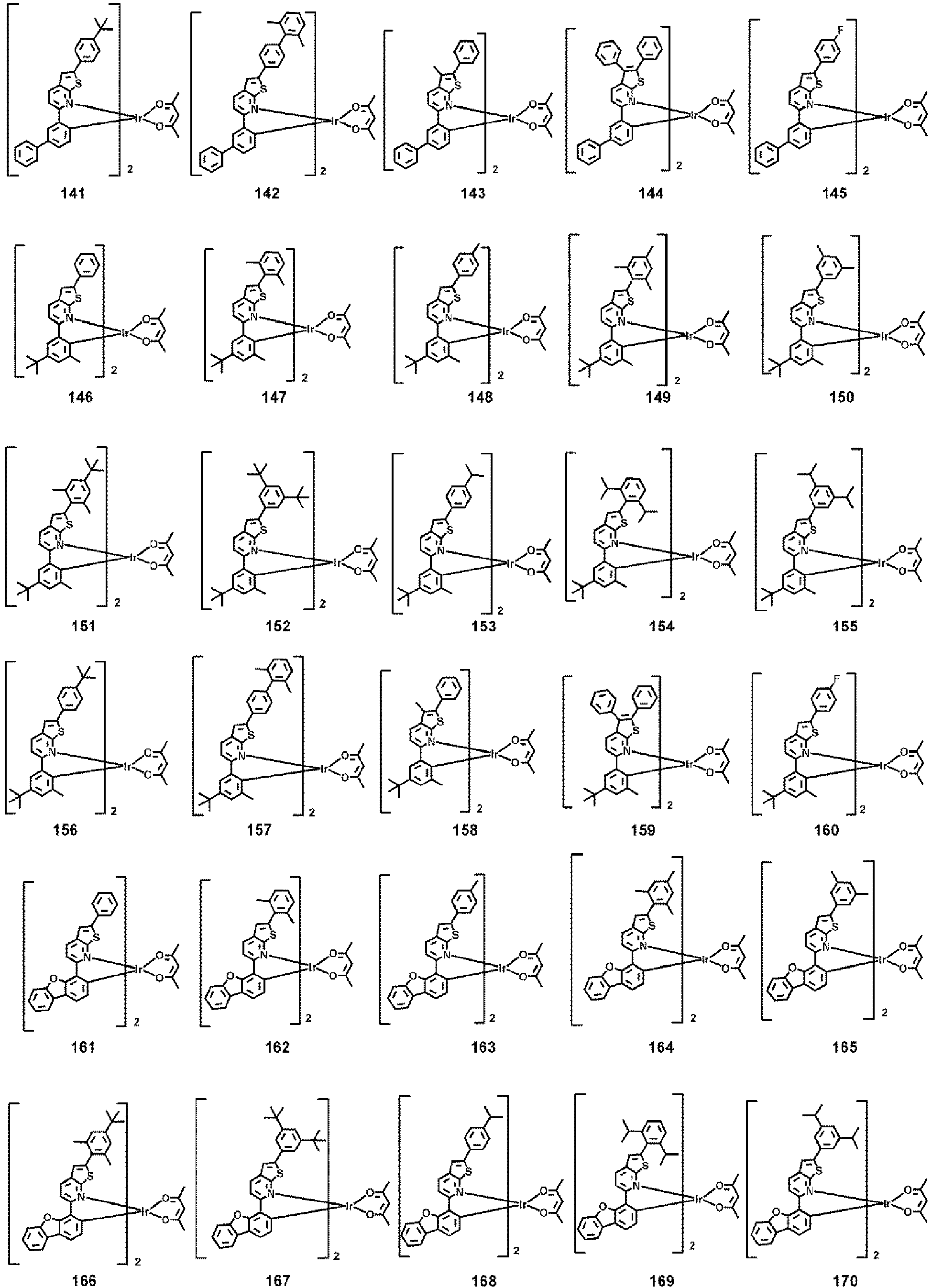

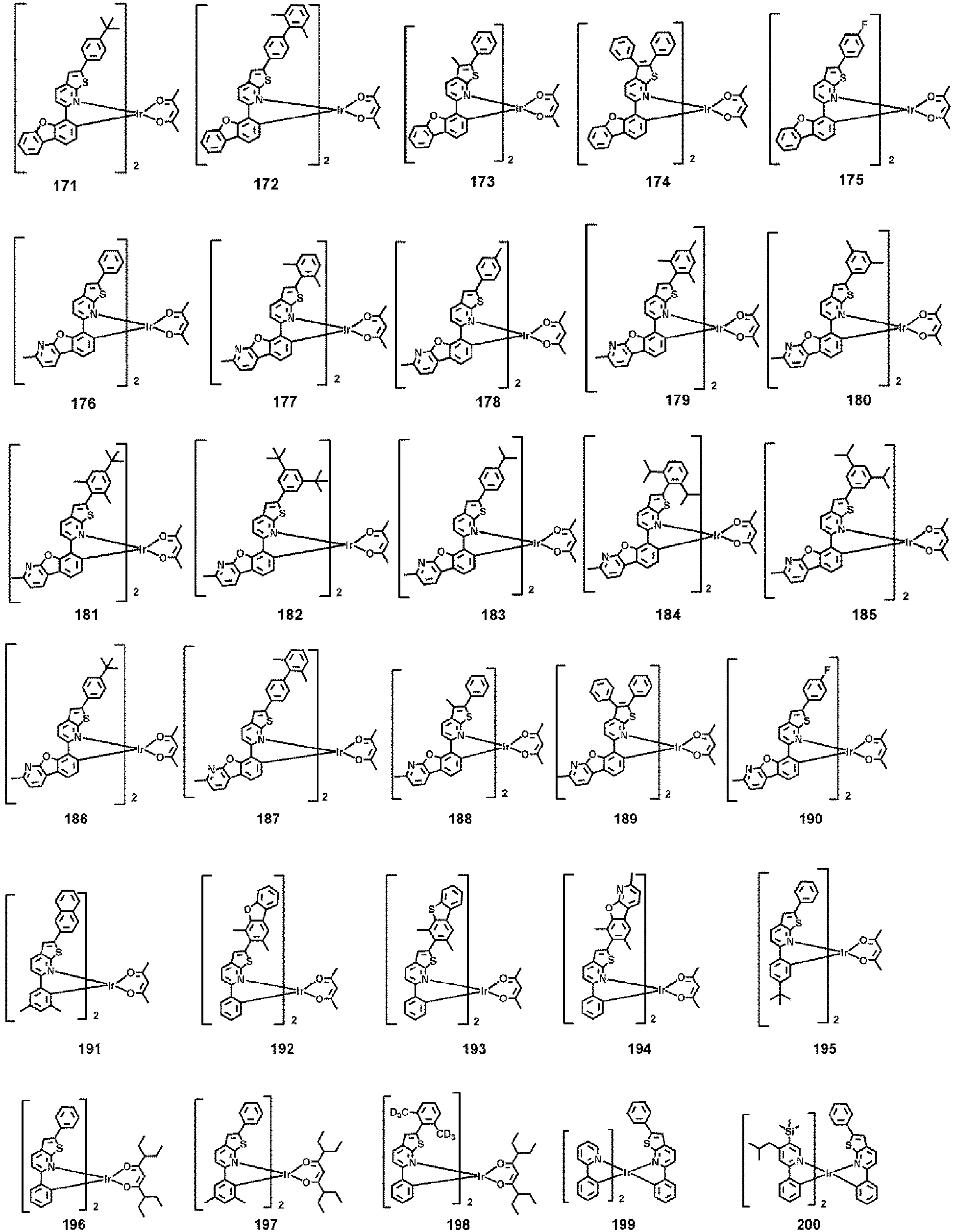

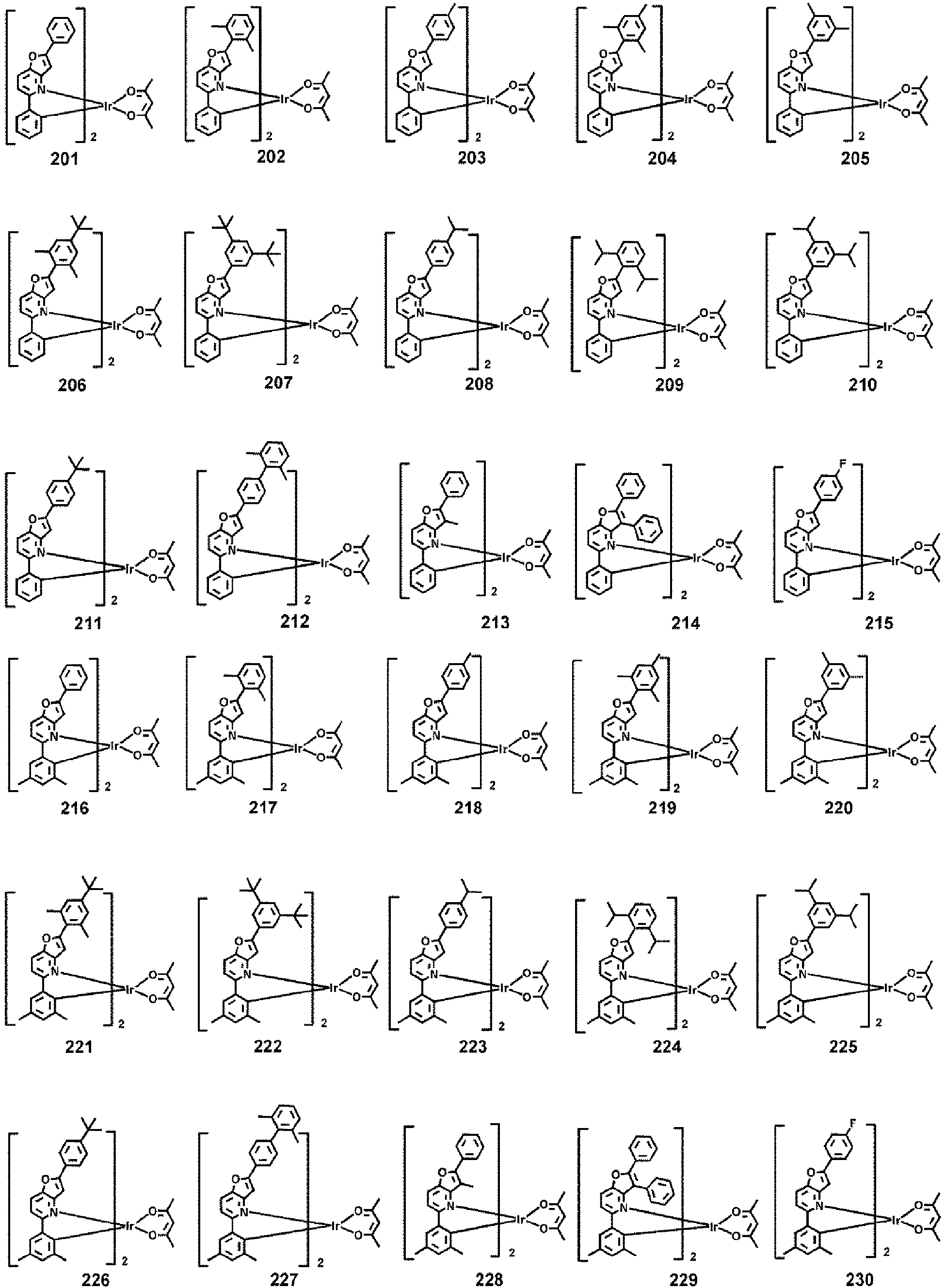

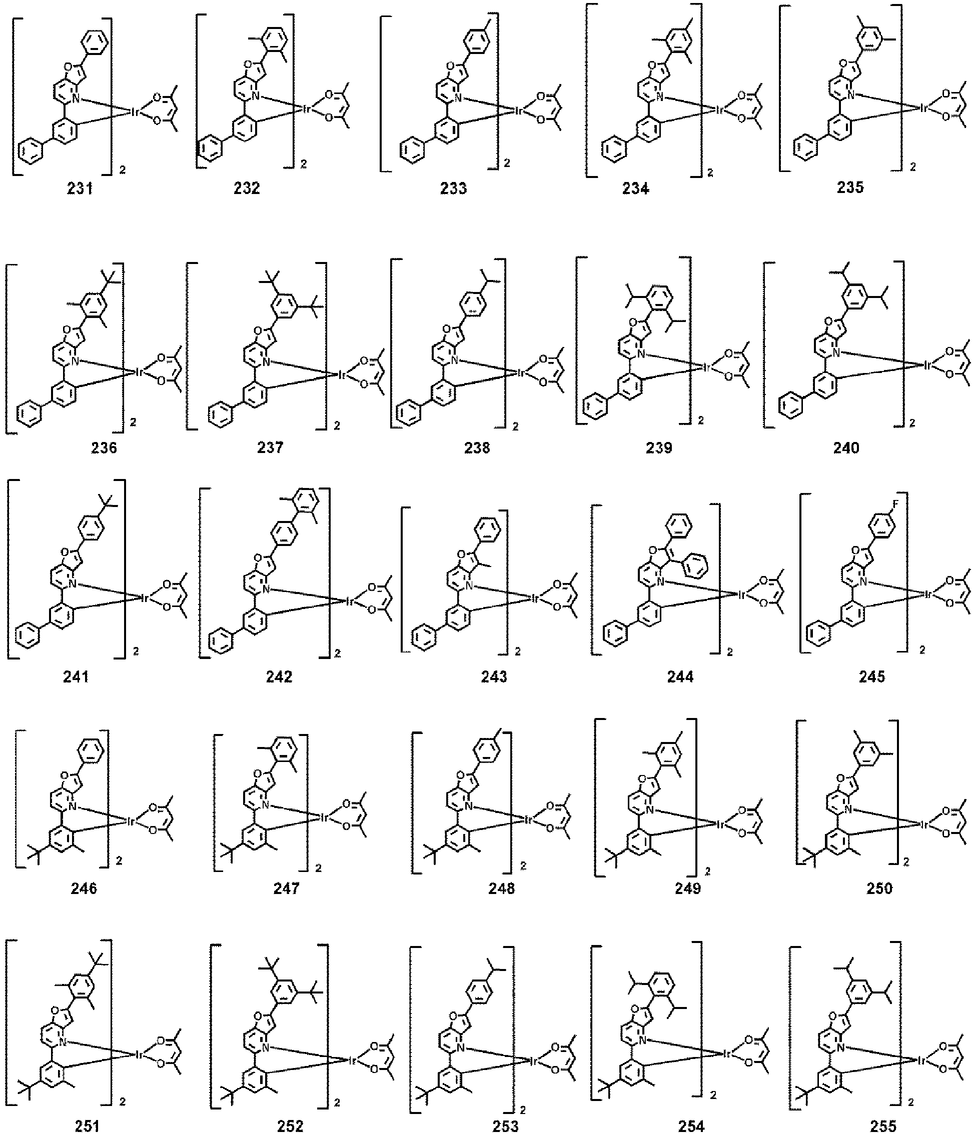

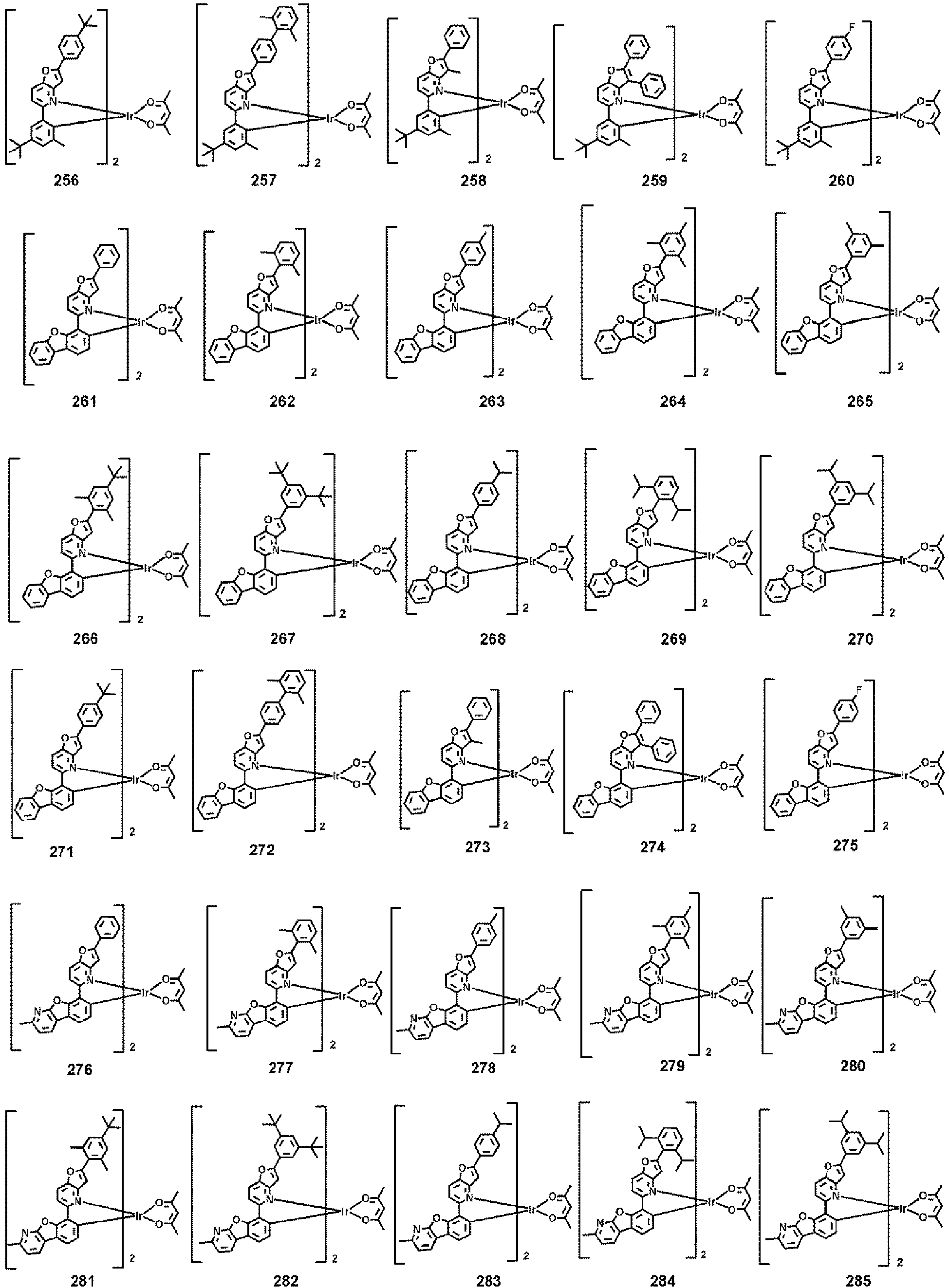

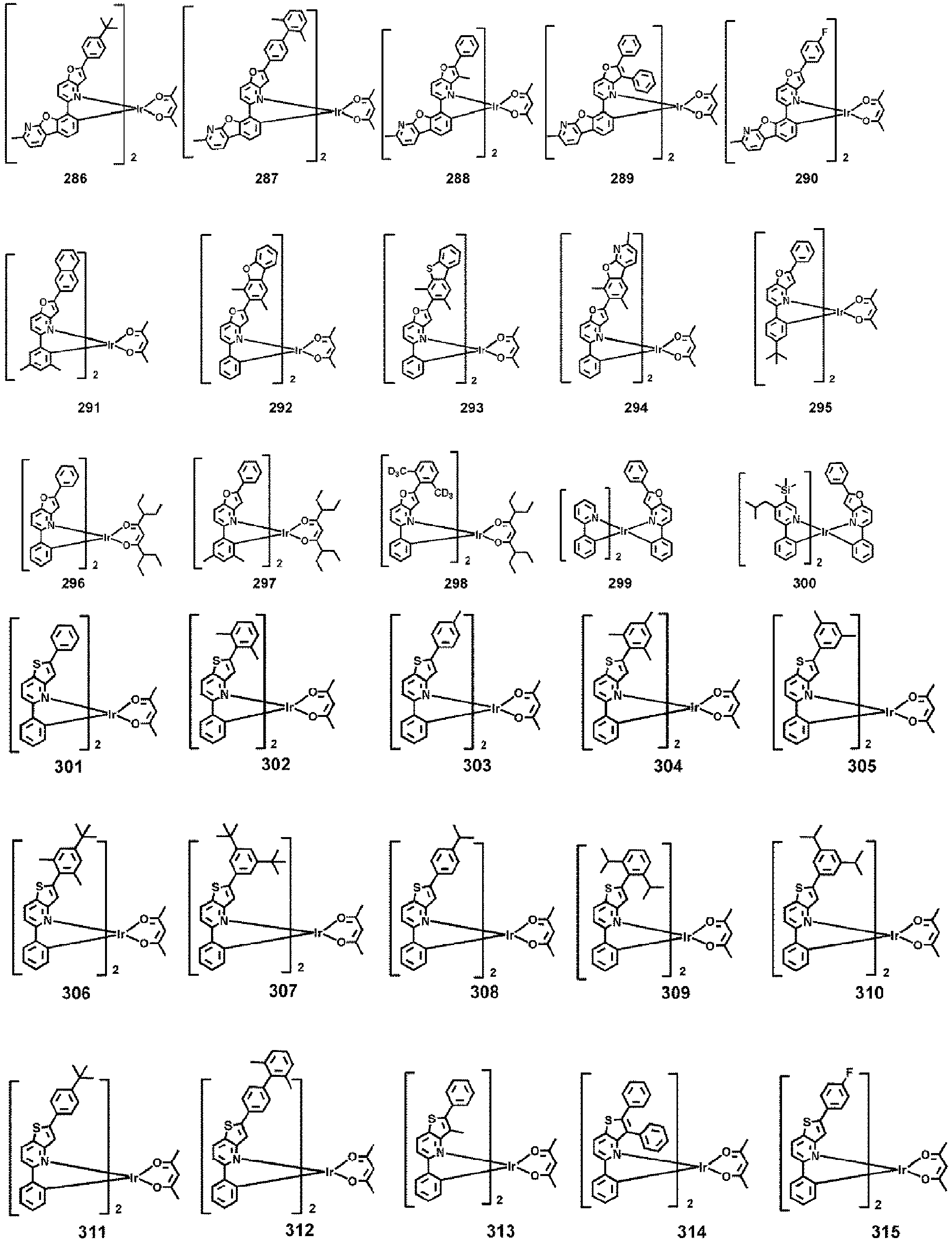

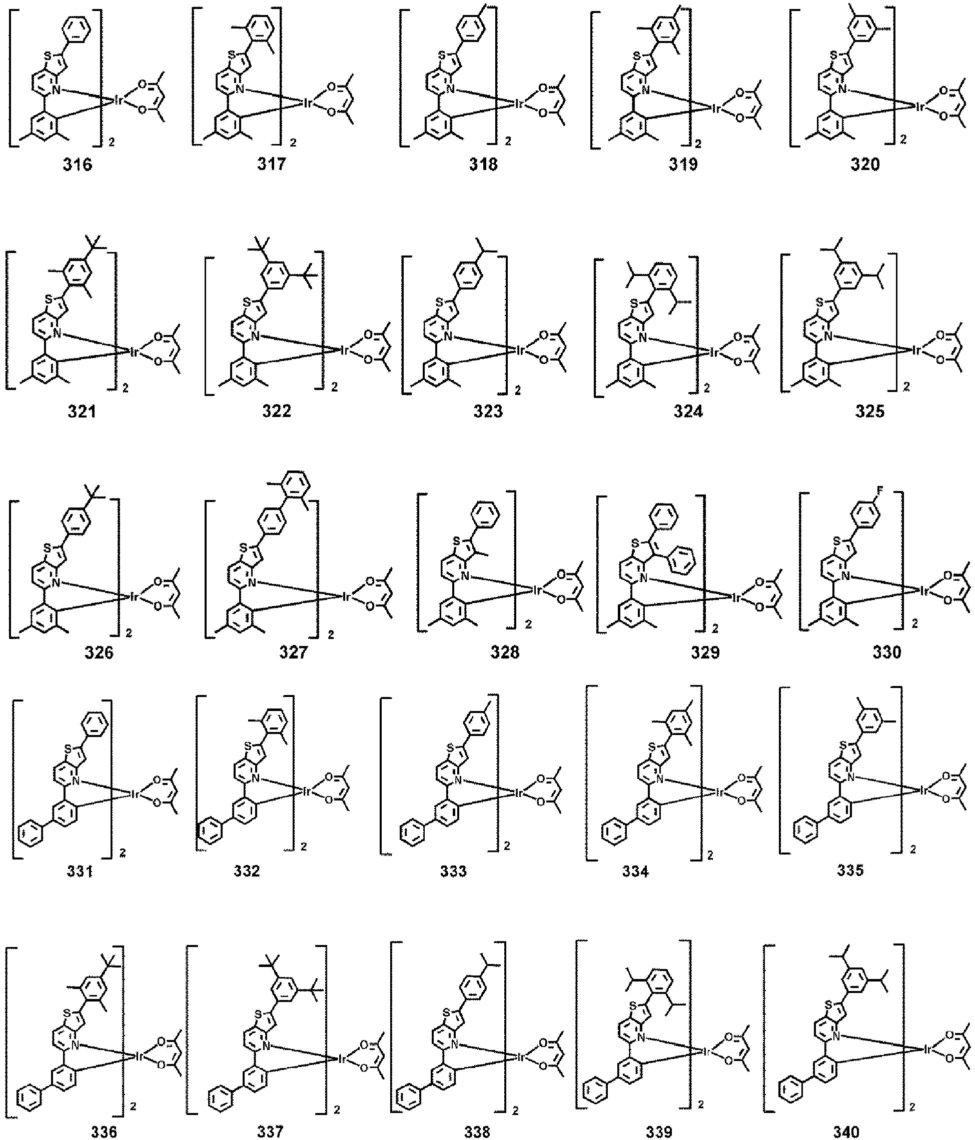

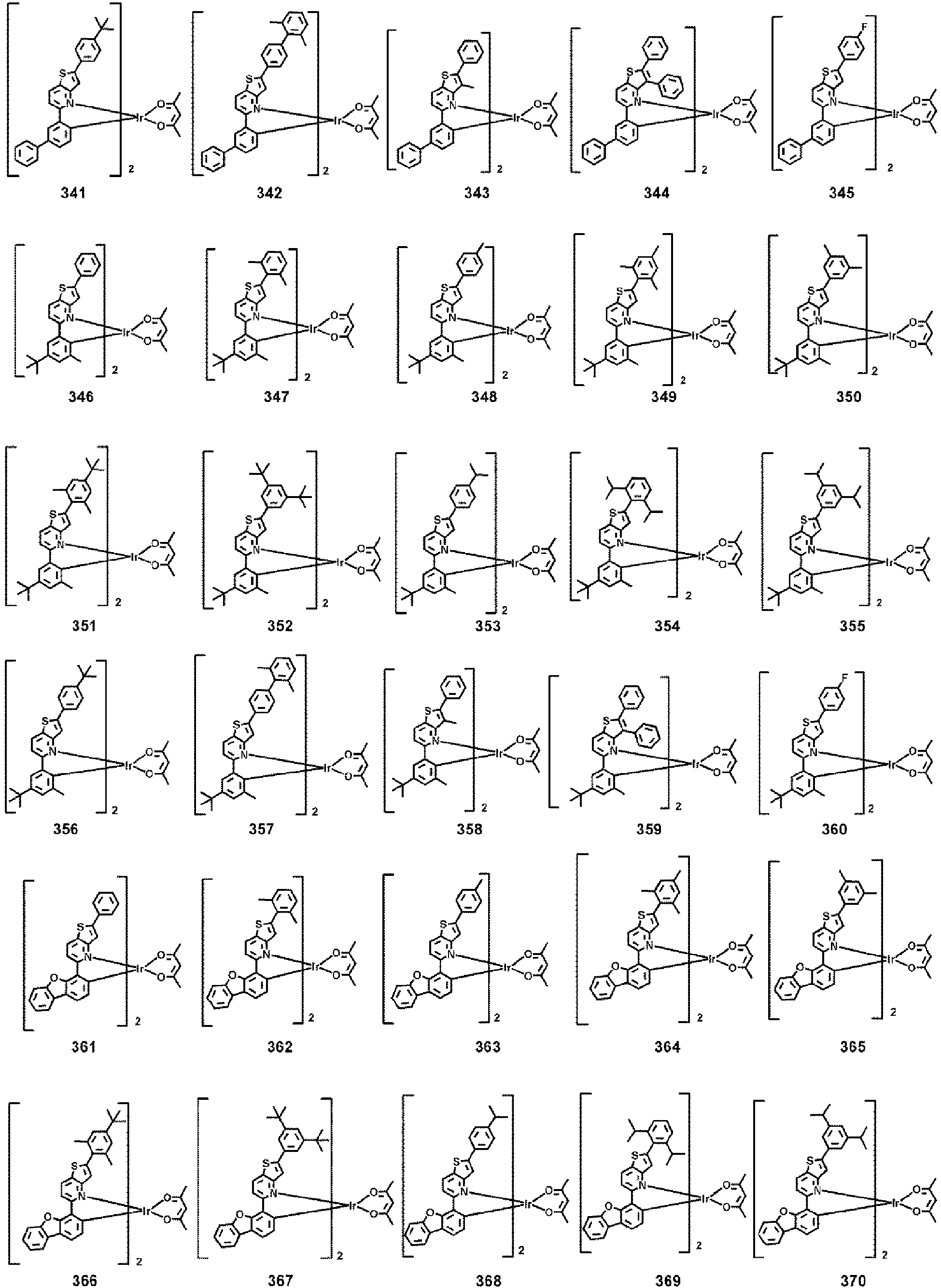

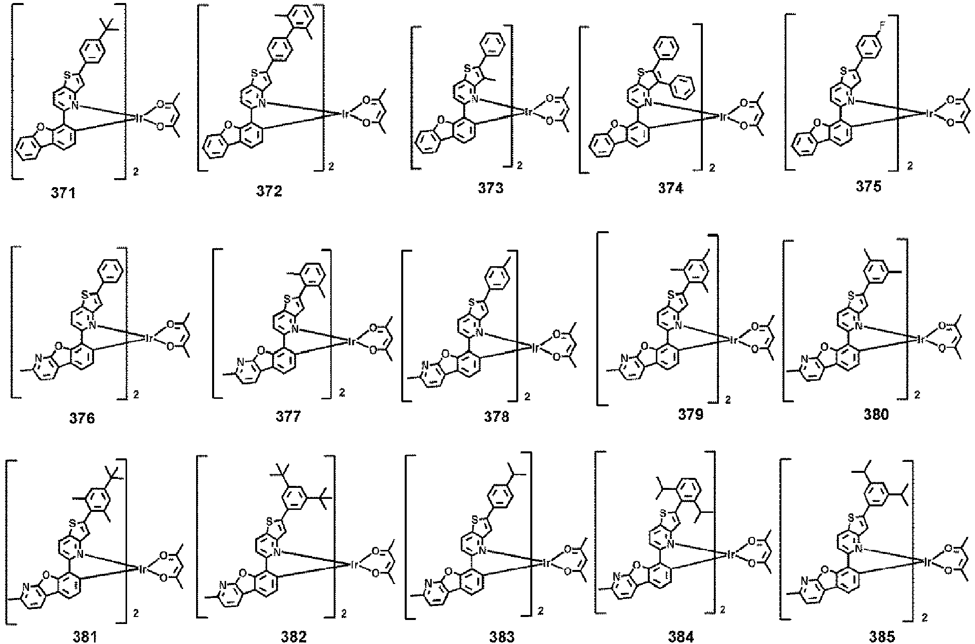

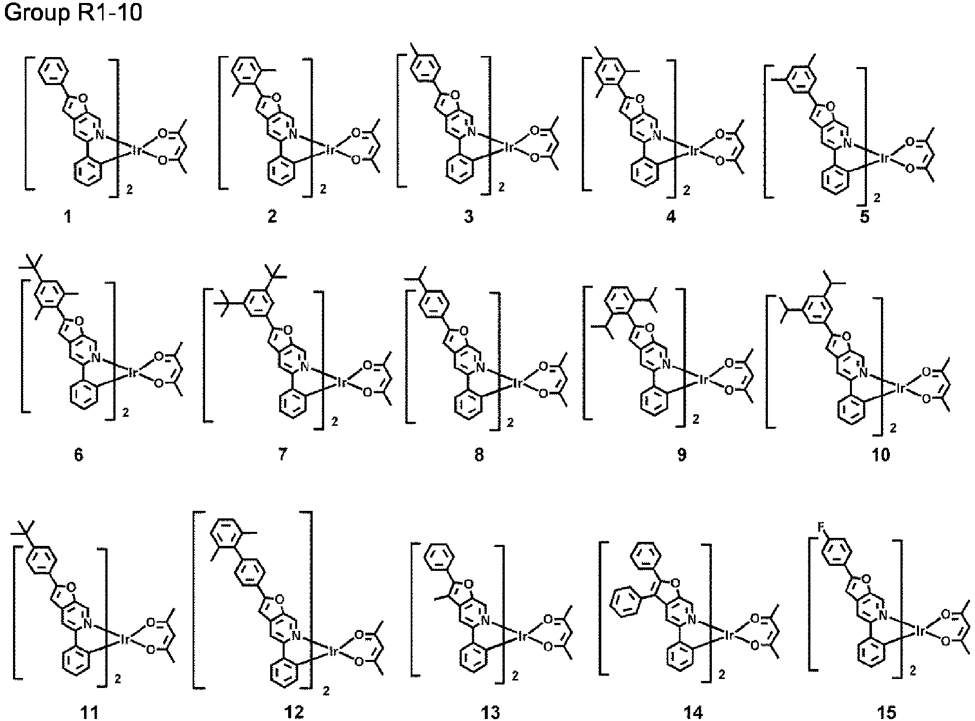

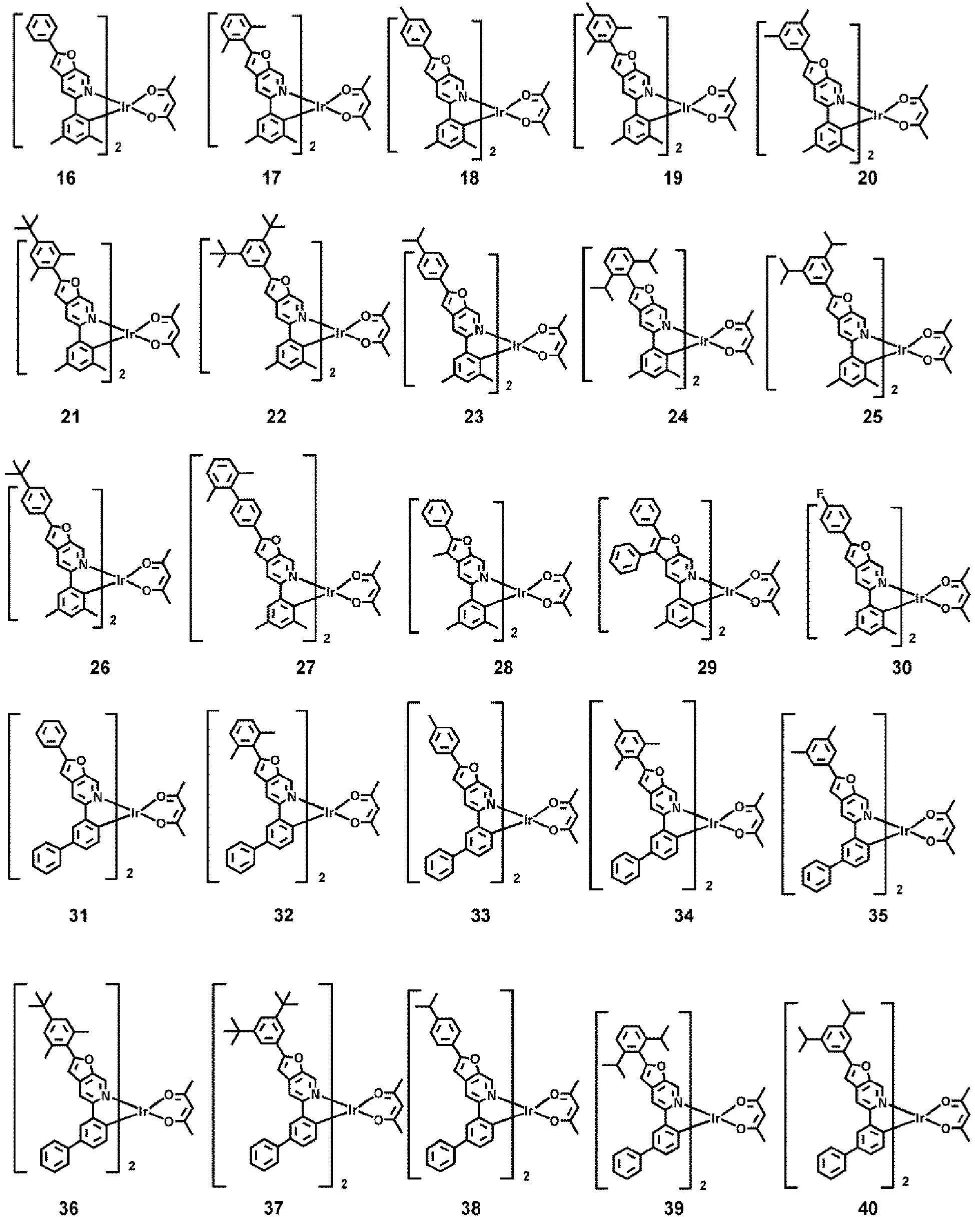

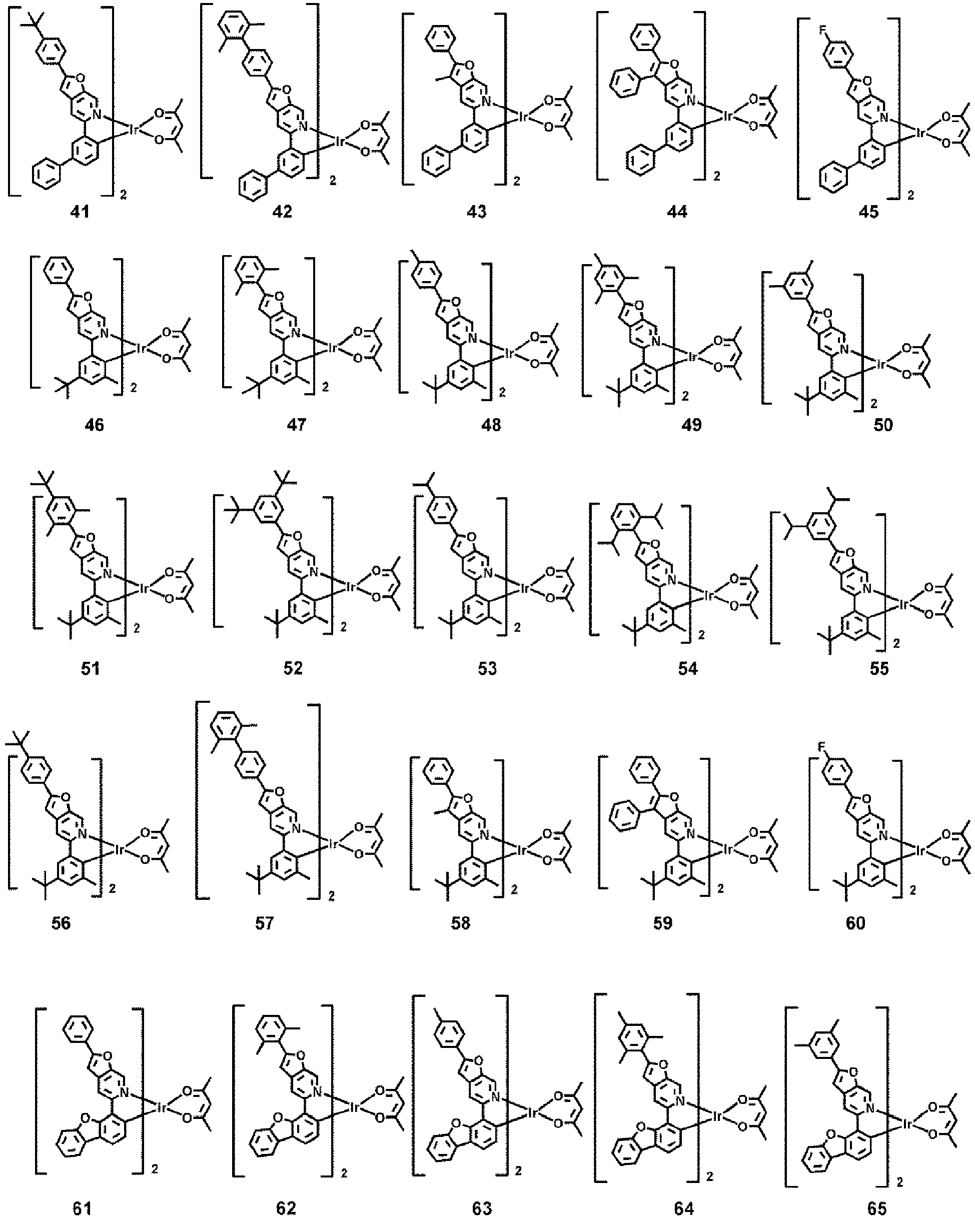

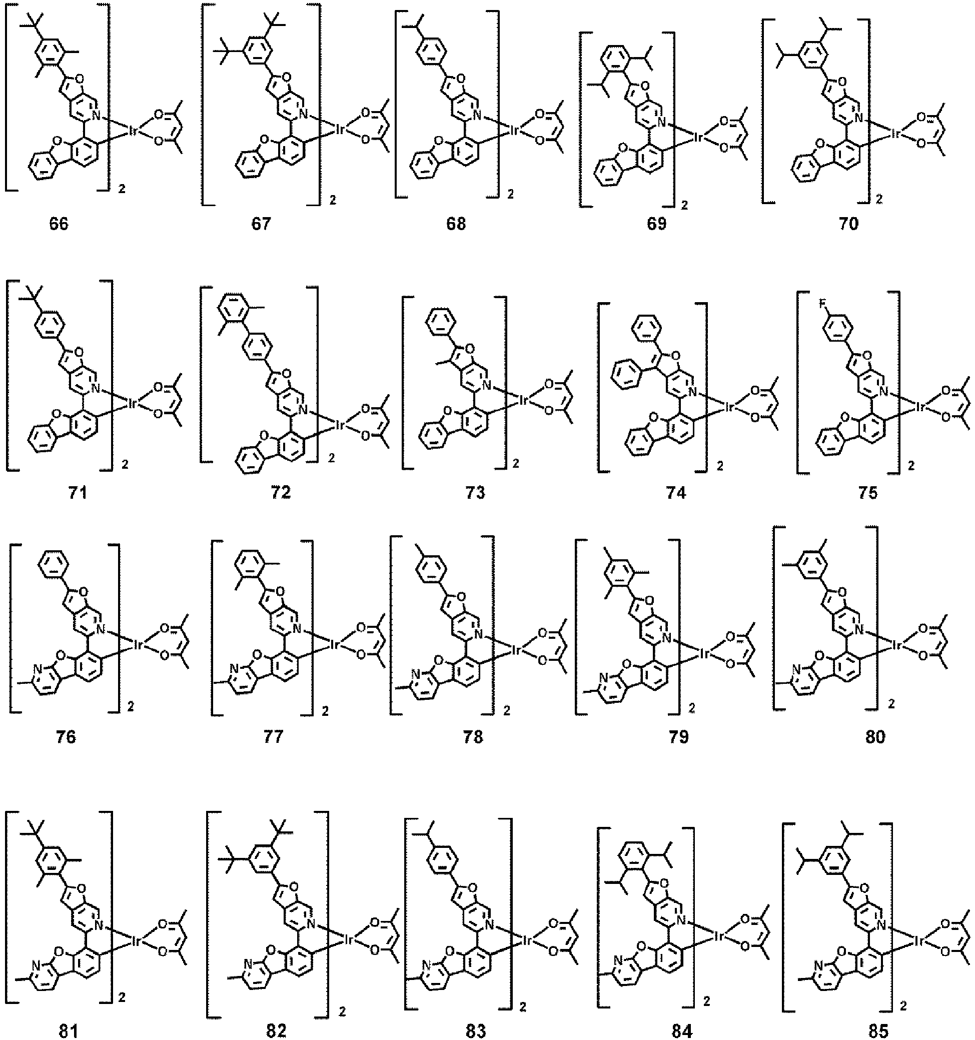

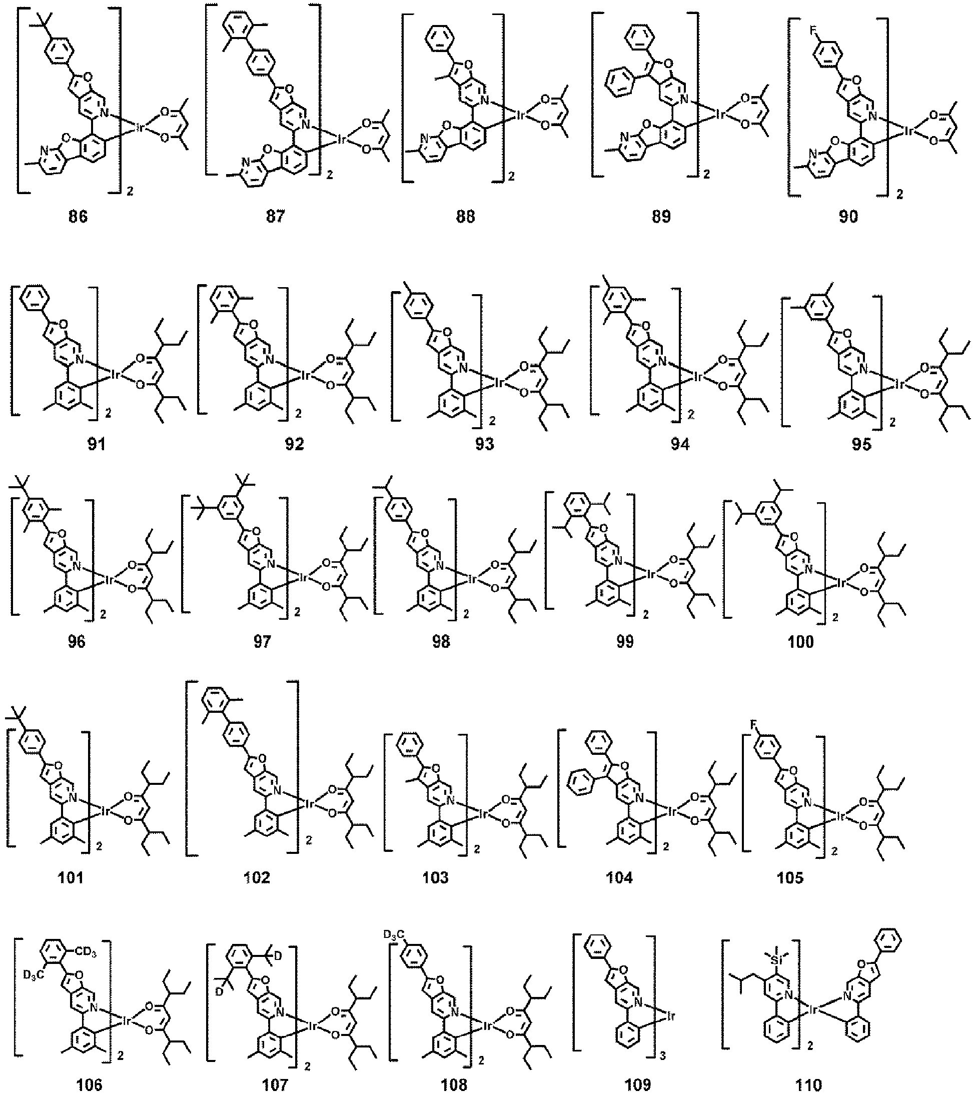

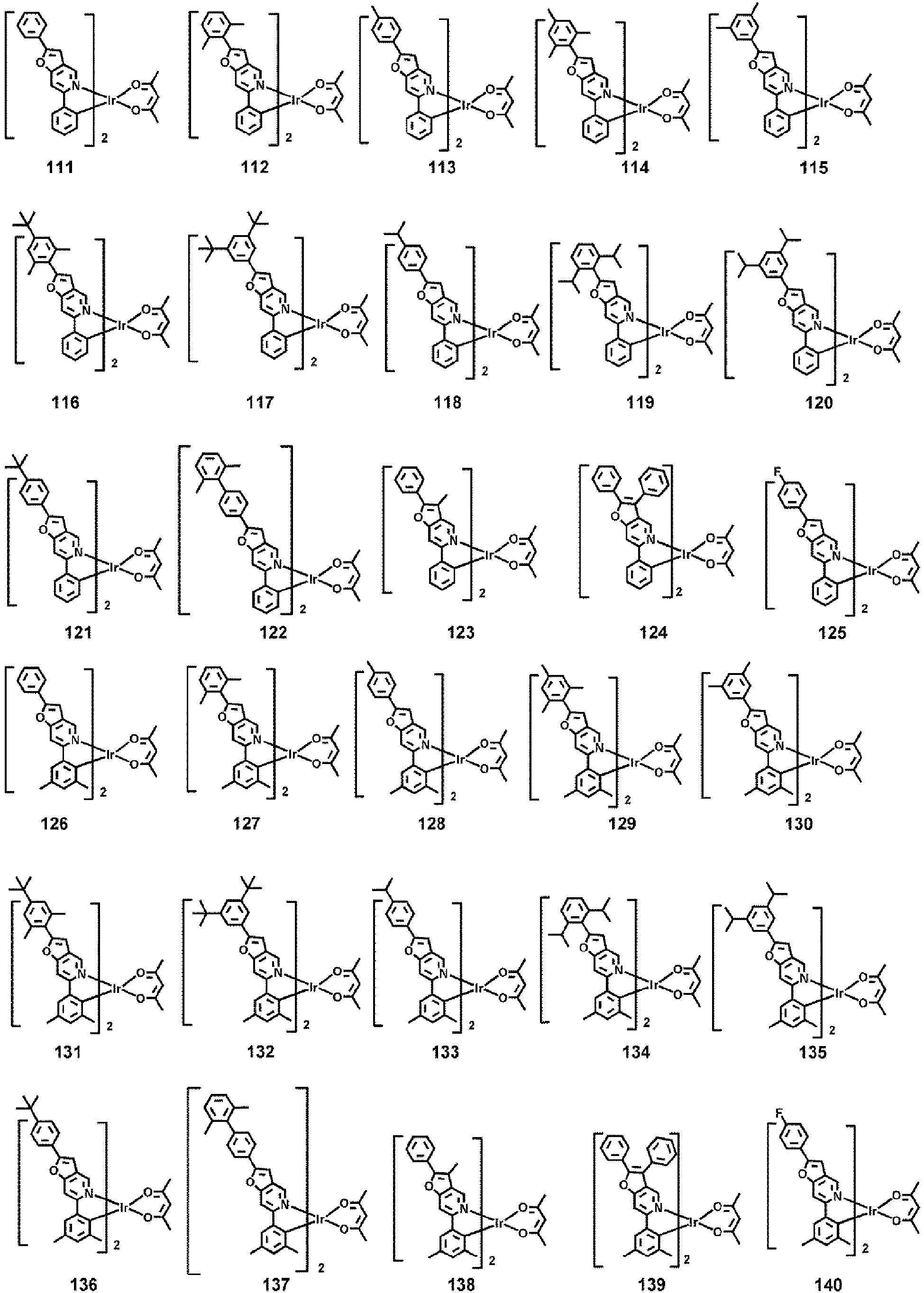

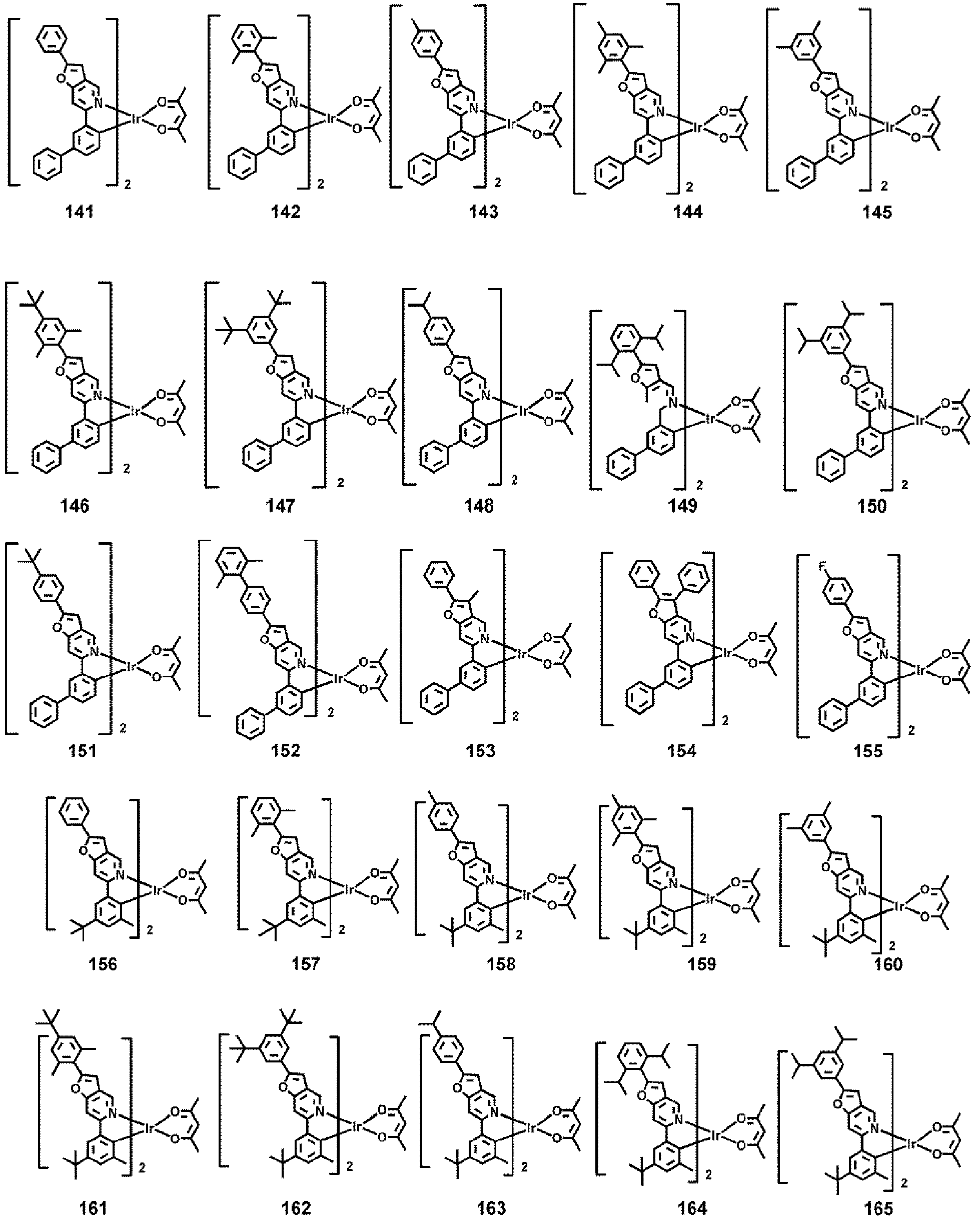

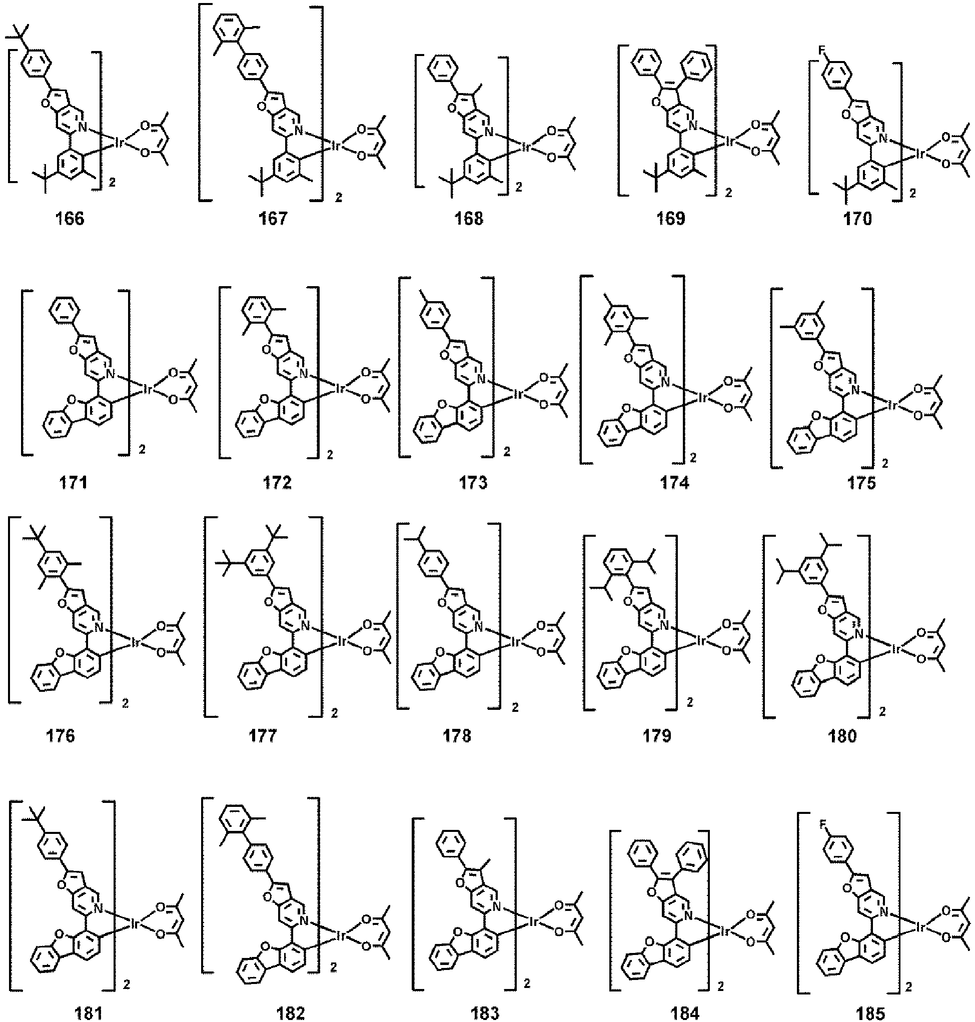

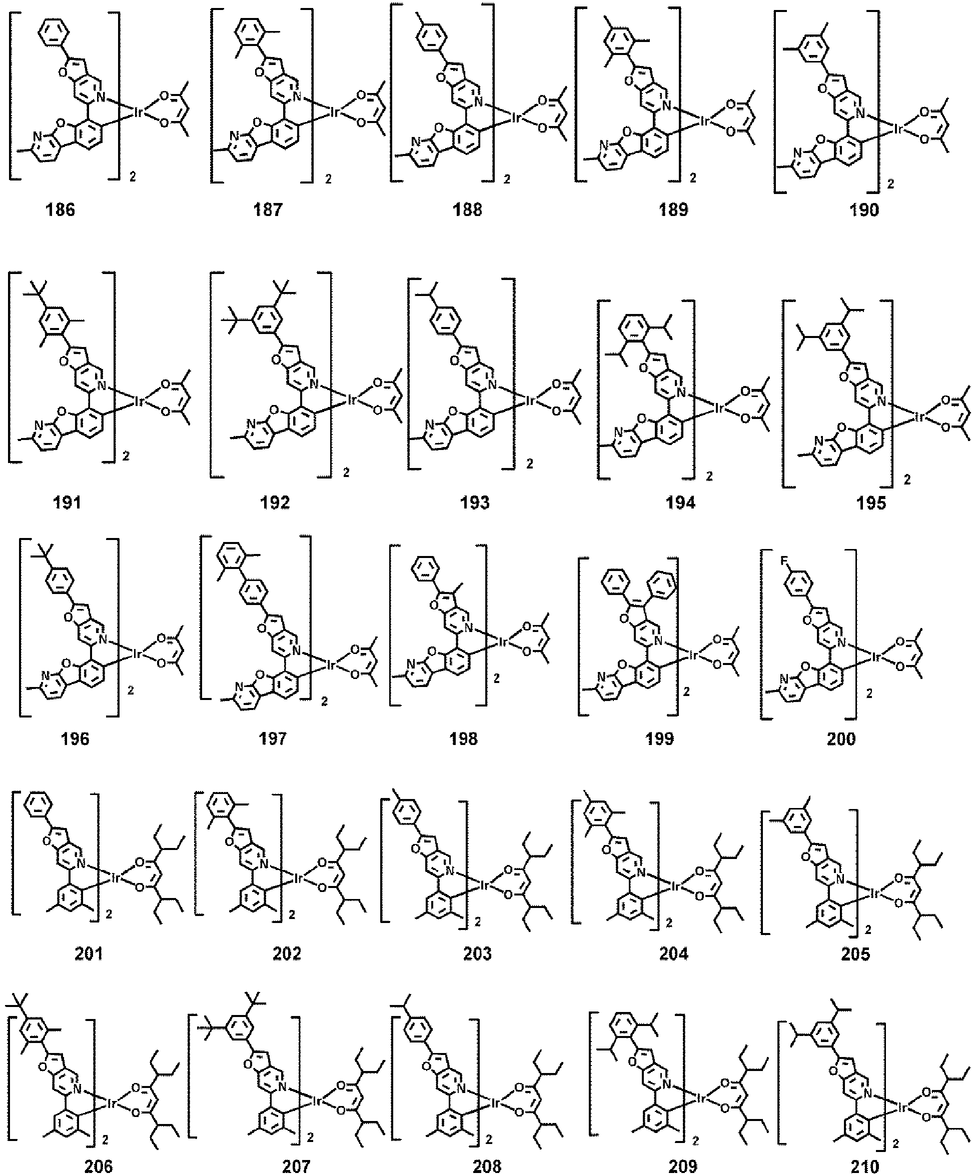

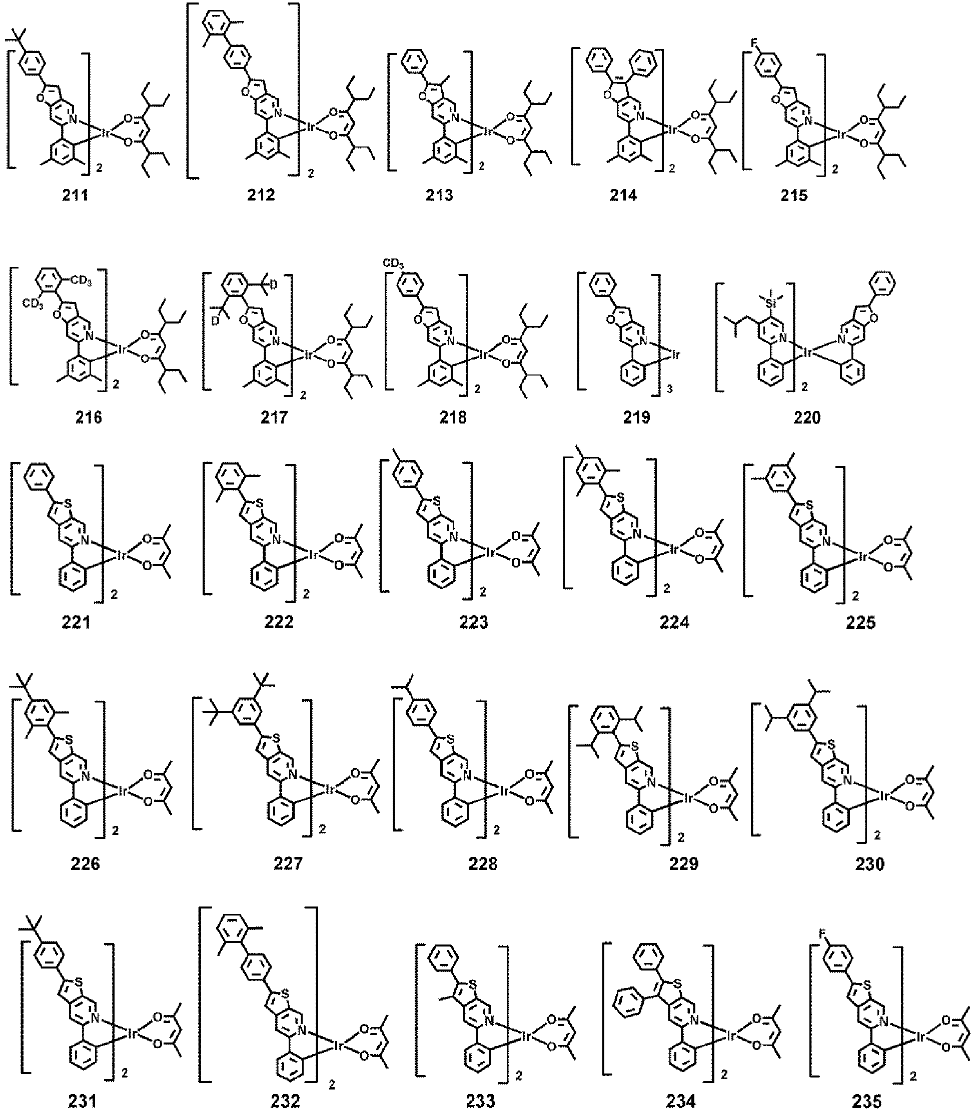

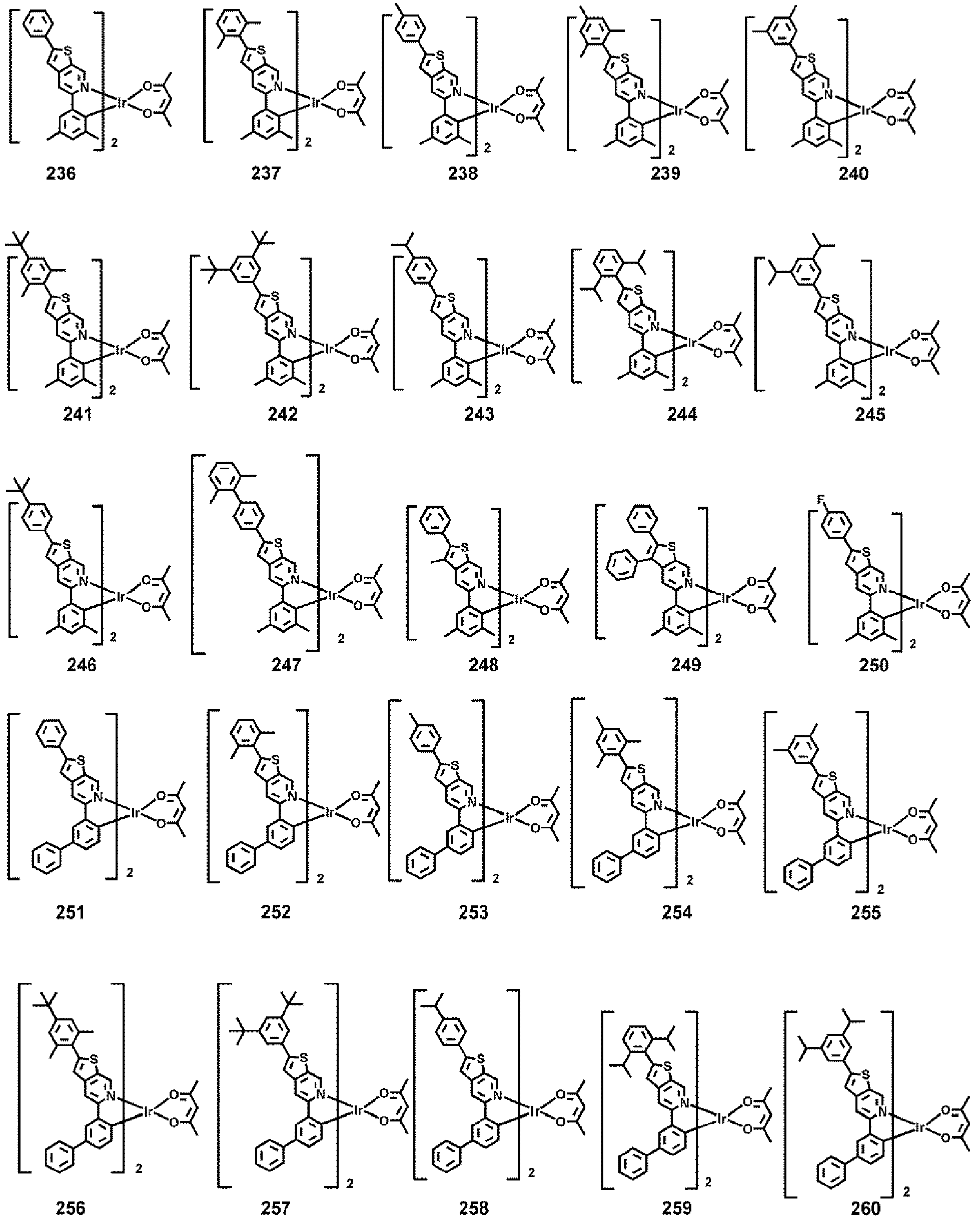

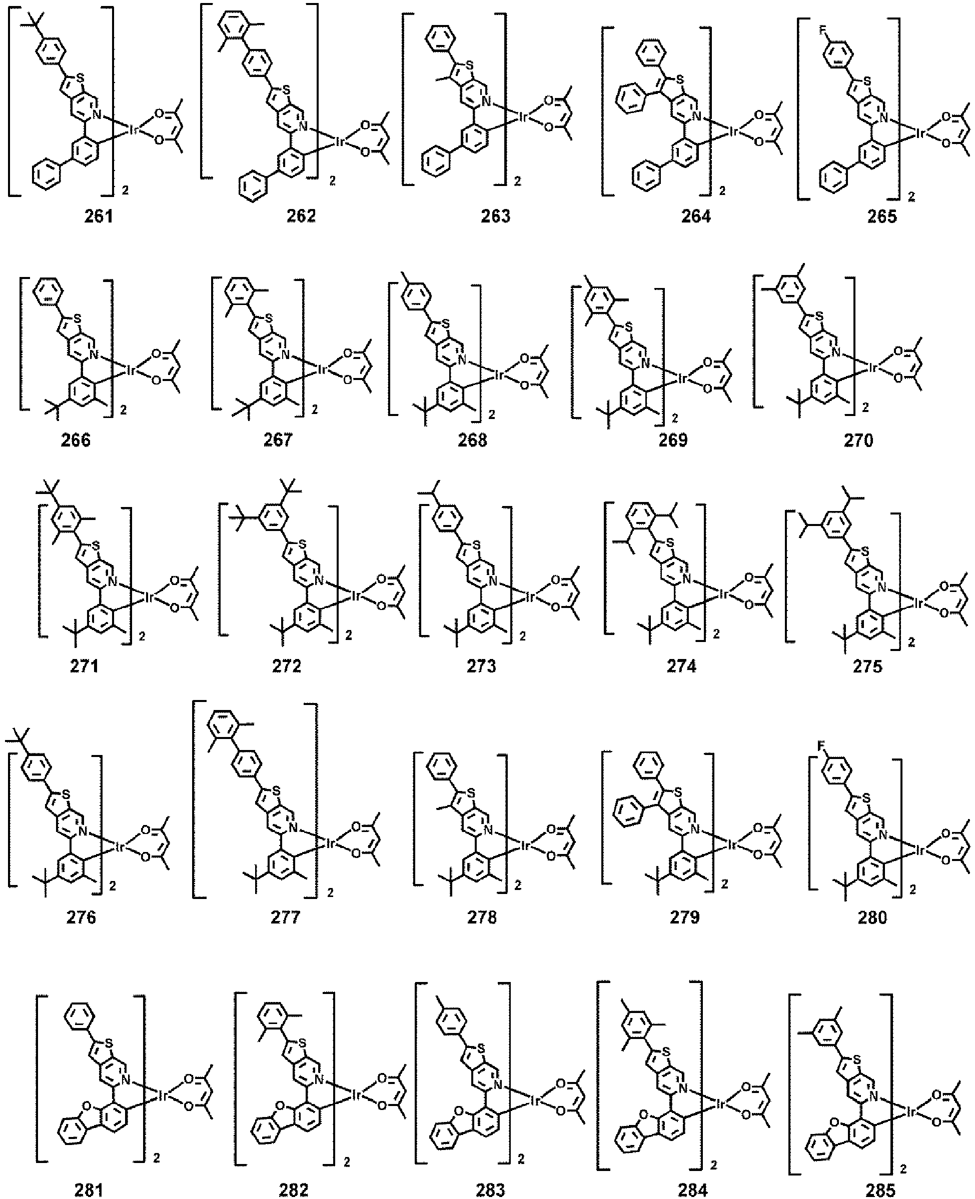

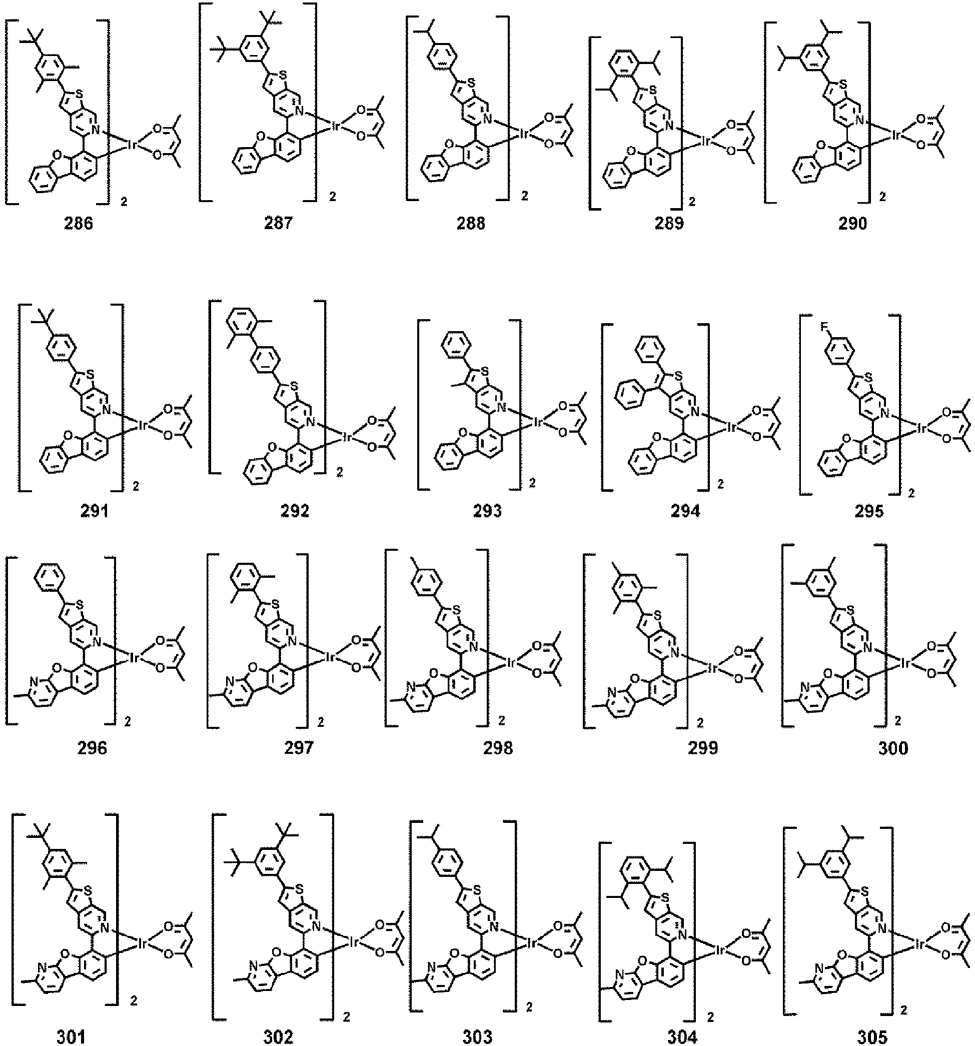

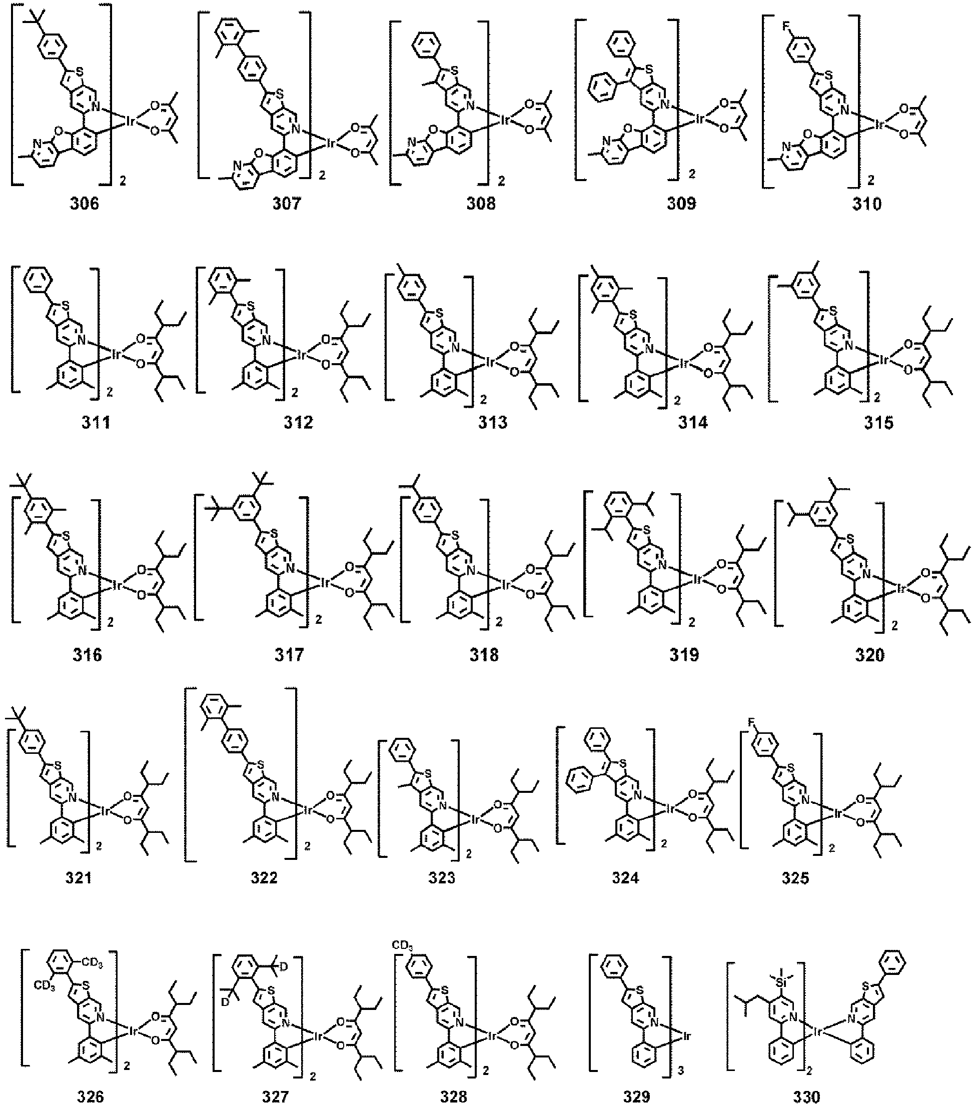

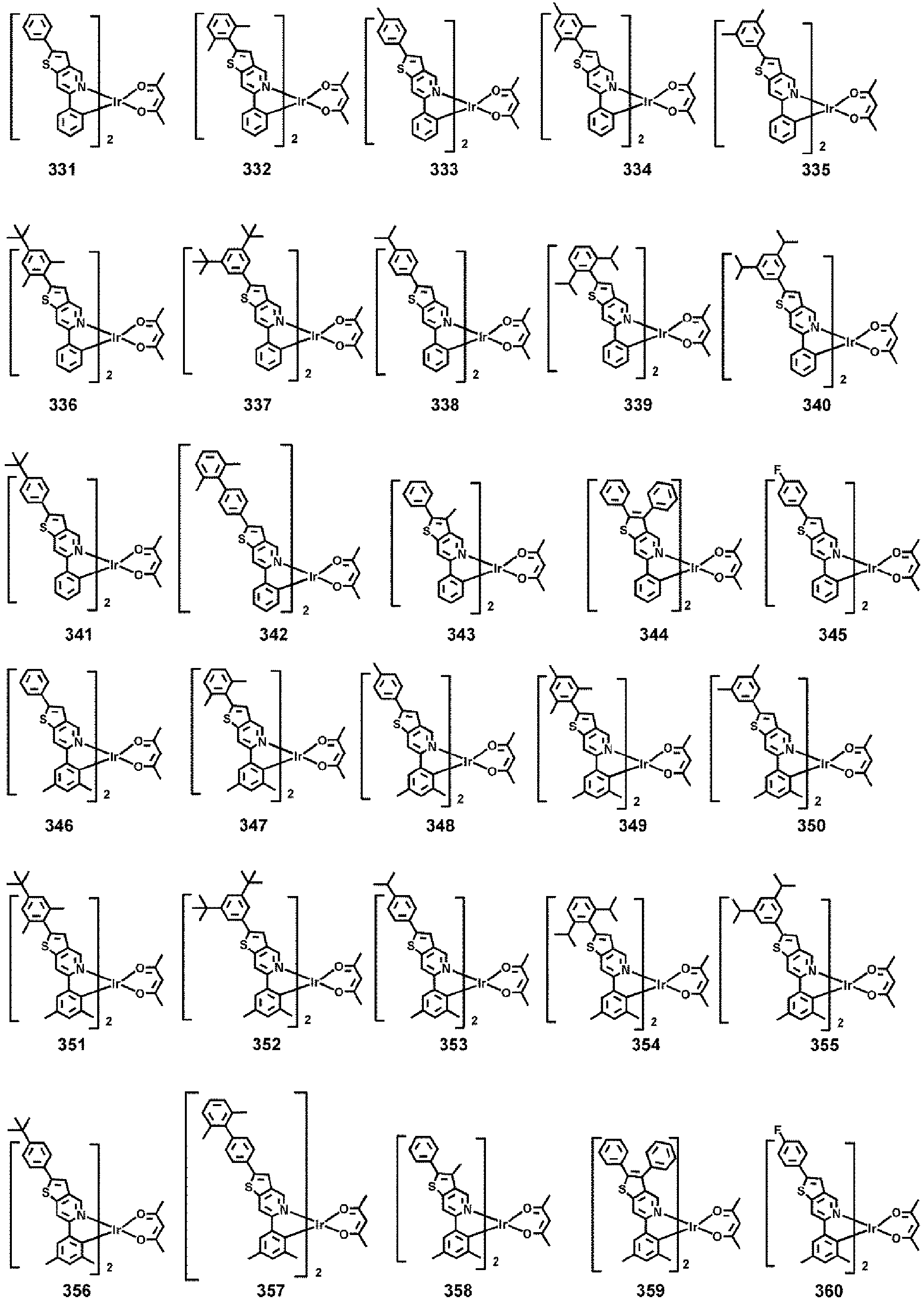

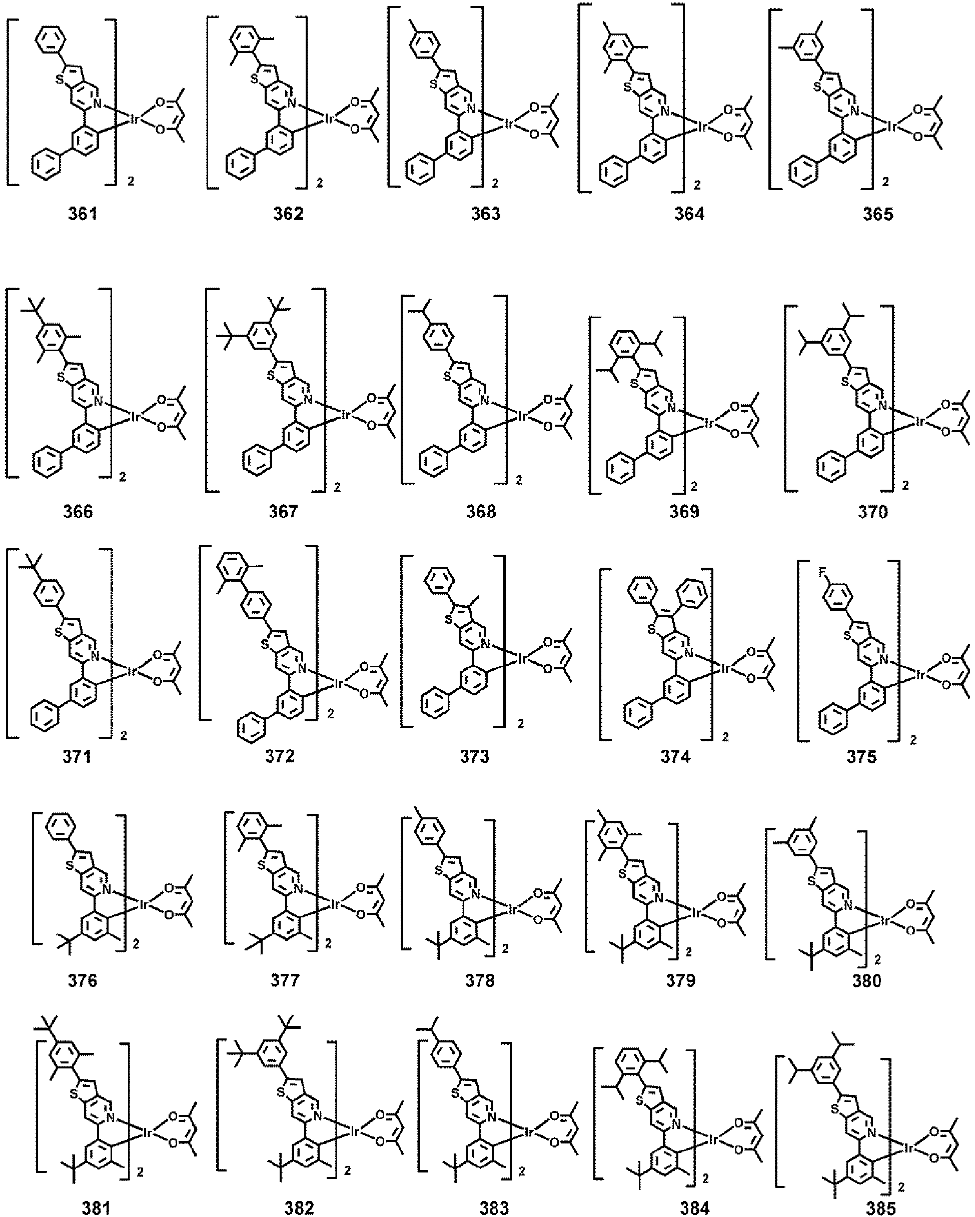

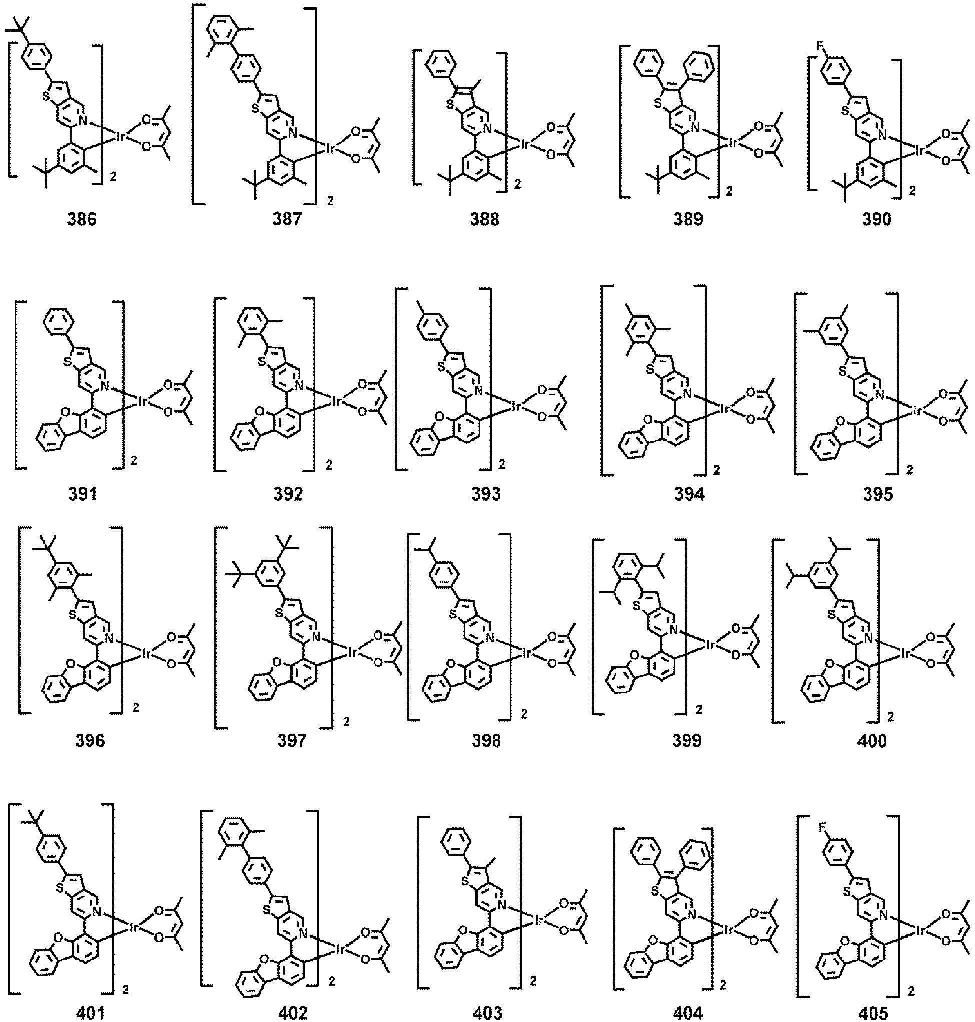

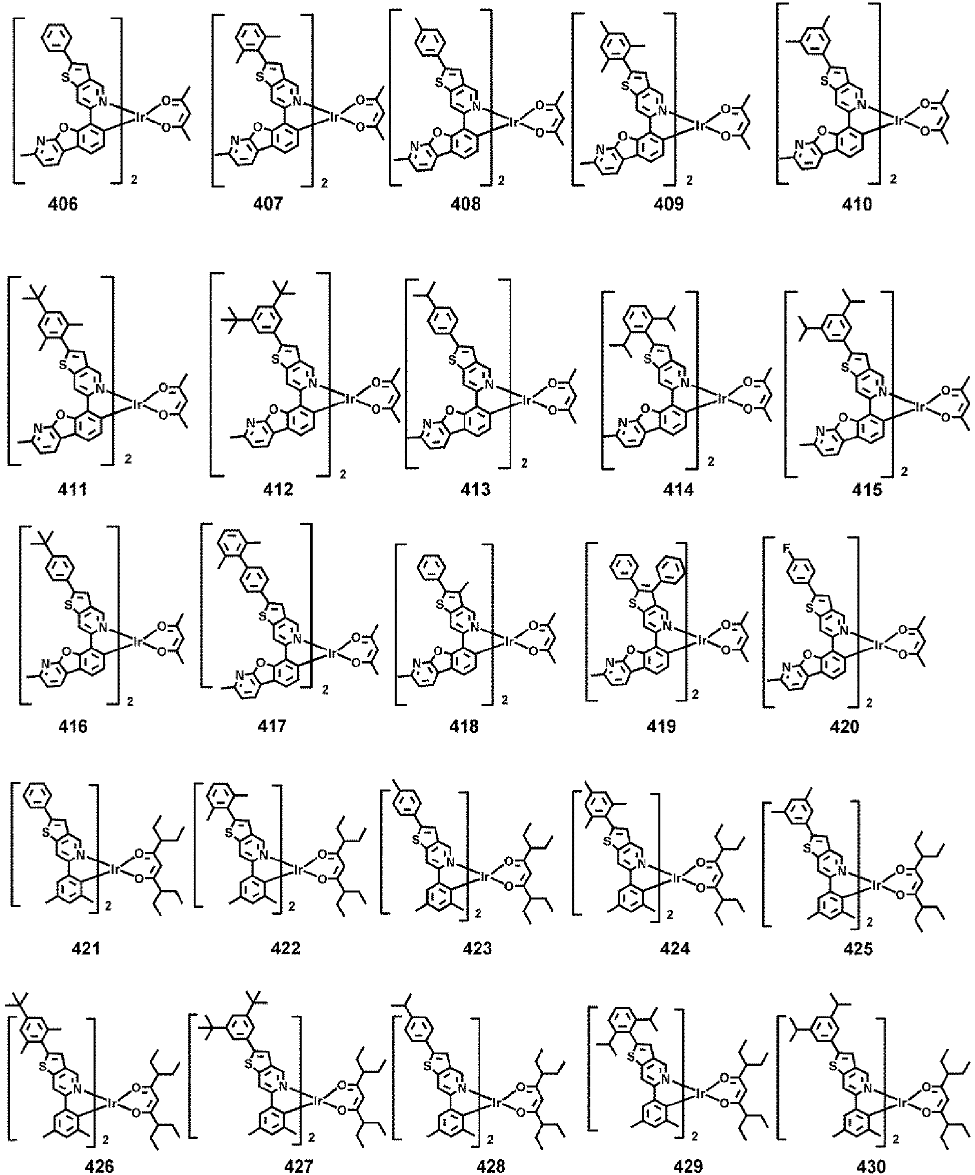

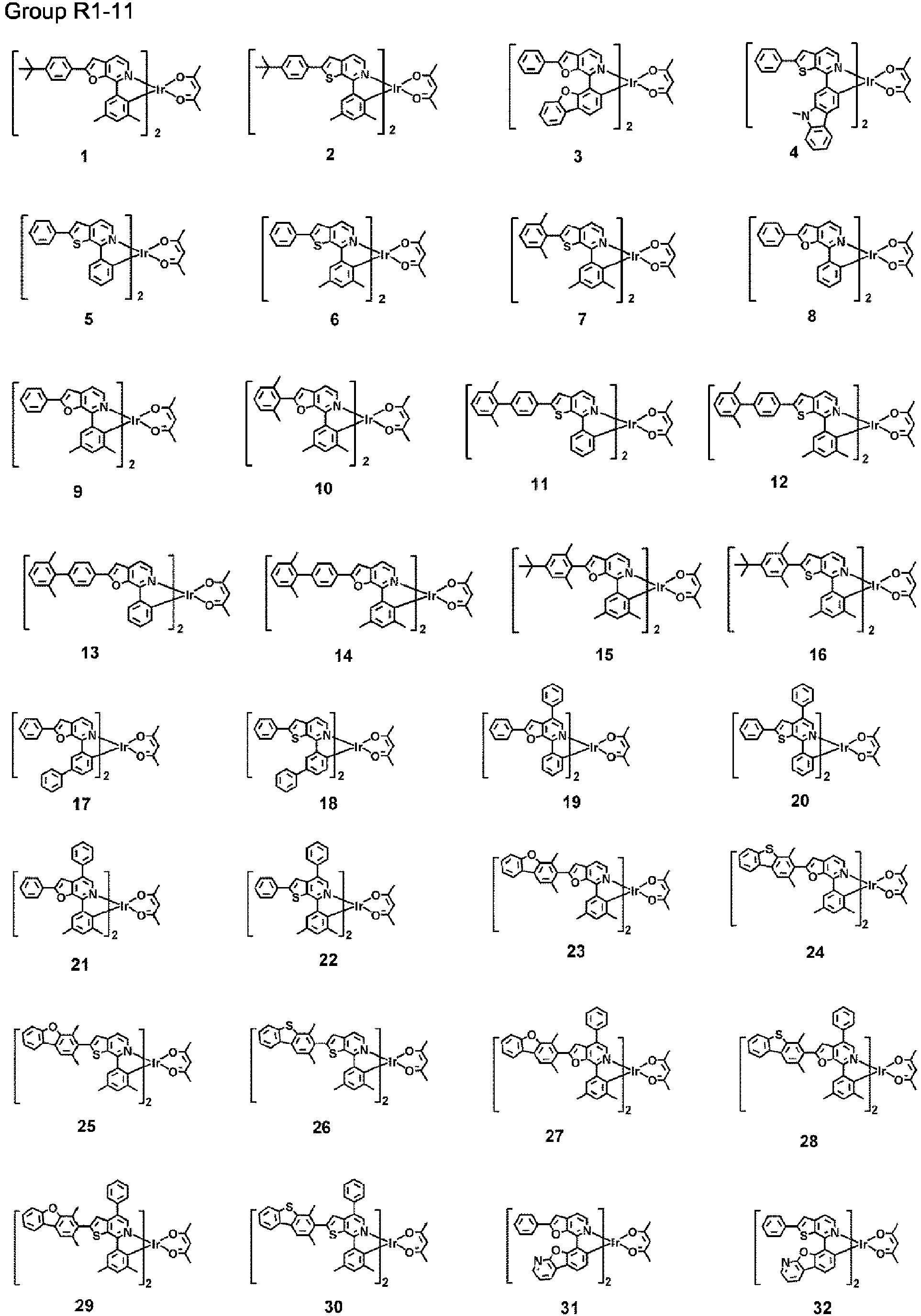

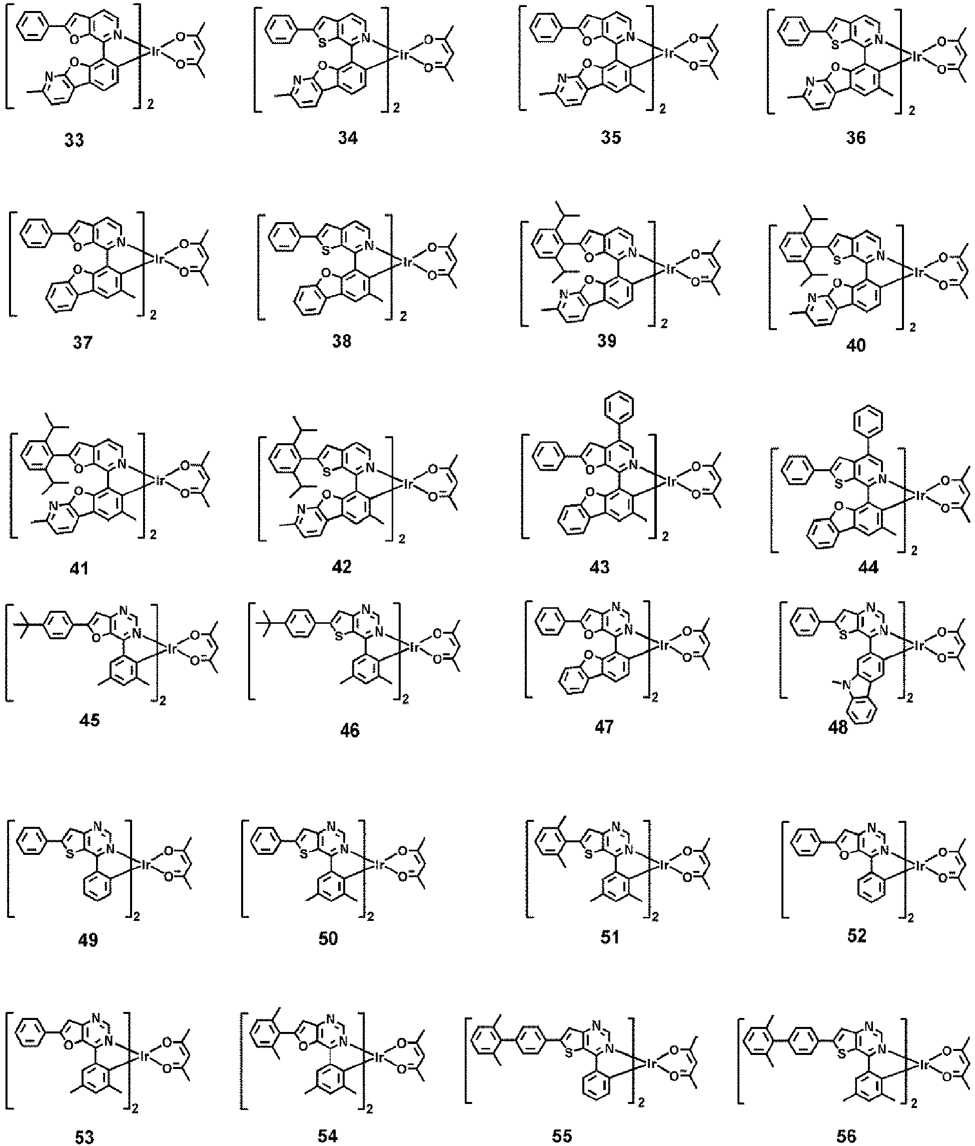

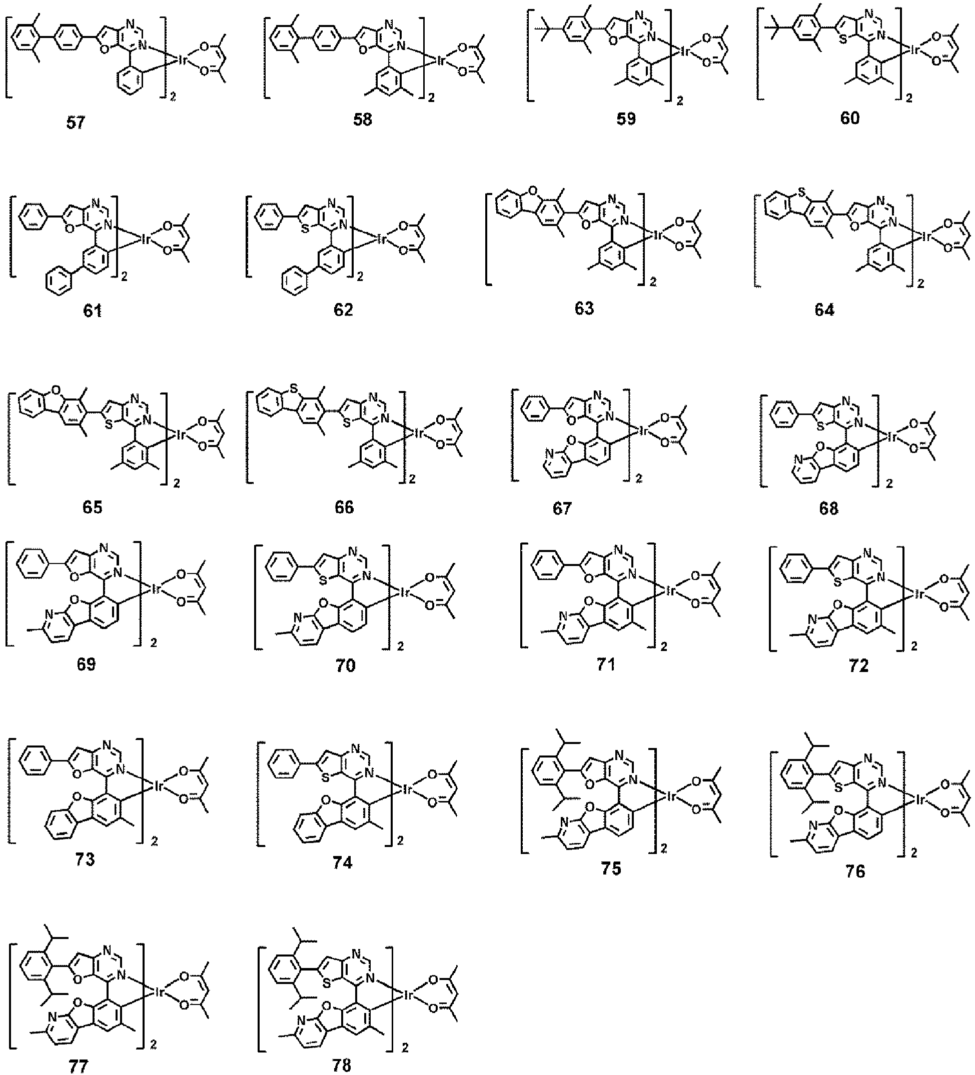

The composition including the first compound represented by Formula 1 and the second compound represented by Formula 2 can emit light having excellent luminescence efficiency and lifespan (for example, light having an emission maximum (peak) wavelength in the range of about 570 nm to about 650 nm, i.e., red light, etc.). Accordingly, a layer including the composition, a light-emitting device including the composition, and an electronic device including the light-emitting device may be provided.

Another aspect of the present disclosure provides a layer including the composition including the first compound and the second compound.

In one or more embodiments, the layer may emit light having an emission maximum (peak) wavelength in the range of about 570 nm to about 650 nm, for example, about 600 nm to about 650 nm.

In one or more embodiments, the layer may emit red light.

In one or more embodiments, a weight ratio of the first compound and the second compound included in the layer may be in a range of about 90:10 to about 10:90, about 80:20 to about 20:80, about 70:30 to about 30:70, or about 60:40 to about 40:60.

In one or more embodiments, the weight ratio of the first compound and the second compound included in the layer may be about 50:50, that is, 1:1.

In one or more embodiments, the layer may be formed by i) co-depositing the first compound and the second compound, or ii) using a first mixture including the first compound and the second compound.

In one or more embodiments, the layer may include a host and a dopant, wherein the host does not include a transition metal, and the dopant may include the composition including the first compound and the second compound. In one or more embodiments, the layer may be formed by i) co-depositing the host and the dopant, or ii) using a second mixture including the host and the dopant.

A weight of the host in the layer may be greater than a weight of the dopant.

For example, a weight ratio of the host and the dopant in the layer may be in a range of about 99:1 to about 55:45, about 97:3 to about 60:40, or about 95:5 to about 70:30.

The host in the layer may include a hole-transporting compound, an electron-transport compound, a bipolar compound, or a combination thereof.

Another aspect of the present disclosure provides a light-emitting device including: a first electrode; a second electrode; and an organic layer arranged between the first electrode and the second electrode and including an emission layer, wherein the organic layer includes the composition including the first compound and the second compound.

The light-emitting device may have excellent driving voltage, excellent external quantum efficiency, and excellent lifetime characteristics by including the composition including the first compound and the second compound as described above. Also, the light-emitting device may have an excellent side luminance ratio.

In one or more embodiments, the emission layer included in the organic layer of the light-emitting device may include the composition including the first compound and the second compound.

In one or more embodiments, the emission layer may include a host and a dopant, wherein the host may not include a transition metal, and the dopant may include the composition.

The host included in the emission layer may include a hole-transporting compound, an electron-transport compound, a bipolar compound, or a combination thereof.

For example, the host may include a hole-transporting compound and an electron-transporting compound, wherein the hole-transporting compound and the electron-transporting compound may be different from each other.

The emission layer may be formed by i) co-depositing the host and the dopant, or ii) using a second mixture including the host and the dopant.

The emission layer may emit third light having a third spectrum, and AP(EML) indicates an emission maximum (peak) wavelength (nm) in the third spectrum. For example, the AP(EML) may be evaluated from an electroluminescence spectrum of the light-emitting device.

The light-emitting device may emit fourth light having a fourth spectrum and extracted to the outside of the light-emitting device through the first electrode and/or the second electrode of the light-emitting device, and λP(OLED) indicates an emission maximum (peak) wavelength (nm) in the fourth spectrum. For example, the AP(OLED) may be evaluated from an electroluminescence spectrum of the light-emitting device.

In one or more embodiments, the AP(EML) and the AP(OLED) may each independently be about 570 nm to about 650 nm, for example, about 600 nm to about 650 nm.

In one or more embodiments, the third light and the fourth light may each be red light.

In one or more embodiments, each of the third light and the fourth light may not be white light.

In one or more embodiments, regarding the third spectrum, i) a main emission peak having the λP(EML) may be included; but ii) an additional emission peak having an emission maximum (peak) wavelength of λP(EML) + 50 nm or more or λP(EML) - 50 nm or less may not be included.

In one or more embodiments, the third spectrum may include i) a main emission peak having the AP(EML), and may not include ii) an additional emission peak having an emission maximum (peak) wavelength of green light and/or blue light region.

In one or more embodiments, regarding the fourth spectrum, i) a main emission peak having the λP(OLED) may be included; but ii) an additional emission peak having an emission maximum (peak) wavelength of AP(OLED) + 50 nm or more or AP(OLED) - 50 nm or less may not be included.

In one or more embodiments, the fourth spectrum may include i) a main emission peak having the AP(EML), and may not include ii) an additional emission peak having an emission maximum (peak) wavelength of green light and/or blue light region.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the light-emitting device, the first electrode may be an anode, and the second electrode may be a cathode, and the organic layer may further include a hole transport region arranged (located) between the first electrode and the emission layer and an electron transport region arranged (located) between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer or a plurality of layers arranged between the first electrode and the second electrode of the light-emitting device. The "organic layer" may include, in addition to an organic compound, an organometallic complex including a metal.

The FIGURE is a schematic cross-sectional view of a light-emitting device 10 according to one or more embodiments. Hereinafter, a structure and a manufacturing method of a light-emitting device according to one or more embodiments of the present disclosure will be described in connection with the FIGURE. The light-emitting device 10 includes a first electrode 11, an organic layer 15, and a second electrode 19, which are sequentially stacked.

A substrate may be additionally located under or beneath the first electrode 11 or above or on the second electrode 19. For use as the substrate, any substrate that is used in light-emitting devices of the related art may be used, and the substrate may be a glass substrate or a transparent plastic substrate, each having excellent mechanical strength, thermal stability, transparency, surface smoothness, ease of handling, and/or water resistance.

In one or more embodiments, the first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 revolutions per minute (rpm) to about 5,000 rpm and a heat treatment temperature in a range of about 80°C to about 200°C for removing a solvent after coating.

The conditions for forming the hole transport layer and the electron blocking layer may be the same as the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalene-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

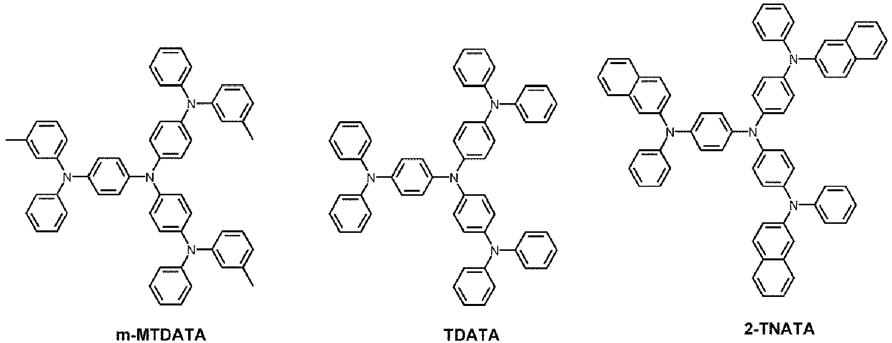

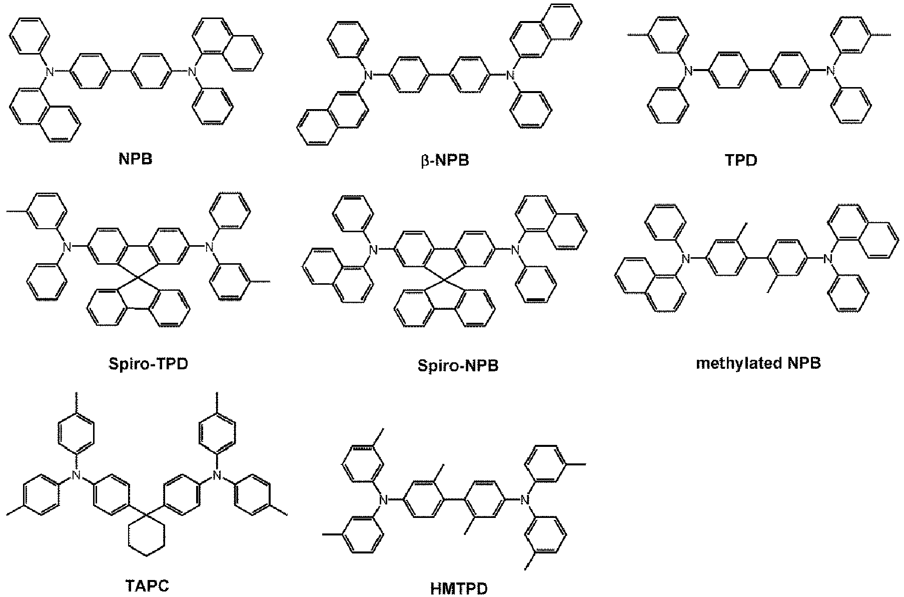

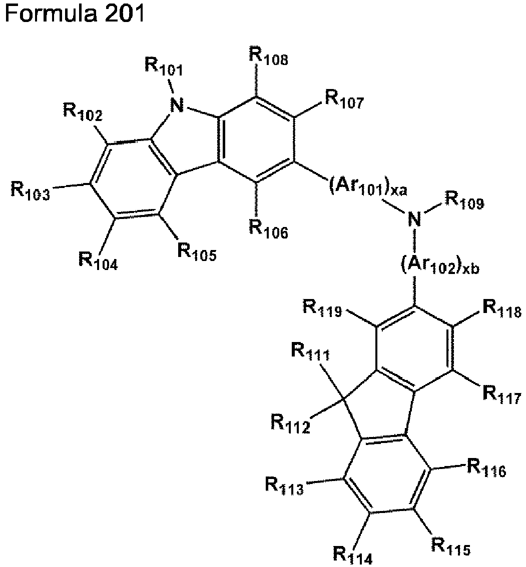

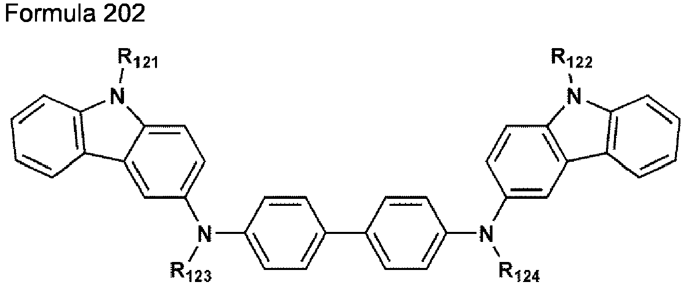

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -CI, -Br, -I, - SF₅, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉ and R₁₂₁ to R₁₂₄ in Formulae 201 and 202 may each independently be:
hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -CI, -Br, -I, -SF₅, a hydroxyl group, a cyano group, a nitro group, an amino group, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each substituted or unsubstituted with at least one of deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₁₀ alkylthio group, a phenyl group, a naphthyl group, an anthracenyl group, a pyridinyl group, or a combination thereof.

In one embodiment, the compound represented by Formula 201 may be represented by Formula 201A:

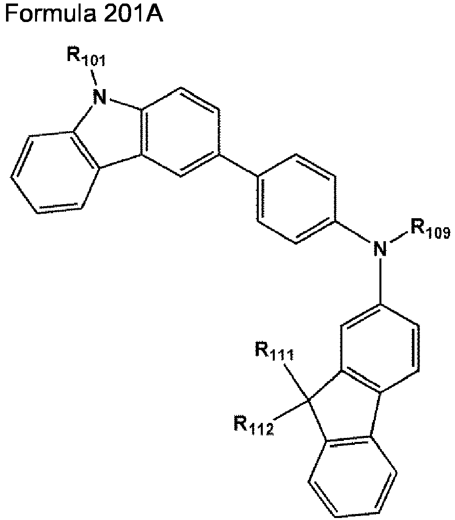

R₁₀₁, R₁₁₁, R₁₁₂, and R₁₀₉ in Formula 201A are each as described in the present specification.

For example, the hole transport region may include one of Compounds HT1 to HT20 or a combination thereof:

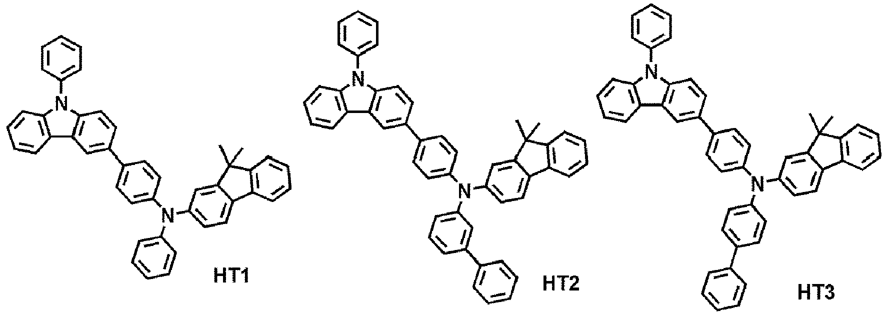

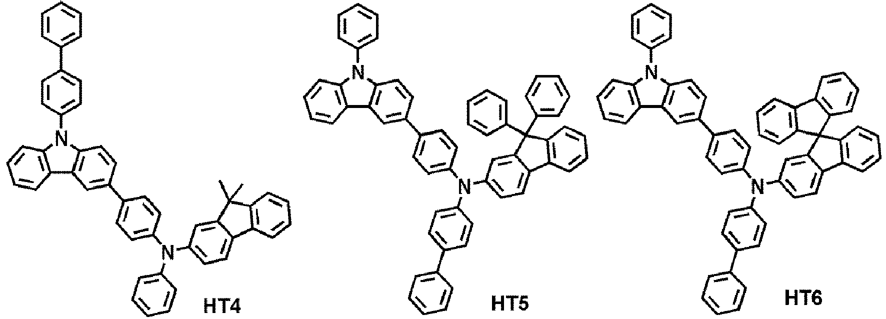

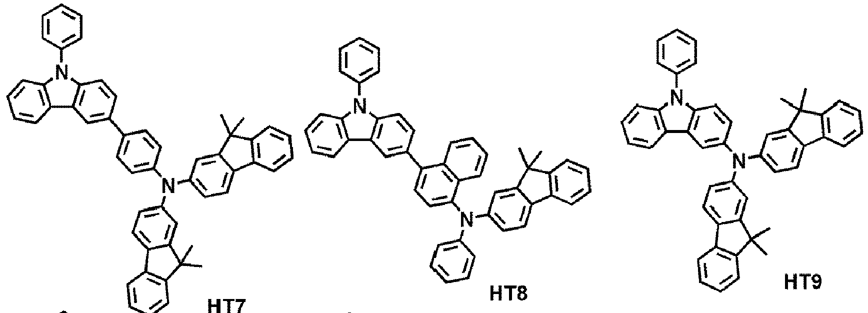

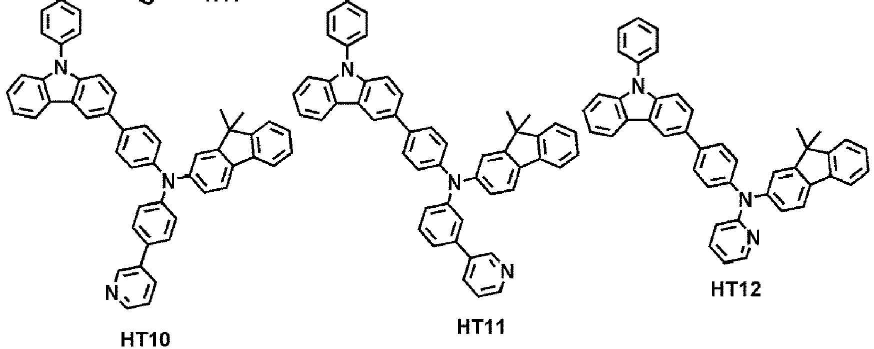

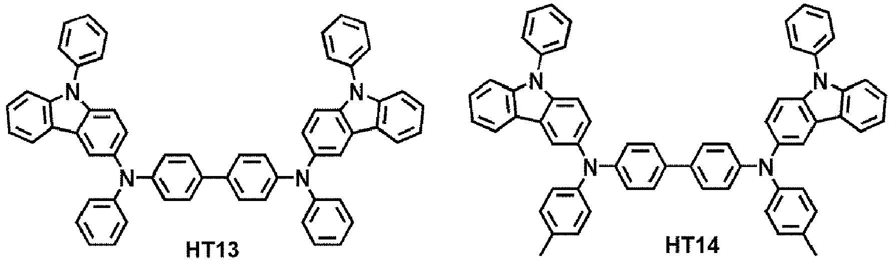

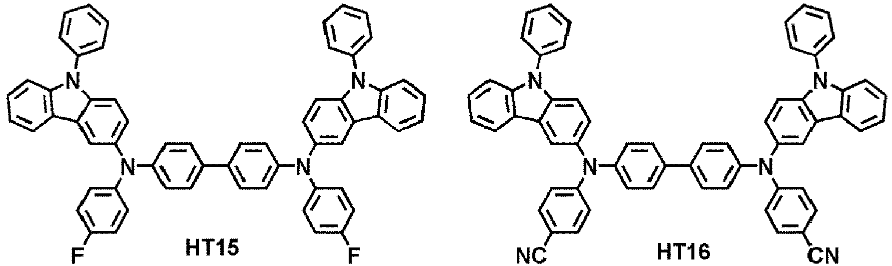

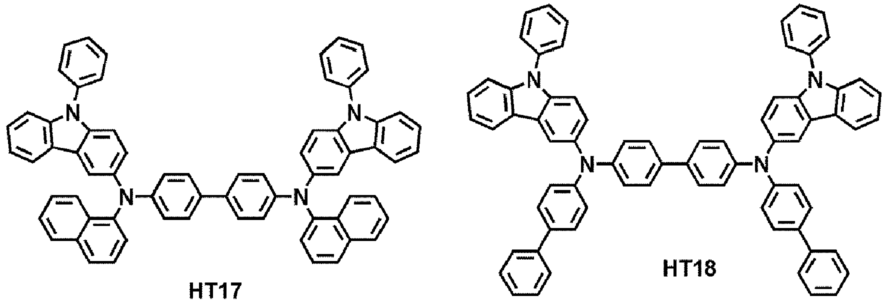

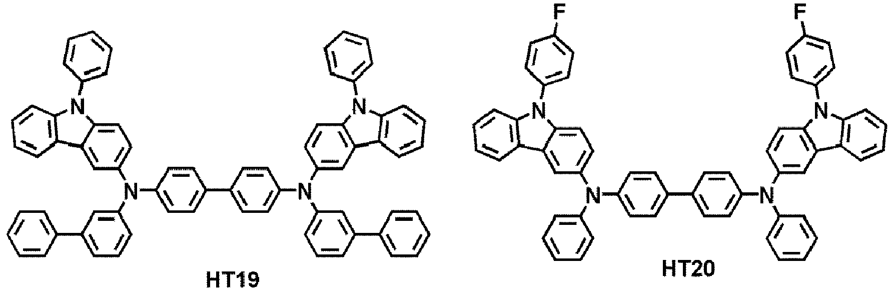

A thickness of the hole transport region may be in the range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may be: a quinone derivative such as tetracyanoquinodimethane (TCNQ), 2,3,5,6-tetrafluoro-tetracyano-1,4-benzoquinonedimethane (F4-TCNQ), or F6-TCNNQ; a metal oxide, such as tungsten oxide or molybdenum oxide; a cyano group-containing compound, such as Compound HT-D1; or a combination thereof:

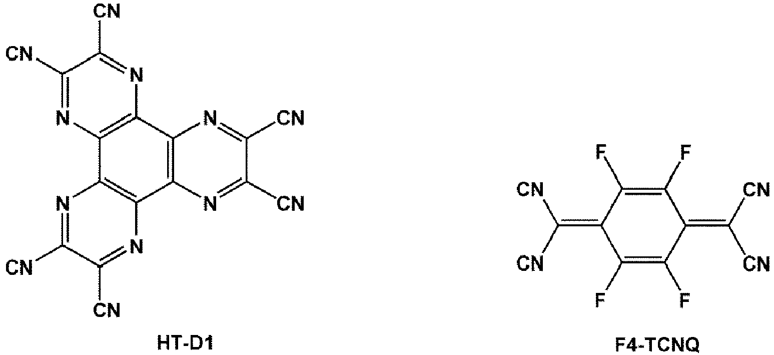

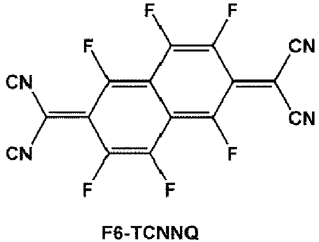

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for forming the electron blocking layer may include a material that is used in the hole transport region as described herein, a host material as described herein, or a combination thereof. For example, when the hole transport region includes an electron blocking layer, the material for forming the electron blocking layer may include mCP as described herein, Compound H-H1 as described herein, or a combination thereof.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

In one or more embodiments, the emission layer may include the composition including the first compound represented by Formula 1 and the second compound represented by Formula 2 as described herein. In one or more embodiments, the emission layer may include the layer including the composition including the first compound represented by Formula 1 and the second compound represented by Formula 2 as described herein.

In one or more embodiments, the emission layer may include a host and a dopant, wherein the host does not include a transition metal, and the dopant includes the composition including the first compound represented by Formula 1 and the second compound represented by Formula 2 as described herein.

The host may include 1,3,5-tris(N-phenylbenzimidazole-2-yl)benzene (TPBi), 3-tert-butyl-9,10-di(naphth-2-yl)anthracene (TBADN), 9,10-di(naphthalene-2-yl)anthracene (ADN, also referred to as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H52, Compound H-H1, Compound H-H2, or a combination thereof:

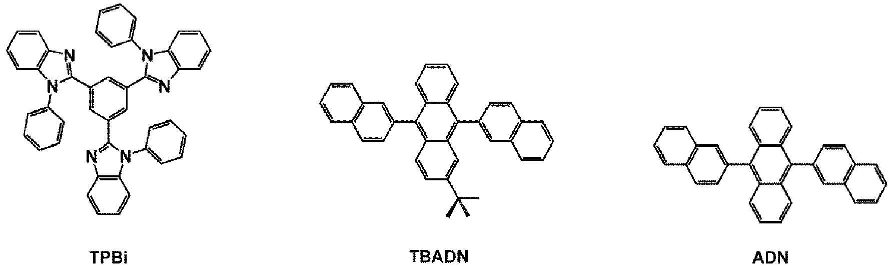

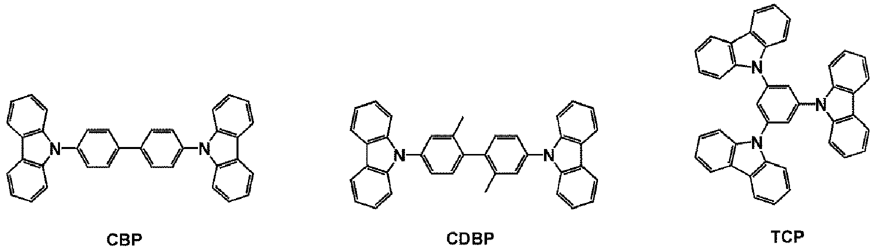

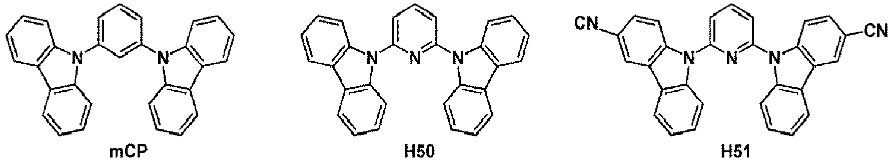

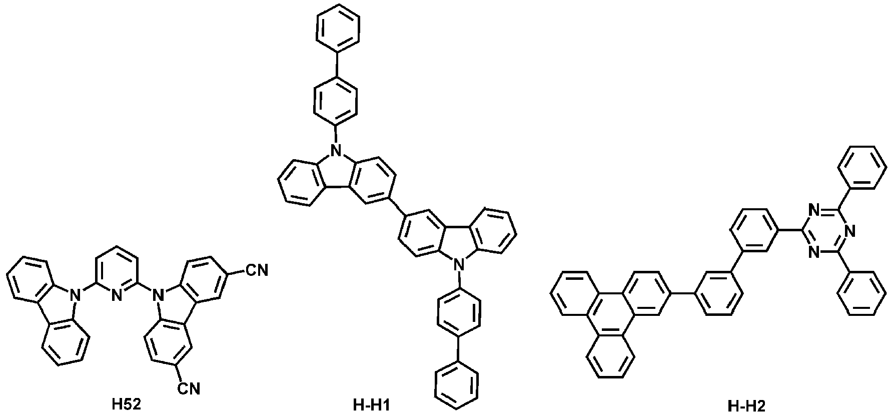

When the light-emitting device is a full-color light-emitting device, the emission layer may be patterned into a red emission layer, a green emission layer, and/or a blue emission layer.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

An electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof:

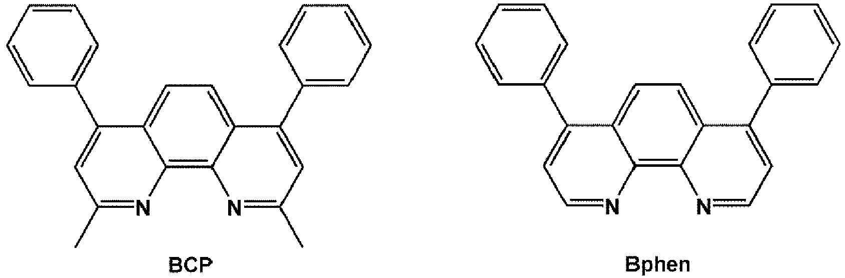

A thickness of the hole blocking layer may be in a range of about 20 Å to about 1,000 Å, for example, about 30 Å to about 600 Å. When the thickness of the hole blocking layer is within these ranges, excellent hole blocking characteristics may be obtained without a substantial increase in driving voltage.

The electron transport layer may include BCP, Bphen, TPBi, tris(8-hydroxyquinolinato)aluminum (Alq₃), Balq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

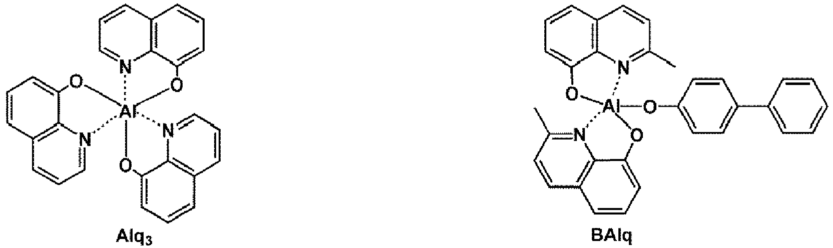

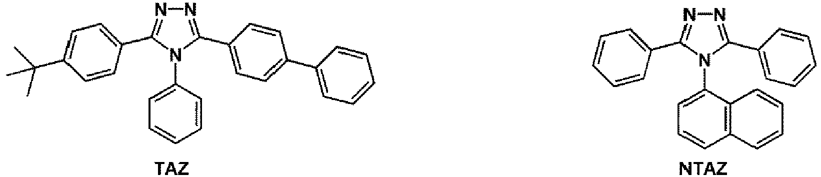

In one or more embodiments, the electron transport layer may include one of Compounds ET1 to ET25, or a combination thereof:

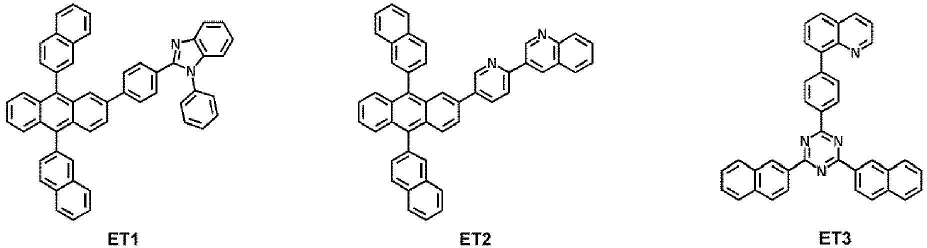

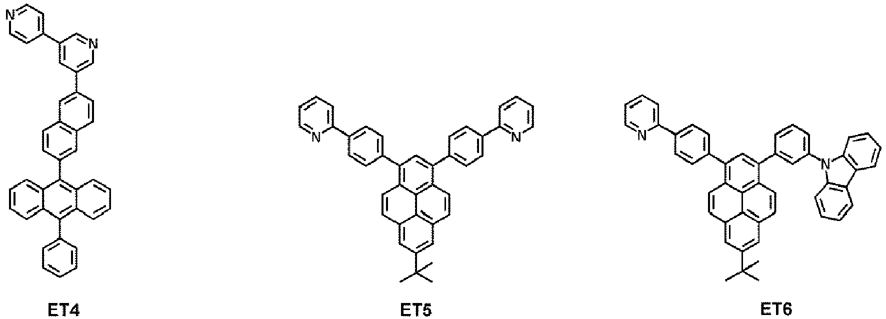

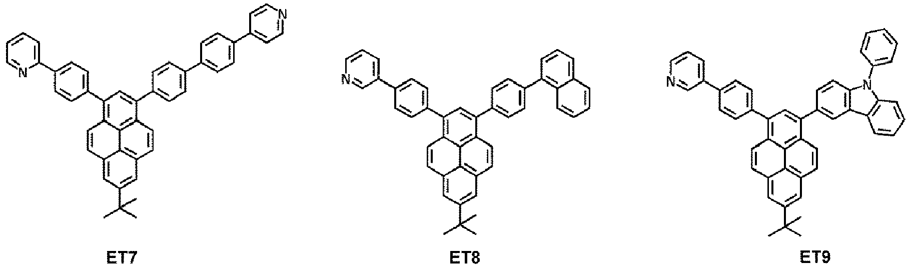

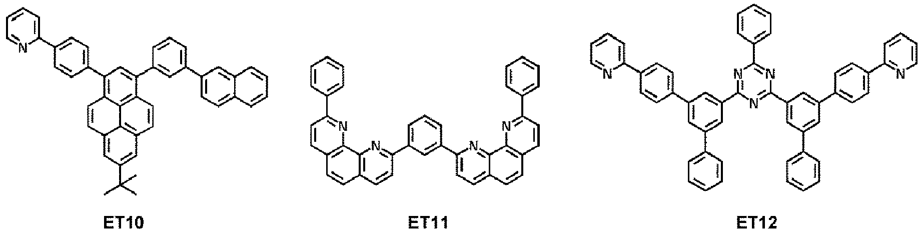

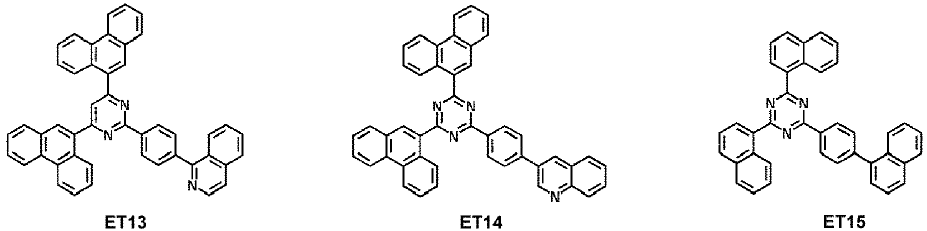

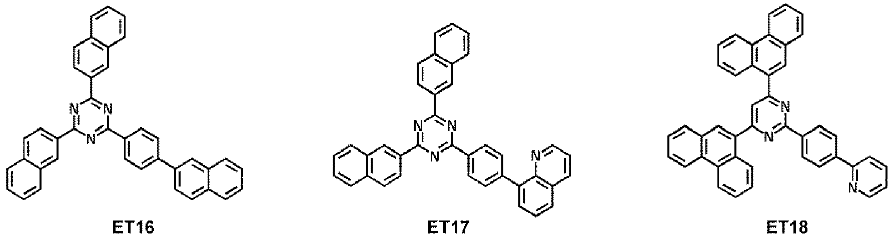

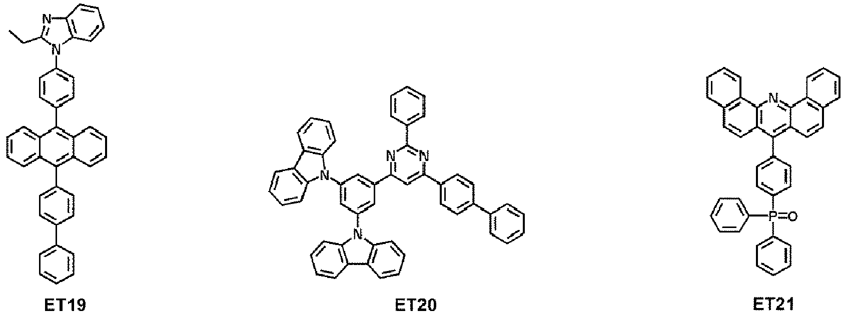

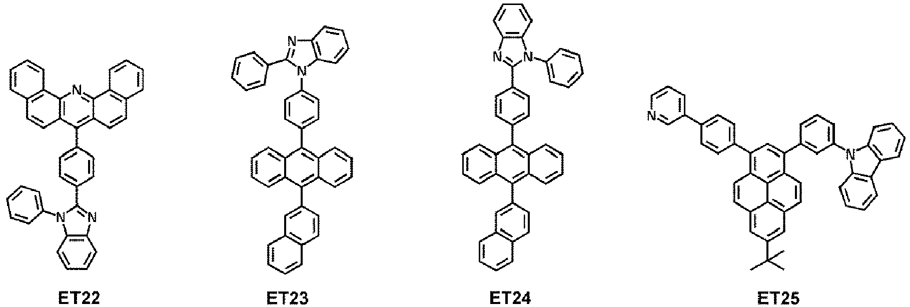

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described herein.

The metal-containing material may include a Li complex. The Li complex may include, for example, Compound ET-D1 or ET-D2:

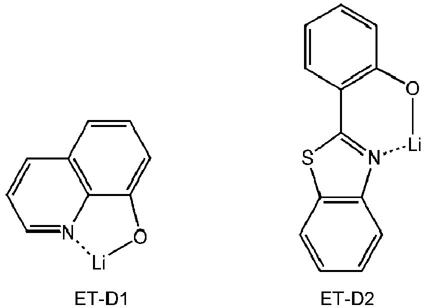

The electron transport region may include an electron injection layer that promotes the flow of electrons from the second electrode 19 thereinto.

The electron injection layer may include LiF, NaCl, CsF, Li₂O, BaO, Compound ET-D1, Compound ET-D2, or a combination thereof.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, the material for forming the second electrode 19 may be Li, Mg, Al, Ag, Al-Li, Ca, Mg-In, Mg-Ag, or the like. In one or more embodiments, to manufacture a top-emission type light-emitting device, a transmissive electrode formed using ITO or IZO may be used as the second electrode 19.

In one or more embodiments, the composition, a layer including the composition, an emission layer in a light-emitting device including the composition may not include a compound of Group A and mCP (1,3-bis(N-carbazolyl)benzene):

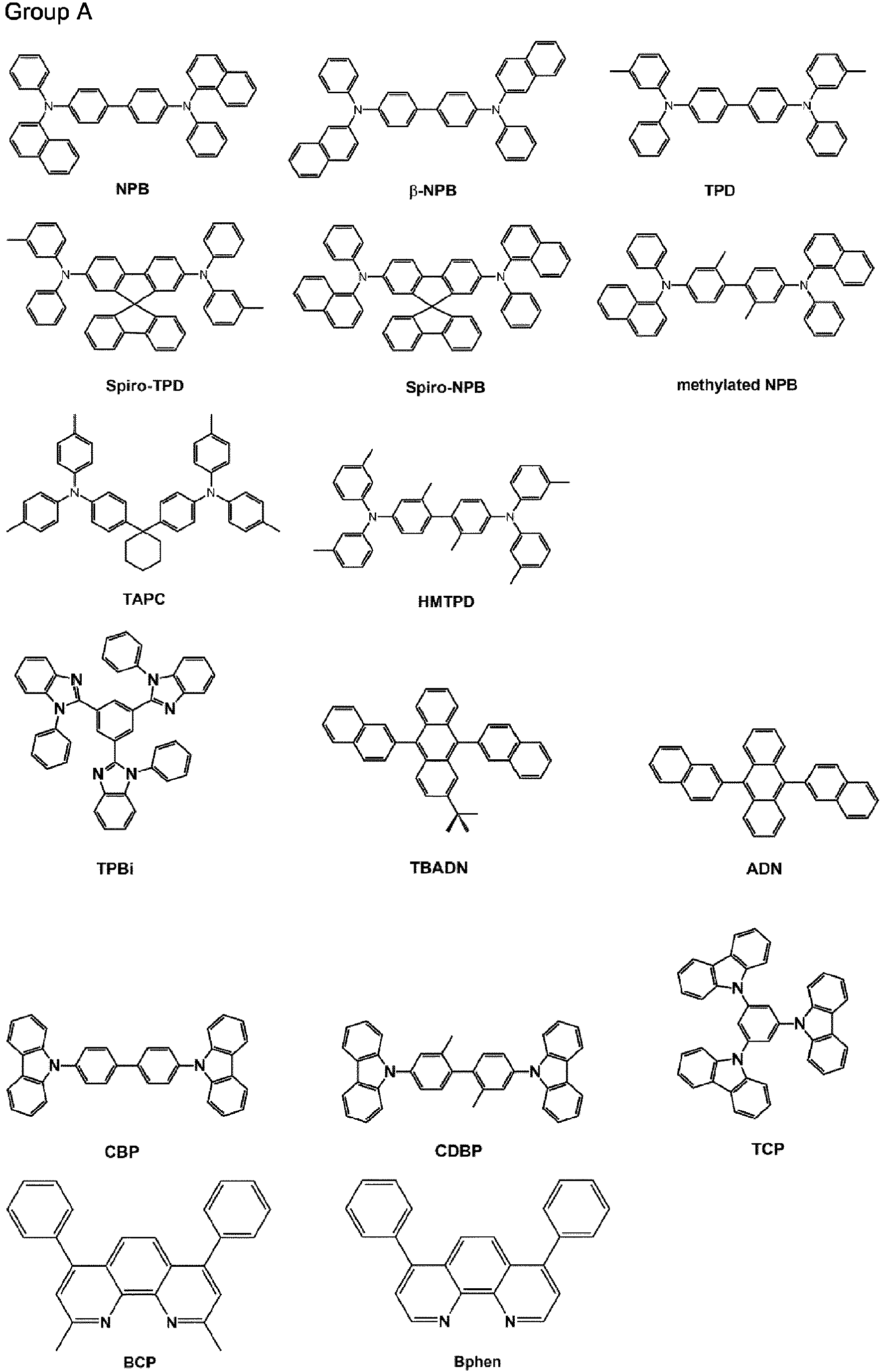

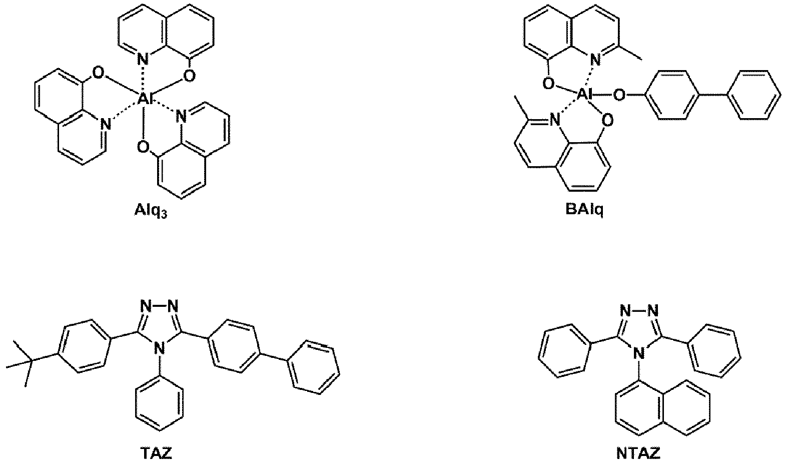

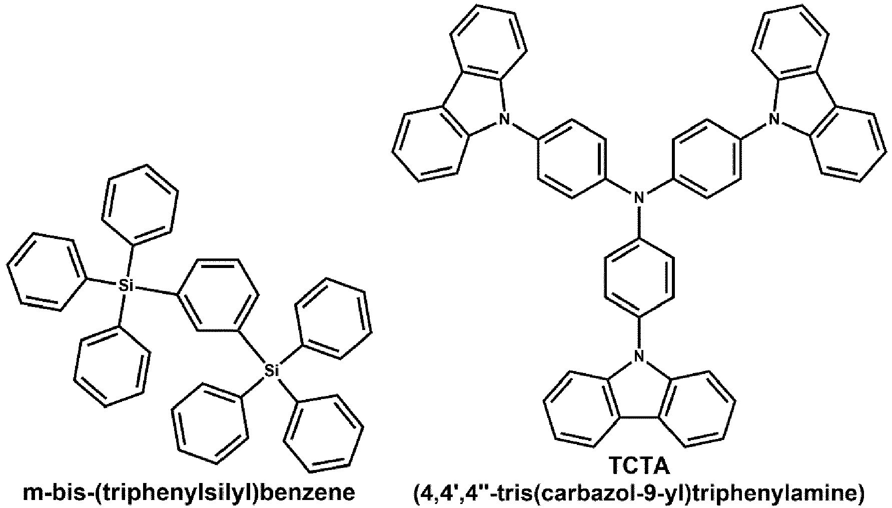

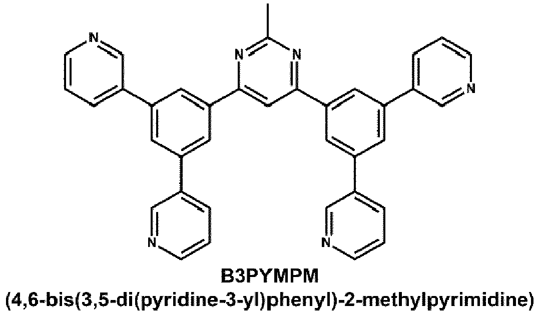

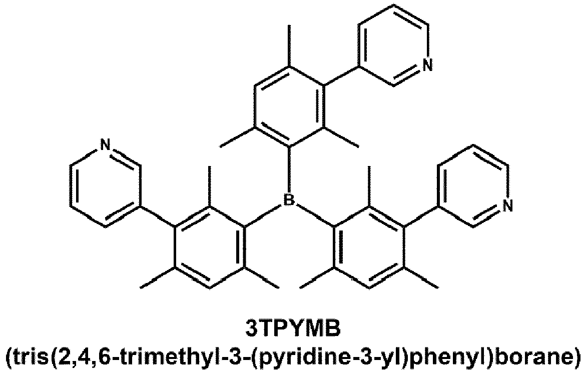

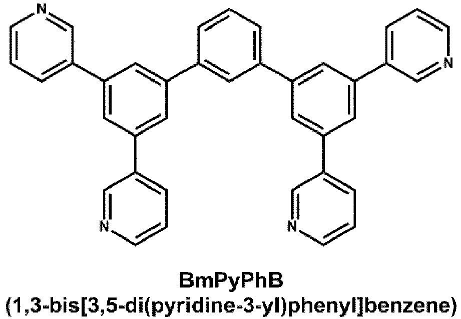

Hereinbefore, the light-emitting device 10 according to one or more embodiments has been described in connection with the FIGURE, but embodiments of the present disclosure are not limited thereto.

According to another aspect, the light-emitting device may be included in an electronic apparatus. Thus, an electronic apparatus including the light-emitting device is provided. The electronic apparatus may include, for example, a display, an illumination, a sensor, and the like.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and non-limiting examples thereof are a methoxy group, an ethoxy group, a propoxy group, a butoxy group, and a pentoxy group.

The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Non-limiting examples of the C₃-C₁₀ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a saturated monovalent cyclic group that includes at least one hetero atom selected from N, O, P, Si, S, Se, Ge, and B as a ring-forming atom and 1 to 10 carbon atoms. The term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group are a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one double bond in its ring. Non-limiting examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group that includes at least one hetero atom selected from N, O, P, Si, S, Se, Ge, and B as a ring-forming atom and a cyclic aromatic system having 1 to 60 carbon atoms. The term "C₁-C₆₀ heteroarylene group" as used herein refers to a divalent group that includes at least one hetero atom selected from N, O, P, Si, S, Se, Ge, and B as a ring-forming atom and a carbocyclic aromatic system having 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ indicates the C₆-C₆₀ aryl group). The term "C₆-C₆₀ arylthio group" as used herein indicates -SA103 (wherein A₁₀₃ indicates the C₆-C₆₀ aryl group).

The term "C₁-C₆₀ heteroaryloxy group" as used herein indicates -OA_{102'} (wherein A_{102'} indicates the C₁-C₆₀ heteroaryl group). The term "C₁-C₆₀ heteroarylthio group" as used herein indicates -SA_{103'} (wherein A_{103'} indicates the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, at least one hetero atom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. Non-limiting examples of "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

Non-limiting examples of the "C₅-C₃₀ carbocyclic group" and "C₁-C₃₀ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). Non-limiting examples of the term "fluorinated C₁ alkyl group (that is, a fluorinated methyl group)" include -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated phenyl group" as used herein may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. Non-limiting examples of the "deuterated C₁ alkyl group (that is, the deuterated methyl group)" may include -CD₃, -CD₂H, and -CDH₂, and non-limiting examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" as used herein may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" as used herein respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of each of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -CI, -Br, -I, -SFs, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -SFs, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉), or a combination thereof;
-N(Q31)(Q32), -Si(Q₃₃)(Q₃₄)(Q₃₅), -Ge(Q₃₃)(Q₃₄)(Q₃₅), -B(Q36)(Q37), - P(=O)(Q₃₈)(Q₃₉), or -P(Q₃₈)(Q₃₉); or
a combination thereof.

In the present specification, Q₁ to Q₉, Q₁₁ to Q₁₉, Q₂₁ to Q₂₉, and Q₃₁ to Q₃₉ may each independently be: hydrogen, deuterium, -F, -CI, -Br, -I, -SFs, a hydroxyl group, a cyano group, a nitro group; an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

For example, Q₁ to Q₉, Q₁₁ to Q₁₉, Q₂₁ to Q₂₉ and Q₃₁ to Q₃₉ described herein may each independently be:
-CH3, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a compound and a light-emitting device according to one or more exemplary embodiments of the disclosure are described in further detail with reference to Synthesis Example and Examples. However, the light-emitting device is not limited thereto. The wording "B was used instead of A" used in describing Synthesis Examples means that an amount of A used was identical to an amount of B used, in terms of a molar equivalent.

### EXAMPLES

### Synthesis Example 1 (Compound RD-1)

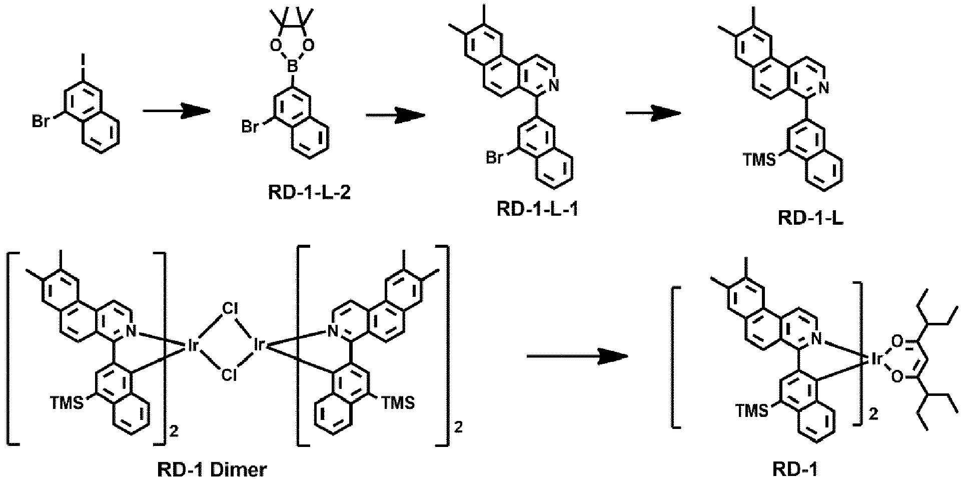

### Synthesis of Intermediate RD-1-L-2

2.5 grams (g) (7.4 millimoles (mmol)) of 1-bromo-3-iodonaphthalene was mixed with 60 milliliters (mL) of anhydrous tetrahydrofuran (THF), and then, 4.6 mL (7.4 mmol) of 1.6 M n-butyl lithium (nBuLi) solution of hexane was slowly added thereto at a temperature of -78°C. After about 1 hour, 1.8 mL (8.9 mmol) of 2-isopropoxy-4,4,5,5-tetramethyl-1,3,2-dioxaborolane was slowly added dropwise thereto and stirred at room temperature for 14 hours. After completion of the reaction, the organic layer, obtained by extraction with 50 mL of water and ethyl acetate, was dried using magnesium sulfate and distilled under reduced pressure. The resultant was purified by liquid chromatography to obtain 2.2 g (yield of 90%) of Intermediate RD-1-L-2.

### Synthesis of Intermediate RD-1-L-1

2.2 g (6.6 mmol) of Intermediate RD-1-L-2 was dissolved in 40 mL of THF and 10 mL of water, and then, 1.1 g (4.4 mmol) of 4-chloro-8,9-dimethylbenzo[f]isoquinoline, 0.1 g (0.43 mmol) of palladium(II) acetate (Pd(OAc)₂), 0.37 g (0.88 mmol) of 2-dicyclohexylphosphino-2',6'-dimethoxybiphenyl (Sphos), and 1.50 g (11.02 mmol) of K₂CO₃ were added thereto, and the resultant mixture was heated at reflux for 24 hours. After the reaction was completed, an extraction process was performed thereon after adding ethyl acetate and water thereto, and the obtained organic layer was dried using magnesium sulfate and distilled under reduced pressure. The resultant was purified by liquid chromatography to obtain 1.5 g (yield of 85%) of Intermediate RD-1-L-1.

Liquid chromatography mass spectrometry (LC-MS) m/z = 412 (M+H)⁺.

### Synthesis of Intermediate RD-1-L

1.5 g (3.65 mmol) of Intermediate RD-1-L-1 was mixed with 30 mL of anhydrous THF, and then, at a temperature of -78°C, 2.5 mL (4.0 mmol) of 1.6 M nBuLi solution in hexanes was slowly added thereto. After about 1 hour, 0.6 mL (4.4 mmol) of chlorotrimethylsilane was slowly added dropwise thereto and stirred at room temperature for 12 hours. After completion of the reaction, the organic layer, obtained by extraction with 30 mL of water and ethyl acetate, was dried using magnesium sulfate and distilled under reduced pressure. The resultant was purified by liquid chromatography to obtain 1.4 g (yield of 95%) of Intermediate RD-1-L.

LC-MS m/z = 406(M+H)⁺.

### Synthesis of Intermediate RD-1 Dimer

1.4 g (3.4 mmol) of Intermediate RD-1-L and 15 mL of deionize (DI) water were mixed with 0.6 g (1.6 mmol) of iridium chloride tetrahydrate, followed by refluxing while heating for 24 hours. After the reaction was completed, the temperature was lowered to room temperature, and the solid produced therefrom was filtered and washed sufficiently with water/methanol/hexane in the stated order. The obtained solid was dried in a vacuum oven to obtain 1.1 g of Intermediate L1 Dimer.

### Synthesis of Compound RD-1

40 mL of ethoxyethanol was mixed with 1.0 g (0.48 mmol) of Intermediate RD-1 Dimer, 0.9 g (4.2 mmol) of 3,7-diethyl-nonane-4,6-dione, and 0.48 g (4.5 mmol) of Na₂CO₃, and the resultant mixture was stirred for 24 hours at a temperature of 90°C to proceed with a reaction. After the reaction was completed, the temperature was lowered to room temperature, and the solid produced therefrom was filtered and purified by liquid chromatography to obtain 1.0 g (yield of 80%) of Compound 1.

LC-MS m/z = 1213(M+H)⁺.

### Synthesis Example 2 (Compound RD-2)

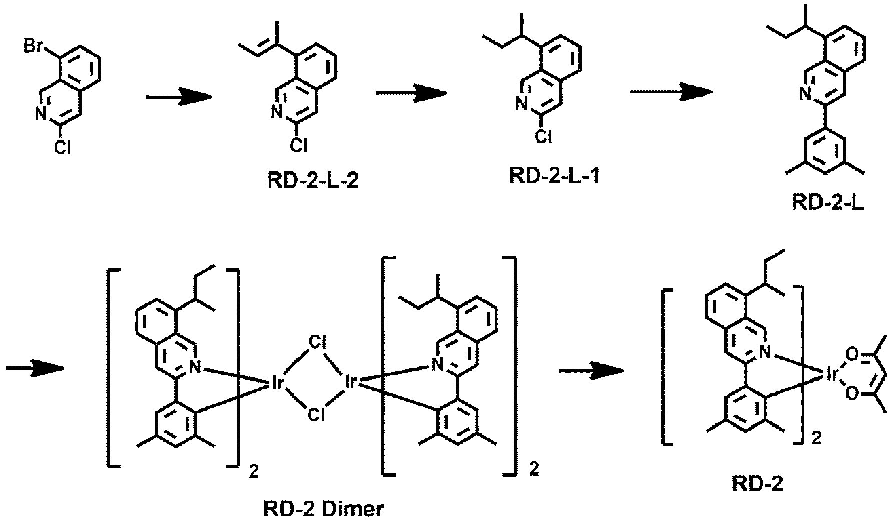

### Synthesis of Intermediate RD-2-L-2

10 g (41.5 mmol) of 8-bromo-3-chloroisoquinoline, which is a starting material, was dissolved in 100 mL of THF and 25 mL of water, and then, 41.5 g (41.5 mmol) of sec-butenylboronic acid and 3.36 g (2.9 mmol) of a Pd(PPh₃)₄, and 14.4 g (103 mmol) of K₂CO₃ were added thereto, and refluxed while heating at a temperature of 80 °C for 18 hours. When the reaction was completed, the reaction mixture was concentrated under reduced pressure, and the result was dissolved in 50 mL of ethyl acetate, followed by an extraction process, and the obtained organic layer was dried using magnesium sulfate and distilled under reduced pressure. The resultant was purified by liquid chromatography to obtain 4.5 g (yield of 50%) of Intermediate RD-2-L-2.

LC-MS m/z = 218(M+H)⁺.

### Synthesis of Intermediate RD-2-L-1

4.5 g (20.7 mmol) of Intermediate RD-2-L-2 was dissolved in 100 mL of methanol, 0.5 g (10 wt%) of palladium/carbon (Pd/C) catalyst was added thereto, and hydrogen was injected thereinto, followed by 18 hours of stirring. When the reaction was completed, the reaction mixture was passed through a celite pad and concentrated under reduced pressure. The resultant was purified by liquid chromatography to obtain 4.3 g (yield of 95%) of Intermediate RD-2-L-1.

LC-MS m/z = 220(M+H)⁺.

### Synthesis of Intermediate RD-2-L

4.3 g (19.6 mmol) of Intermediate RD-2-L-1 was dissolved in 160 mL of toluene and 32 mL of ethanol, and 3.2 g (20.7 mmol) of 3,5-dimehtylphenylboronic acid, 1.6 g (1.6 mmol) of Pd(PPh₃)₄, and 2 normal (N) Na₂CO₃ solution in H₂O were added thereto, and refluxed while heating at a temperature of 80°C for 18 hours. When the reaction was completed, the reaction mixture was concentrated under reduced pressure, and the result was dissolved in 400 mL of ethyl acetate, followed by an extraction process, and the obtained organic layer was dried using magnesium sulfate and distilled under reduced pressure. The resultant was purified by liquid chromatography to obtain 4.0 g (yield of 70%) of Intermediate RD-2-L.

LC-MS m/z = 290(M+H)⁺.

### Synthesis of Intermediate RD-2 Dimer

Intermediate RD-2 Dimer was obtained in the same manner as in Synthesis Example 1, except that Intermediate RD-2-L was used instead of Intermediate RD-1-L in the Synthesis of Intermediate RD-1 Dimer.

### Synthesis of Compound RD-2

Compound RD-2 was obtained in the same manner as in Synthesis Example 1, except that Intermediate RD-2 Dimer and pentane-2,4-dione were used instead of Intermediate RD-1 Dimer and 3,7-diethyl-nonane-4,6-dione, respectively, in the Synthesis of Compound RD-1.

LC-MS m/z = 869(M+H)⁺.

### Manufacture of OLED 1

An ITO (as an anode)-patterned glass substrate was cut to a size of 50 mm x 50 mm x 0.5 mm, sonicated with isopropyl alcohol, and DI water each for 5 minutes, and then cleaned by exposure to ultraviolet (UV) rays and ozone for 30 minutes. Then, the ITO-patterned glass substrate was provided to a vacuum deposition apparatus.

HT3 and F6-TCNNQ were vacuum-co deposited on the ITO anode at the weight ratio of 98:2 to form a hole injection layer having a thickness of 100 Å, and HT3 was vacuum-deposited on the hole injection layer to form a hole transport layer having a thickness of 1350 Å, and then, HT21 was vacuum-deposited on the hole transport layer to form an electron blocking layer having a thickness of 300 Å.

Next, a host and a dopant were co-deposited on the electron blocking layer at a weight ratio described in Table 1 to form an emission layer having a thickness of 400 Å. H52 was used as the host, and the first compound and the second compound listed in Table 1 were used at a weight ratio of 1:1 as the dopant.

Afterwards, ET3 and ET-D1 were co-deposited on the emission layer at a volume ratio of 50:50 to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of OLED 1.

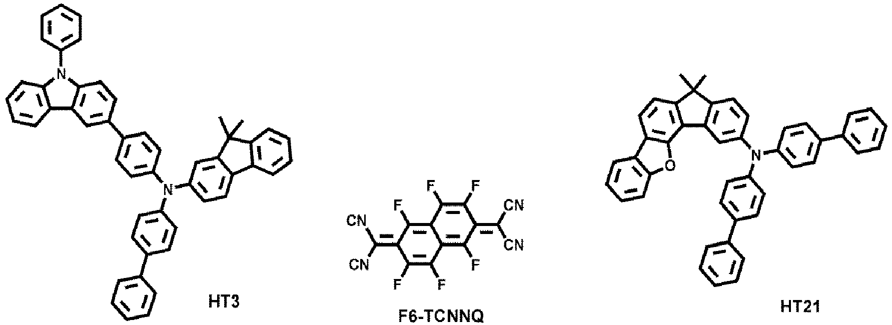

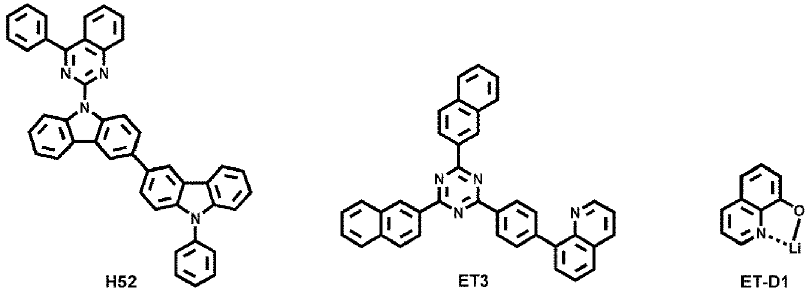

### Manufacture of OLED A and OLED B

OLED A and OLED B were manufactured in the same manner as used to manufacture OLED 1, except that, in forming an emission layer, compounds described in Table 1 were used as a dopant.

### Evaluation Example 1

For OLEDs 1, A and B, the driving voltage (volts, V), emission maximum (peak) wavelength (λₘₐₓ, nm), maximum value of external quantum efficiency (Max EQE, %), and lifespan (LT₉₇, hr, relative value) were evaluated, and the results are shown in Table 1. A current-voltage meter (Keithley 2400) and a luminance meter (Minolta Cs-1000A) were used as an apparatus for evaluation, the lifespan (LT₉₇) (at 7,000 candela per square meter, cd/m²) was obtained by measuring the amount of time (hr) that elapsed until luminance was reduced to 97% of the initial brightness of 100 %, and the results are expressed as a relative value (%).

**Table 1**

| | Dopant in emission layer | | Weight ratio of host to dopant in emission layer | Driving Voltage (V) | λₘₐₓ (nm) | Max EQE (%) | LT97 (Relative value, %) |
|---|---|---|---|---|---|---|---|
| | First compou nd | Second compoun d | | | | | |
| OLED 1 | RD-1 | RD-2 | 98 : 2 | 3.94 | 627 | 103 | 125 |
| OLED A | RD-1 | | 98 : 2 | 3.92 | 629 | 100 | 100 |
| OLED B | RD-2 | | 98 : 2 | 3.99 | 617 | 93 | 70 |

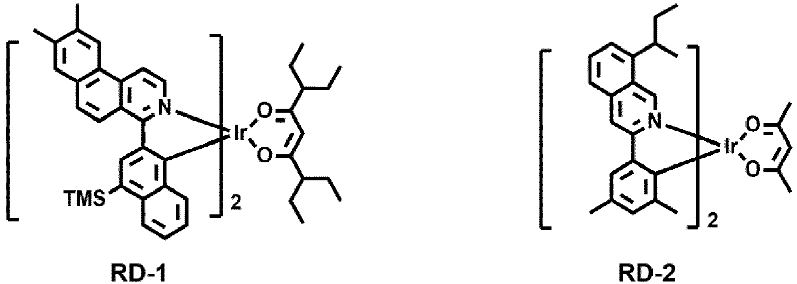

Referring to Table 1, it was confirmed that OLED 1 emitted red light, and as compared to OLEDs A and B, have improved properties in terms of driving voltage, EQE, and lifespan.

According to the one or more embodiments, an electronic device, for example, a light-emitting device, employing the composition may have improved driving voltage, improved external quantum efficiency, and improved lifetime characteristics.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figure, it will be understood by those of ordinary skill in the art that various changes in form and details may be made therein without departing from the scope as defined by the following claims.

## Claims

1. A composition, comprising:
a first compound represented by Formula 1; and
a second compound represented by Formula 2,
wherein the first compound and the second compound are different from each other:
Formula 1 Ir(L₁₁)ₙ₁₁(L₁₂)ₙ₁₂(L₁₃)ₙ₁₃
Formula 2 Ir(L₂₁)ₙ₂₁(L₂₂)ₙ₂₂₍L₂₃)ₙ₂₃
wherein, in Formula 1 and Formula 2,
L₁₁ is a bidentate ligand, i) bonded to iridium of Formula 1 via a nitrogen atom and a carbon atom and ii) including ring A₁ bonded to iridium of Formula 1 via the nitrogen atom,
ring A₁ is:
a C₃-C₆₀ polycyclic group comprising at least three cyclic groups that are condensed with each other, or
a C₃-C₆₀ polycyclic group comprising at least one cyclic group and at least one 5-membered ring that are condensed with each other,
L₁₃, L₂₁, and L23 are each independently:
a bidentate ligand bonded to iridium of Formula 1 or Formula 2 via two nitrogen atoms,
a bidentate ligand bonded to iridium of Formula 1 or Formula 2 via a nitrogen atom and a carbon atom, or
a bidentate ligand bonded to iridium of Formula 1 or Formula 2 via two carbon atoms,
L₁₂ and L₂₂ are each independently a bidentate ligand bonded to iridium of Formula 1 or Formula 2 via two oxygen atoms,
n11, n12, n21, and n22 are each independently 1 or 2,
n13 and n23 are each independently 0 or 1,
the sum of n11, n12, and n13 is 3, and
the sum of n21, n22, and n23 is 3,
with the proviso that the first compound is not:

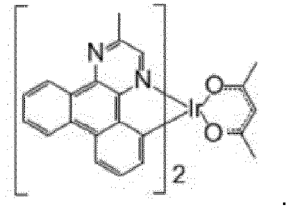

2. The composition of claim 1, wherein L13, L21, and L23 are each independently a bidentate ligand bonded to iridium of Formula 1 or Formula 2 via a nitrogen atom and a carbon atom, and n12 and n22 are each 1; and/or
wherein n13 and n23 are each 0.

3. The composition of claims 1 or 2, wherein
L₁₁ is a ligand represented by Formula 1-1,
L₁₂ is a ligand represented by Formula 1-3,
L₁₃ is a ligand represented by Formula 1-1 or 1-2,
L₂₁ is a ligand represented by Formula 2-1,
L₂₂ is a ligand represented by Formula 2-3, and
L₂₃ is a ligand represented by Formula 2-1 or 2-2: 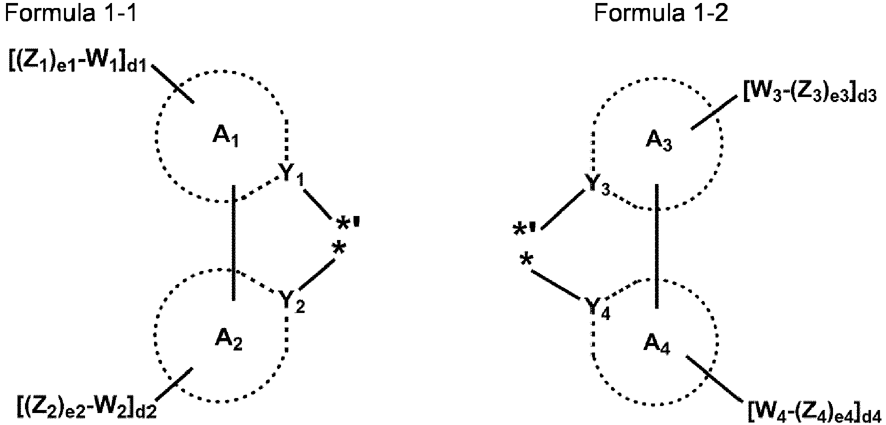 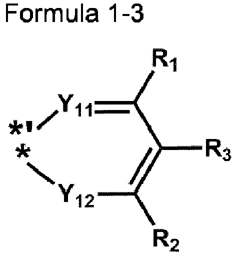 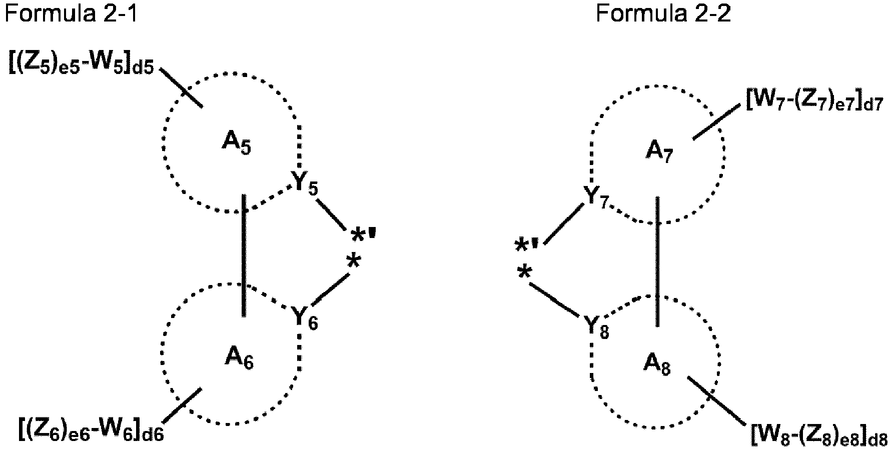 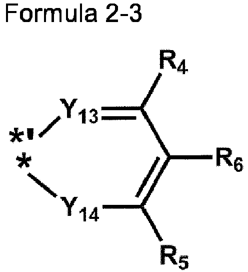 wherein, in Formulae 1-1 to 1-3 and 2-1 to 2-3,
Y₁ is N,
Y₂ to Y₈ are each independently N or C,
Y₁₁ to Y₁₄ are each O,
ring A₁ is
a C₃-C₆₀ polycyclic group comprising at least three cyclic groups that are condensed with each other, or
a C₃-C₆₀ polycyclic group comprising at least one cyclic group and at least one 5-membered ring that are condensed with each other,
ring A₂ to ring A₈ are each independently a C₅-C₃₀ carbocyclic group or a C₁-C₃₀ heterocyclic group,
W₁ to W₈ are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
Z₁ to Z₈ and R₁ to R₆ are each independently hydrogen, deuterium, -F, -CI, -Br, - I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉),
e1 to e8 and d1 to d8 are each independently an integer from 0 to 20,
two or more of a plurality of Z₁(s), two or more of a plurality of Z₂(s), two or more of a plurality of Z₃(s), two or more of a plurality of Z₄(s), two or more of a plurality of Z₅(s), two or more of a plurality of Z₆(s), two or more of a plurality of Z₇(s), two or more of a plurality of Z₈(s), two or more of R₁ to R₃, and at least two of R₄ to R₆ are optionally bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is as defined in connection with Z₁,
* and *' in Formula 1-1 to 1-3 and 2-1 to 2-3 each indicate a binding site to iridium in Formulae 1 and 2, and
at least one substituent of each of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -CI, -Br, -I, -SFs, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -CI, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₆)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently: hydrogen, deuterium, -F, -CI, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

4. The composition of claim 3, wherein ring A₁ and ring A₅ are different from each other; and/or
wherein ring A₁ is a benzoquinoline group, a benzoisoquinoline group, a naphthoquinoline group, a naphthoisoquinoline group, a furanopyridine group, a furanopyrimidine group, a thienopyridine group, a thienopyrimidine group, an azadibenzofuran group, or an azadibenzothiophene group; and/or
wherein ring A₃, ring A₅, and ring A₇ are each independently: a pyridine group, a pyrimidine group, a pyrazine group, a pyridazine group, a quinoline group, an isoquinoline group, a benzoquinoline group, a benzoisoquinoline group, a naphthoquinoline group, a naphthoisoquinoline group, a furanopyridine group, a furanopyrimidine group, a thienopyridine group, a thienopyrimidine group, an azadibenzofuran group, or an azadibenzothiophene group; and/or
wherein ring A₂ and ring A₆ are different from each other.

5. The composition of claims 3 or 4, wherein ring A₂, ring A₄, ring A₆, and ring A₈ are each independently:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

6. The composition of any of claims 3-5, wherein
each of e1 and d1 is not 0, and
one or more Z₁(s) are each independently:
a C₁-C₂₀ alkyl group that is unsubstituted or substituted with at least one of deuterium, -F, a phenyl group, or a combination thereof;
-Si(Q₃)(Q₄)(Q₅); or
-Ge(Q₃)(Q₄)(Q₅).

7. The composition of any of claims 3-6, wherein
each of e5 and d5 is not 0, and
one or more Zs(s) are each independently:
a C₁-C₂₀ alkyl group that is unsubstituted or substituted with at least one of deuterium, -F, a phenyl group, or a combination thereof;
-Si(Q3)(Q4)(Q5); or
-Ge(Q3)(Q4)(Q5).

8. The composition of any of claims 3-7, wherein a group represented by 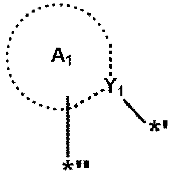 in Formula 1-1 is a group represented by one of Formulae NR(4) to NR(28), and
a group represented by 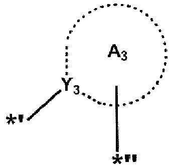 in Formula 1-2,
a group represented by 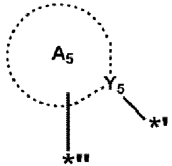 in Formula 2-1, and
a group represented by 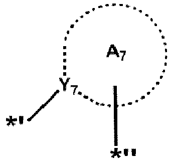 in Formula 2-2 are each independently a group represented by one of Formulae NR(1) to NR(28): 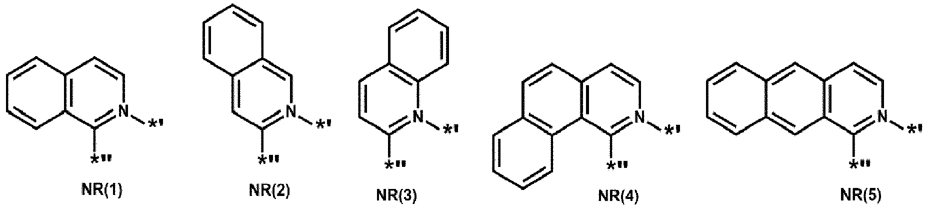 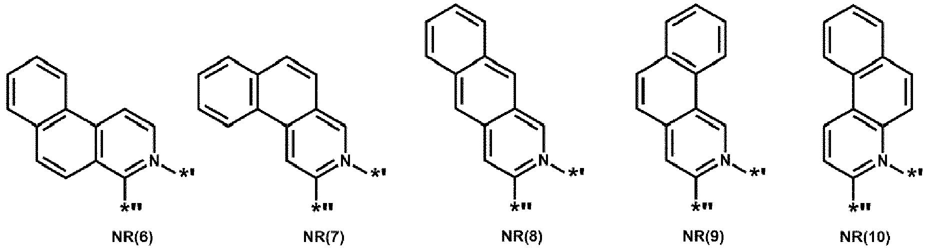 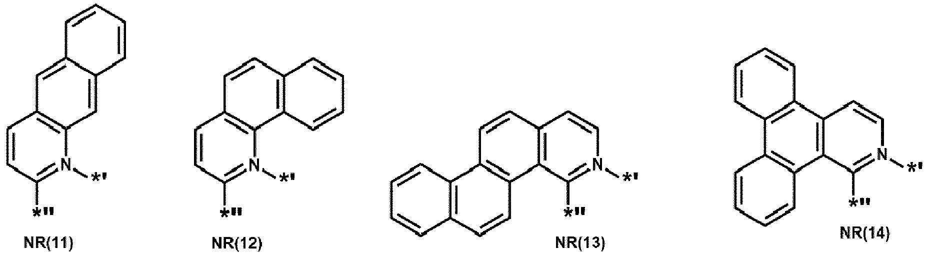 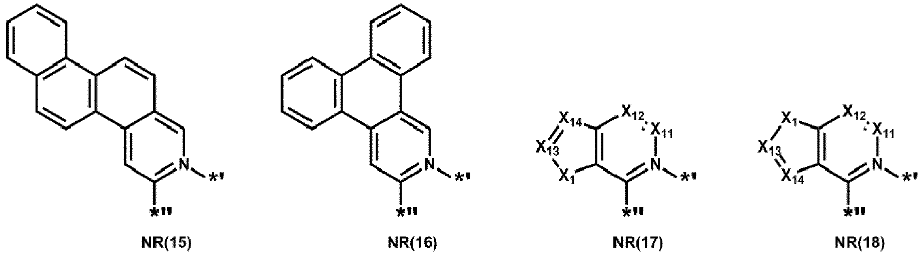 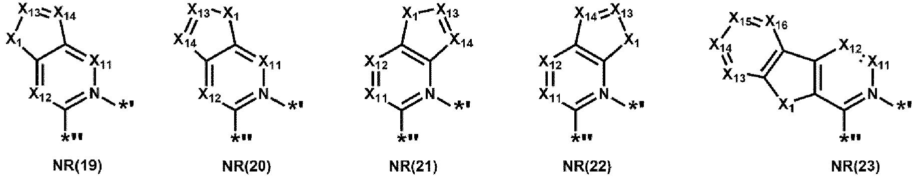 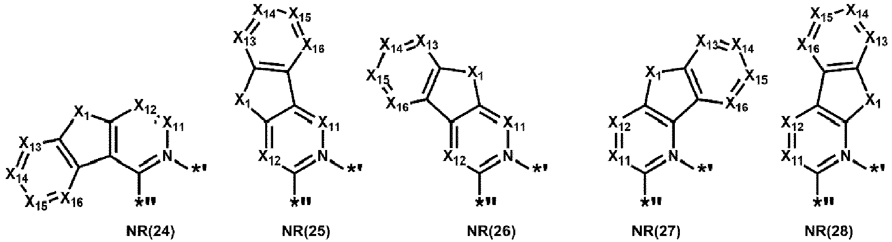 wherein, in Formulae NR(1) to NR(28),
X₁ is O or S,
X₁₁ to X₁₆ are each independently C or N,
*' indicates a binding site to iridium in Formulae 1 and 2, and
*" indicates a binding site to ring A₂, ring A₄, ring A₆, or ring A₈.

9. The composition of any of claims 3-8, wherein
Y₂ of Formula 1-1, Y₄ of Formula 1-2, Y₆ of Formula 2-1, and Y₈ of Formula 2-2 are each C, and
a group represented by 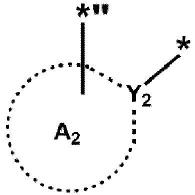 in Formula 1-1,
a group represented by 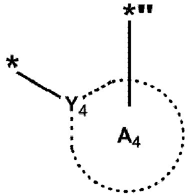 in Formula 1-2,
a group represented by 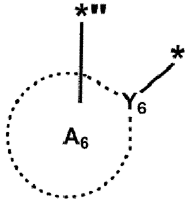 in Formula 2-1, and
a group represented by 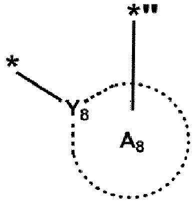 in Formula 2-2 are each independently a group represented by one of Formulae CR1 to CR29: 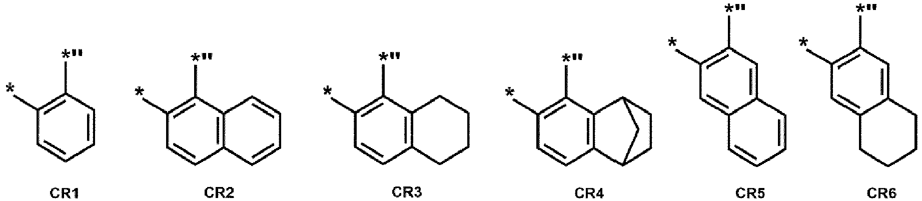 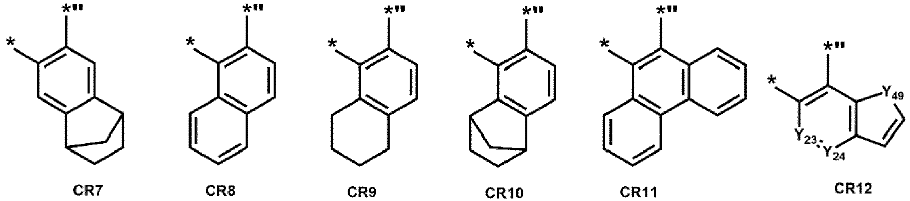 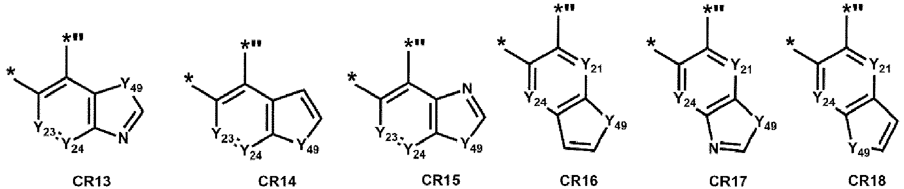 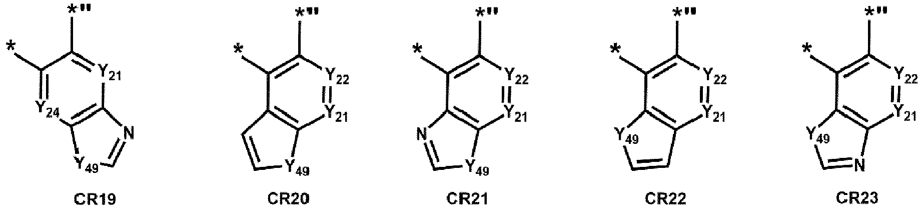 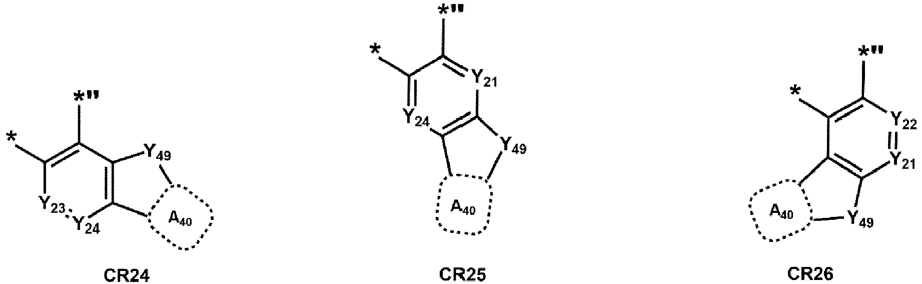 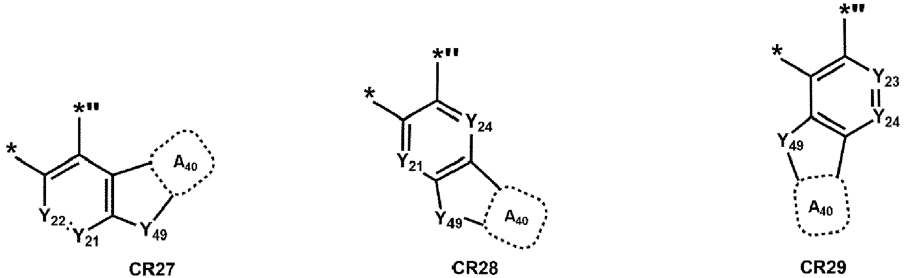 wherein, in Formulae CR1 to CR29,
Y49 iS O, S, Se, N-[W2-(Z2)e2], N-[W4-(Z4)e4], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}), or Si(Z₈₉ₐ)(Z_{89b}),
W₂, W₄, W₆, W₈, Z₂, Z₄, Z₆, Z₈, e2, e4, e6, and e8 are each as defined in claim 4,
Z₂₉ₐ and Z_{29b} are each as defined in connection with Z₂ in claim 3,
Z₄₉ₐ and Z_{49b} are each as defined in connection with Z₄ in claim 3,
Z₆₉ₐ and Z_{69b} are each as defined in connection with Z₆ in claim 3,
Z₈₉ₐ and Z_{89b} are as defined in connection with Z₈ in claim 3,
Y₂₁ to Y₂₄ are each independently N or C,
ring A₄₀ is a substituted or unsubstituted C₅-C₃₀ carbocyclic group or a substituted or unsubstituted C₁-C₃₀ heterocyclic group,
* indicates a binding site to iridium in Formulae 1 and 2, and
*" indicates a binding site to ring A₁, ring A₃, ring A₅, and ring A₇.

10. The composition of any of claims 1-9, wherein
the first compound emits a first light having a first spectrum, wherein λP(1) is an emission maximum wavelength (nanometers) of the first spectrum,
the second compound emits a second light having a second spectrum, wherein λP(2) is an emission maximum wavelength (nanometers) of the second spectrum, and
λP(1) and λP(2) are each independently from 570 nanometers to 650 nanometers,
wherein λP(1) and the λP(2) are evaluated from a photoluminescence spectrum measured for a first film comprising the first compound and a second film comprising the second compound.

11. The composition of claim 10, wherein λP(1) and λP(2) are each independently from 600 nanometers to 650 nanometers.

12. The composition of any of claims 1-11, wherein
the first compound emits a first light having a first spectrum, wherein λP(1) is an emission maximum wavelength (nanometers) of the first spectrum,
the second compound emits a second light having a second spectrum, wherein λP(2) is an emission maximum wavelength (nanometers) of the second spectrum, and
an absolute value of the difference between λP(1) and λP(2) is from 0 nanometers to 30 nanometers,
wherein λP(1) and the λP(2) are evaluated from a photoluminescence spectrum measured for a first film comprising the first compound and a second film comprising the second compound.

13. A layer, comprising the composition of any of claims 1-12.

14. A light-emitting device, comprising:
a first electrode;
a second electrode; and
an organic layer located between the first electrode and the second electrode,
wherein the organic layer comprises an emission layer, and
wherein the organic layer comprises the composition of any of claims 1-12;
preferably wherein the emission layer comprises the composition.

15. An electronic apparatus, comprising the light-emitting device of claim 14.
